(19) Europäisches Patentamt
European Patent Office
Office européen des brevets

(11) Publication number: **0 295 065**
**A2**

(12) # EUROPEAN PATENT APPLICATION

(21) Application number: 88305199.7

(22) Date of filing: 08.06.88

(51) Int. Cl.[4]: **H 01 L 21/66**
H 01 L 23/54, H 01 L 21/302

(30) Priority: 31.08.87 JP 217030/87
10.06.87 JP 143065/87
21.07.87 JP 181460/87
29.07.87 JP 187507/87

(43) Date of publication of application:
14.12.88 Bulletin 88/50

(84) Designated Contracting States: DE FR GB IT

(71) Applicant: HITACHI, LTD.
6, Kanda Surugadai 4-chome
Chiyoda-ku Tokyo 101 (JP)

(72) Inventor: Takahashi, Takahiko
Arubiyon, 301 1920-2, Hane Hamura-machi
Nishitama-gun Tokyo (JP)

Hayakawa, Hajime
505-gou, Hitotsubashihaimu 1-9-4, Naka
Kunitachi-shi Tokyo (JP)

Okamoto, Yoshihiko
301, 1-17-1, Gakuennishi-machi
Kodaira-shi Tokyo (JP)

Itoh, Fumikazu
802, Pahkuhausu 5-8-23, Kugenumakaigan
Fujisawa-shi Kanagawa (JP)

Haraichi, Satoshi
201, Mezon-Tateba 4035, Izumi-cho Izumi-ku
Yokohama-shi Kanagawa (JP)

Shimase, Akira
Hitachi-Isogoryo 4-17-21, Okamura Isogo-ku
Yokohama-shi Kanagawa (JP)

Kobayashi, Tohru
2255-14, Noda
Iruma-shi Saitama (JP)

Anzai, Akio
1-604, 4-4-34, Nishihara-cho
Tanashi-shi Tokyo (JP)

Yamaguchi, Hiroshi
3-24-24, Kameino
Fujisawa-shi Kanagawa (JP)

Hongo, Mikio
315, Pairottohaususantotsuka 4208-10, Totsuka-cho
Totsuka-ku Yokohama-shi Kanagawa (JP)

(74) Representative: Calderbank, Thomas Roger et al
MEWBURN ELLIS & CO. 2/3 Cursitor Street
London EC4A 1BQ (GB)

(54) **Semiconductor integrated circuit device, method of making same or cutting method for same, and cutting system using energy beam for same.**

(57) In making defect correction and circuit change in a semiconductor integrated circuit device using a focused ion beam etching technique, the present invention relates to an IC or VLSI structure having a trial cutting region, a test etching region and an auxiliary wiring or pad, suitable for the application of such defect correction and circuit change, as well as a method of making same, a designing method using such technique, and a focused ion beam system and other systems for use in those methods.

FIG. 1A

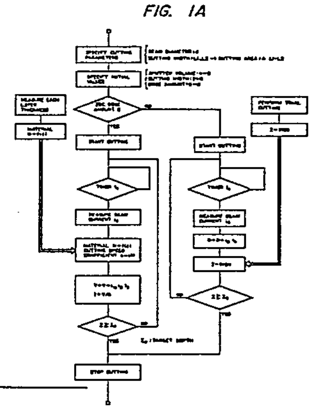

EP 0 295 065 A2

**Description**

## SEMICONDUCTOR INTEGRATED CIRCUIT DEVICE, METHOD OF MAKING SAME OR CUTTING METHOD FOR SAME, AND CUTTING SYSTEM USING ENERGY BEAM FOR SAME

The present invention relates to a cutting depth controlling technique used in applying a cutting work to an LSI or a mask for exposure using a focused ion beam or the like.

The present invention also relates to a cutting technique of a high accuracy which is carried out under radiation of an ion beam, and particularly to a technique of cutting with a high accuracy an internal layer of, for example, an LSI having a multilayer structure.

The present invention further relates to a semiconductor device and a cutting technique using an ion beam for making same, and particularly to a technique effective in its application to cutting and exposure of wiring using an ion beam to effect logical correction in a logical element, take measures against a defective design or make analysis of a defect.

Further, the present invention relates to a semiconductor integrated circuit device and particularly to a technique effective in its application to the analysis of defects.

Further, the present invention relates to a cutting depth monitoring technique in cutting an LSI or a mask for exposure using a focused ion beam or the like.

In an LSI developing process it has recently become very important to make debugging, correction or analysis of a defect by cutting or connecting a part of a wiring in an LSI chip. To this end, there have heretofore been reported examples of cutting a wiring in an LSI chip using a focused ion beam.

For example, Japanese Patent Laid Open No. 106750/83 (Focused Ion Beam Cutting Method) describes that it is possible to effect cutting at different etching depths by changing the dose amount, radiation time and acceleration voltage of an ion beam.

Further, as a technique associated with a higher integration of a semiconductor device such as an LSI (large scale integrated circuit) and shortening of the developing period, a technique of cutting a wiring of the LSI by radiating a focused ion beam to a predetermined cutting region with a view to making debugging, correction or analysis of a defect of the LSI is disclosed in detail, for example in the foregoing Japanese patent laid open No. 106750/83, which technique is outlined as follows. In etching a workpiece selectively by radiating a focused ion beam thereto, desired etching depths for the workpiece are preset as positional functions and on the basis of the preset data the ion beam is radiated while changing the dose amount and radiation time of the beam as well as acceleration voltage, whereby it is intended to effect etching at different depths. The above patent publication fully describes an etching control in the depth direction, but as to positioning of the cutting region in the planar direction, the said publication merely states that an ion beam is radiated to a part to be cut while referring to a positioning mark formed on the workpiece.

Further, as a cutting technique using an ion beam in the production of a semiconductor device, there is known the technique disclosed in Japanese Patent Laid Open No. 202038/83. According to an outline of this technique, there is provided an end point detecting means for detecting a cutting end point accurately by observing charged particles such as secondary ions or secondary electrons or an emission spectrum emitted from an ion beam-radiated part of a workpiece during cutting, whereby in removing a black spot defect caused by the adhesion of a light shielding film such as a chromium film to a part which should be transparent, for example in a photo mask, it is intended to prevent a glass substrate located below the black spot defect from being damaged by excess cutting.

Further, according to a conventional technique for measuring the potential of a defective part of an internal circuit in the analysis of a defect of an IC (integrated circuit) or an LSI, a laser beam is applied to an insulation film on an aluminum wiring of the defective part to form a hole and probes are manually put on the surface of the wiring (e.g. Japanese Patent Publication No. 6173/79).

In the above prior art such as Jpanese Patent Laid Open No. 106750/83, etc., regarding how to judge the time when a desired cutting depth was attained and how to stop cutting, it is merely mentioned that the radiation time and dose amount are made variable. An expression representing an etching depth S is shown on page 4 of the said laid open print, but there is no concrete description therein as to how cutting to a target depth can be done from that expression. A secondary ion analyzing method is referred to therein as a concrete method for detecting a cutting end point.

However, the LSI adopts a multilayer interconnection, so in order to cut a lower layer wiring, it is necessary to form a hole typically having a high aspect ratio, such as a cutting area of 5 $\mu m^2$ and a cutting depth of 10 $\mu m$, as shown in the sectional view of a cutting region of Fig. 1C. In the case of a small cutting depth, as shown in Fig. 1B, a sufficient quantity of secondary ions 29 are detected by a secondary ion detector 30. But at a higher aspect ratio, as in Fig. 1C, secondary ions 29 are scarcely detected. By this method, therefore, it is impossible to detect a cutting end point.

On the other hand, if the beam current and the acceleration voltage are constant, the cutting depth is proportional to the cutting time. In the case of a small cutting depth, the cutting time is short, so when the depth was controlled by the cutting time on the assumption that the beam current was constant within the said time, there occurred no large error.

In the hole shown in Fig. 1C, however, about 14 minutes was required for cutting, for example, a volume of 5 x 5 x 10 = 250 $\mu m^3$ at a typical cutting speed of 0.3 $\mu m^3$/S, and within this time it is impossible to ignore a drift

of a beam current iB as shown in Fig. 1D, which drift may exceed 10%. Therefore, where a cutting time is set on the basis of an initially-set current value and thereafter a drift is made in a decreasing direction of the beam current, as shown in Fig. 1E, an actual depth becomes insufficient so it is impossible to cut a wiring 31. Conversely, where a drift is made in an increasing direction of an actual current value as compared with an initially-set current value, cutting will be done to a larger depth than a target depth, reaching a lower-layer wiring, resulting in the occurrence of problems, e.g. short-circuit with an upper-layer wiring due to reattachment 33 of sputter from the lower-layer wiring.

Further, it has become clear that the technique disclosed in the foregoing Japanese Patent Laid Open No. 106750/83 involves the following problem.

In the recent LSIs there is generally adopted a multilayer interconnection and the spacing between adjacent wirings in the same layer is narrow, so for cutting a wiring in an internal layer it is necessary to form a hole having a high aspect ratio of, for example, a cutting area of 5 $\mu m^2$ and a cutting depth of 10 $\mu m$, and thus an extremely high accuracy etching is required. On the other hand, a multilayer interconnection of an LSI is formed by laminating an insulating film of for example silicon dioxide ($SiO_2$) and a wiring of for example aluminum (Al) successively on a semiconductor of for example a silicon (Si) single crystal by vapor deposition or any other suitable method, and subjecting the layers formed to a desired etching. Thus, it is formed through such working process. In the multilayer interconnection, therefore, a positional deviation which has occurred in the LSI working process may occur between the lower wiring layer in which the cutting region is positioned and the upper layer positioned thereabove. Consequently, in the case of positioning the cutting region located in the lower layer on the basis of a positioning mark formed on the upper layer, it is impossible to make an accurate positioning of the cutting region due to the foregoing positional deviation between upper and lower layers, sometimes resulting in that it is difficult to cut the desired part. This has been made clear by the present inventors.

In a cutting work using an ion beam, as shown in the above Japanese Patent Laid Open No. 202038/83, it is important to detect charged particles or emission spectrum emitted from a workpiece in order to control the depth of a cutting region with a high accuracy.

In the above prior art, however, no consideration is given to the case where a cutting region is in the form of a relatively deep concave and it is difficult to detect charged particles such as secondary ions and secondary electrons or an emission spectrum emitted from the cutting region.

More particularly, the present inventors have found the following problem. For example, in a logical element having a multilayer interconnection structure, in the case of making a logical correction, taking measures against a defective design or making analysis of a defect by cutting and exposure of wiring using an ion beam, if the wiring is in a relatively deep position, the aspect ratio (the ratio of depth to bore) of a cut-away hole becomes large, so that charged particles such as secondary ions and secondary electrons or an emission spectrum generated at the bottom of the cut-away hole will be captured in the interior of the cut-away hole. Consequently, the detection sensitivity is deteriorated and it is difficult to make an accurate control for the cut-away hole on the basis of detected charged particles or emission spectrum from the cutting region.

Where thickness of each constituent layer of a multilayer interconnection structure is known in advance, it is possible to control the cutting depth on the basis of the cutting speed. However, the thickness of each constituent layer of a multilayer interconnection structure usually differs greatly between the interiors of the same semiconductor wafers, between discrete semiconductor wafers and between semiconductor wafers processed simultaneously, depending on variations in the manufacturing process such as deposition. It requires much labor and is actually difficult to trace the thickness of each constituent layer of a multilayer interconnection structure on each individual case.

According to studies made by the present inventors, the technique of the foregoing Japanese Patent Publication No. 6173/79 involves the problem that the diameter of the hole formed by the radiation of a laser beam is usually as small as about 5 to 10 $\mu m$, while the diameter of the tip end portion of each probe is as large as about 3 $\mu m$ even at the smallest, so it is difficult to secure contact of the probe with the wiring. In manual probing, moreover, since the number of probes is limited, it is impossible to supply power while putting probes on all power supply pads during potential measurement. As a result, there occurs a drop in supply potential in the interior of LSI, making it impossible to measure the potential of a defective part accurately.

In the prior art disclosed in Japanese Patent Laid Open No. 106750/83, it is merely mentioned that the radiation time and dose amount are made variable regarding how to judge the time when a desired cutting depth was obtained and stop cutting. Although an expression representing an etching depth S is shown on page 4 of the said publication, there is found no concrete description therein about in what manner a target depth can be cut in accordance with the said expression. As to a concrete method for detecting a cutting end point, a method of analyzing secondary ions is mentioned therein.

However, since the LSI adopts a multilayer interconnection, in order to cut a lower-layer wiring, it is necessary to form a hole having a high aspect ratio, typically like a cutting area of 5 $\mu m^2$ and a cutting depth of 10 $\mu m$, as shown in the section of a cutting region in Fig. 5C. In the case of a small cutting depth as shown in Fig. 5B, a sufficient amount of secondary ions 520 can be detected by a secondary ion detector 521. But at a high aspect ratio, as shown in Fig. 5C, the secondary ions 520 are scarcely detected. With this method, therefore, it is impossible to detect a cutting end point.

On the other hand, if the beam current and the acceleration voltage are constant, the cutting depth is proportional to the cutting time. In the case of a small cutting depth, the cutting time is short, so even when the

depth was controlled by the cutting time on the assumption that the beam current was constant within the said time, there occurred no great error.

In the hole illustrated in Fig. 5C, however, it requires about 30 minutes to cut, for example, a volume of 5 x 5 x 10 = 250 $\mu m^3$ at a typical cutting speed of 0.14 $\mu m^3/S$. Within this time it is impossible to ignore the drift of the beam current iB, as shown in Fig. 5D. The drift sometimes exceeds 10%. Therefore, as shown in Fig. 5E, when the cutting time is set on the basis of an initially-set current value and thereafter a drift is made in a decreasing direction of the beam current, the actual depth will be insufficient to cut a wiring 522. Conversely, where a drift is made in an increasing direction of the actual current value as compared with the initial current value, even a lower-layer wiring deeper than a target depth will be cut, causing problems such as, for example, short-circuit with the upper-layer wiring due to reattachment of sputter 524 from the lower-layer wiring.

It is an object of the present invention to control a cutting depth with a high accuracy even when the beam current changes during cutting.

It is another object of the present invention to provide a technique capable of radiating an ion beam to a desired position of a workpiece to effect an exact cutting of high accuracy.

It is a further object of the present invention to provide a semiconductor device having a hole of a high aspect ratio formed at an accurate depth as well as a cutting technique using an ion beam capable of controlling a cutting depth with a high accuracy.

It is a still further object of the present invention to provide a technique capable of accurately measuring the potential of an internal circuitry of a semiconductor integrated circuit device.

It is a still further object of the present invention to monitor the cutting depth with a high accuracy even when the beam current changes during cutting.

The objects of the invention are attained by measuring a beam current at very short time intervals during cutting of a single hole, integrating the product of the thus-measured value and a cutting rate coefficient with respect to time to obtain a cut-away volume, and dividing the latter by the area of a beam scan region.

The above and other objects as well as novel features of the present invention will become apparent from the following description and the accompanying drawings.

Typical inventions disclosed herein will be outlined below.

The foregoing first object is attained by measuring a beam current at very short time intervals during cutting, integrating the measured value with respect to time to obtain a radiation ion quantity (hereinafter referred to as "dose amount") and calculating a cutting depth using the dose amount.

The second invention dislcosed herein will be typically outlined below.

In cutting a cutting region by radiating an ion beam to the same region which is positioned in an internal layer of a predetermined depth of a sample, an ion beam radiating position is determined by reference to a cutting reference mark formed at a depth equal to or approximately equal to the depth of the cutting region and there is performed cutting of the same region.

The third invention disclosed herein will be typically outlined below.

In a semiconductor device there is provided a trial cutting region equal in structure in the depth direction and in formation history to an element region.

Further, there are provided an ion source; an ion beam optical system for controlling the acceleration of an ion beam emitted from the ion source and also controlling an arrival position of the beam relative to a workpiece; a detecting means for detecting charged particles or emission spectrum emitted from a cutting region of the workpiece; an ion beam current measuring means for measuring an ion beam current; a dose amount calculating section for measuring a time required for cutting in each of the contituent layers of the workpiece on the basis of changes in charged particles or emission spectrum emitted from the workpiece and integrating the ion beam current measured during cutting of each layer in accordance with the said required time to thereby calculate a dose amount required for cutting per unit area of each layer in the workpiece; and a dose amount storage section for storing the calculated dose amount required for cutting per unit area of each layer, wherein the cutting of a second region is carried out through first and second stages. In the first stage, the dose amount required for cutting per unit area of each layer in a first region of the workpiece is grasped and stored in the dose amount storage section, while in the second stage, a target dose amount required for cutting up to a desired depth in the second region of the workpiece is set on the basis of the dose amount required for cutting per unit area of each layer in the first region of the workpiece which has been stored in the dose amount storage section, and cutting is performed until a dose amount obtained by integrating an ion beam current during cutting with respect to time reaches a target dose amount.

The fourth invention disclosed herein is typically outlined that it is provided with auxiliary bumps or pads in a floating state.

The operation of the first invention is as follows.

In a cutting work using a focused ion beam, as shown in Fig. 1F, atoms 34 sputtered by an ion beam 28 reattaches to the side wall of a cut-away hole to form a reattachment layer 35 so that the side wall of the cut-away hole is inclined. A change in shape of the cut-away hole formed by the reattachment layer exerts an influence on the cutting speed for the depth.

As a result of experiments we obtained such a relationship as shown in Fig. 1G. Where a cutting width L is sufficiently large (4d or more) relative to a value, 2d, twice a beam diameter,d, cutting is started, and while a flat portion remains on the bottom of a cut-away hole, cutting depth Z is proportional to a dose amount D. With further advancement of cutting, when the flat portion of the cut bottom disappears due to reattachment of

sputter and the cut-away hole becomes wedge-like, the cutting speed for the cutting depth Z becomes lower as shown in Fig. 1G. Where the cutting width L is narrower than the above, that is, where L is about the same as or smaller than twice the beam diameter,d, Z and D do not exhibit a proportional relation from the cutting start point, so the advancing speed of Z becomes lower with progress of cutting. In view of this point we have invented depth controlling methods with respect to both the case where Z is proportional to D and the case where Z is not proportional to D.

Where Z is proportional to D, a beam current is measured at a very short time interval during cutting and the measured value is integrated with respect to time to obtain a dose amount D, which in turn is multiplied by a constant of proportion to determine a depth Z. It is here assumed that the sputter volume per unit incident ion quantity of a workpiece material M is $k_M[\mu m^3/n_C]$ (hereinafter referred to as the "cutting rate coefficient of material M") and the opening area at the start of cutting is A $[\mu m^2]$ ($A = L_1 \times L_2$, $L_1$ and $L_2$ being longitudinal and transverse widths, respectively). The cutting depth Z is obtained by dividing the volume V (hereinafter referred to as "sputter volume") of the cut-away hole which is in the form of a rectangular parallelopiped, by an opening area A, ignoring reattachment and assuming that all the sputter atoms disappear. Therefore, the following equations are established:

$V = k_M D$ (1)

$Z = V/A = \frac{k_M}{A} D$ (2)

Thus, the constant of proportion of the above Z and D becomes $\frac{k_M}{A}$.

Next, where Z and D are not proportional to each other, the dose amount D is determined in the same manner as above. Thereafter, the depth Z is determined using a cutting depth function Z = g (D) which has been obtained beforehand by a trial cutting experiment.

According to the foregoing second invention, it is possible to effect cutting with an ion beam in an exact position since an ion beam radiating position can be determined by reference to a cutting reference mark formed with a view to seving as a reference in positioning a cutting region.

According to the foregoing third invention, a trial cutting is performed in a trial cutting region in performing an ion beam cutting with a view to making logical correction, taking measures against a defective design or making analysis of a defect, whereby a dose amount per unit area of each layer can be grasped accurately in advance and it is possible to form a hole of a high aspect ratio at an exact depth in an element region.

For example, in cutting a second region of a workpiece, even when the cutting region is in the form of a concave of a high aspect ratio having a large depth as compared with a cutting area and it is difficult to control the cutting depth under changes in the amount of secondary ions or secondary electrons emitted from the cutting region and detected, it is possible to set an exact target dose amount according to the cutting depth for the second cutting region on the basis of a dose amount per unit area of each layer which has already been grasped in the cutting of the first cutting region and stored in the dose amount storage section. The cutting depth can be controlled precisely by monitoring a dose amount which is obtained by integrating an ion beam current with respect to a cutting time.

According to the foregoing fourth invention, it is possible to make a potential measurement by connecting a portion to be measured for potential with an auxiliary bump or pad through wiring, thus permitting an exact potential measurement for an internal circuitry.

Further, the cutting depth can be monitored with a high accuracy even upon change in beam current during cutting, by measuring a beam current at a very short time interval during cutting for a single hole, then integrating the product of the measured value and a cutting rate coefficient with respect to time to obtain a cut-away volume and dividing the latter by the area of a beam scan region to obtain a cutting depth. More specifically, in a cutting work using an ion beam, since a smaple is cut by sputtering, sputter particles 525 are more likely to reattach to the side wall of a cut-away hole as the hole becomes deeper as shown in Fig. 5F, resulting in that the hole becomes tapered. Therefore, the opening portion comes to have an area A same as that of the beam scan region, but as the hole becomes deeper, a bottom area A′ becomes smaller than the area A.

As a result of an experiment it was confirmed that a cut-away hole volume gradually decreased in its rate of increase with respect to the cutting time (the beam current can be regarded as being almost constant), as shown in Fig. 5G. But the cutting depth increases at a constant rate of increase as long as the flat portion remains on the bottom ($A' > O$) as shown in Fig. 5H. It became clear, however, that this relation was no longer valid when the hole became conical with no bottom surface ($A' = O$).

Therefore, as shown in Fig. 5G, it is presumed that the volume V of the material sputtered by beam is constant with respect to time, but the reattachment volume $V_2$ increases as the hole becomes deeper, so the rate of increase of the cut away hole volume $V_1 = V - V_2$ changes. The volume V of the material sputtered with beam is referred to herein as a cut-away volume V. The cut-away volume V is represented as follows:

$V = 9\int k i_B dt$

where

k: cutting rate Coefficient $[\mu m^3 A^{-1} sec^{-1}]$

$i_B$: beam current [A]

This volume corresponds to a cut-away hole volume in the absence of reattachment of sputter particles and is therefore the volume of a quadrangular prism free of taper wherein the sectional area is A (the area of the beam scan region) everywhere.

Therefore, the cutting depth Z can be determined as follows:

Z = V/A

In the drawings:

Fig. 1 is a flowchart of an embodiment-1 of the present invention;

Fig. 1B and 1C are sectional view explaining how to detect secondary ions;

Fig. 1D is a diagram showing changes of a beam current with respect to time;

Fig. 1E is a diagram showing a cutting state according to a conventional method;

Fig. 1F is a sectional view of a cut-away hole;

Fig. 1G is a diagram showing changes in cutting depth during cutting;

Fig. 1H is a diagram showing a material function in the embodiment-1;

Fig. 1I is a diagram showing a cutting depth function in the embodiment-1;

Fig. 1J is a system block diagram embodying the invention;

Figs. 1K, 1L and 1M are diagrams showing beam current measuring methods;

Figs. 1N, 1O, 1P and 1Q are diagrams showing how to determine a beam current indirectly by calculation;

Fig. 2A is an enlarged sectional view of a wafer for explaining a cutting method using an ion beam according to an embodiment-2-I of the present invention;

Fig. 2B is a schematic block diagram of a cutting system used for practicing the ion beam cutting method shown in Fig. 2A;

Fig. 2C is an enlarged, schematic, perspective view of a sample stage in the cutting system;

Fig. 2D(a) is a schematic explanatory view showing an ion beam scanning state on the surface of a cutting reference mark;

Fig. 2D(b) is an explanatory view showing the intensity of secondary electrons detected;

Figs. 2E(a) to (D) are explanatory views showing modified examples in planar pattern of cutting reference marks;

Figs. 2F(a) and (b) are explanatory views showing modified examples in sectional shape of cutting reference marks;

Fig. 2G(a) is an enlarged, partial, sectional view showing a further example of a cutting reference mark, and Fig. 2G(b) is a schematic plan view thereof;

Fig. 2H is an enlarged, partial, sectional view of a wafer for explaning a cutting method using an ion beam according to an embodiment-1-II of the present invention;

Fig 2I is an enlarged plan view for explaining a relation between a cutting reference mark and a deviation detecting mark;

Fig. 3A is a block diagram showing a principal portion of a cutting system using an ion beam according to an embodiment-3 of the present invention;

Fig. 3B is a plan view showing an example of a semiconductor device of the invention to be subjected to a cutting work with an ion beam;

Fig. 3C is a sectional view of a part of the semiconductor device;

Fig. 3D is also a sectional view of a part of the semiconductor device;

Fig. 4A is a plan view showing a bipolar LSI according to an embodiment-4-I of the present invention;

Fig. 4B is a sectional view of a principal portion of the bipolar LSI shown in Fig. 4A;

Fig. 4C is a circuit diagram showing an ECL 3-input OR gate which constitutes the bipolar LSI shown in Fig. 4A;

Fig. 4D is a symbolic diagram of the ECL 3-input OR gate shown in Fig. 4C;

Figs. 4E to 4H are sectional views for explaining step by step a method for foming a wiring for connection;

Fig. 4I is a plan view in the state of Fig. 4H;

Fig. 4J is a plan view showing an embodiment-4-II of the present invention;

Fig. 5A is a flowchart of an embodiment-5-I of the present invention;

Figs. 5B and 5C are sectional views for explaining how to detect secondary ions;

Fig. 5CC is a diagram showing how a beam current changes with the lapse of time;

Fig. 5E is a diagram showing a cutting state according to a conventional method;

Fig. 5F is a sectional view of a cut-away hole;

Fig. 5G and 5H are graphs showing experimental results on cut-away volume and depth;

Fig. 5I is a system block diagram according to an embodiment-5-I of the invention;

Fig. 5J is a beam current measuring diagram in the embodiment-5-I;

Fig. 5K is a flowchart in the case of cutting plural materials in the embodiment 5-I;

Fig. 5L is a system block diagram according to an embodiment-5-II of the invention;

Fig. 5M is a graph showing a source current - beam current relation;

Fig. 5N is a diagram showing experimental results obtained in the embodiment-5-II;

Fig. 5O is a system block diagram according to an embodiment-5-III of the invention;

Fig. 5P is a graph showing an apeture current - beam current relation;

Fig. 5Q is a system block diagram according to an embodiment-5-IV of the invention;

Fig. 6A is a plan view of a part of a logical gate region on a semiconductor substrate;

Fig. 6B is a plan view of a crossing portion of auxiliary wirings;

Fig. 6C is a sectional view taken on line A-A of Fig. 2;

Fig. 6D is a plan view of a part of a logical gate region on a semiconductor substrate;
Figs. 6E and 6F are each a perspective view of a part of an auxiliary wiring;
Fig. 6G is a plan view of a crossing portion of auxiliary wirings;
Fig. 6H is a sectional view taken on line A-A of Fig. 6G;
Figs. 6I and 6J are each a sectional view of a part of an auxiliary wiring in a correction wiring forming step;
Fig. 6K is a plan view of a crossing portion of auxiliary wirings;
Fig. 6L is a sectional view taken on line A-A of Fig. 6K;
Figs. 6M and 6N are each a plan view of a part of a logical gate region on a semiconductor substrate;
Figs. 7A(a), (b) and 7B(a), (b) are plan and sectional views in a wired state according to an embodiment-7-I of the invention;
Figs. 7C(a) and (b) are plan and sectional views showing a wired state according to an embodiment-7-II of the invention;
Figs. 7D and 7E(a), (b) are plan and sectional views of a crossing structure according to an embodiment-7-III of the invention;
Fig. 7F is a plan view showing a wired state according to a modification of the embodiment-7-III;
Figs. 8A to 8U are diagrams showing a manufacturing process according to an embodiment-8 of the invention;

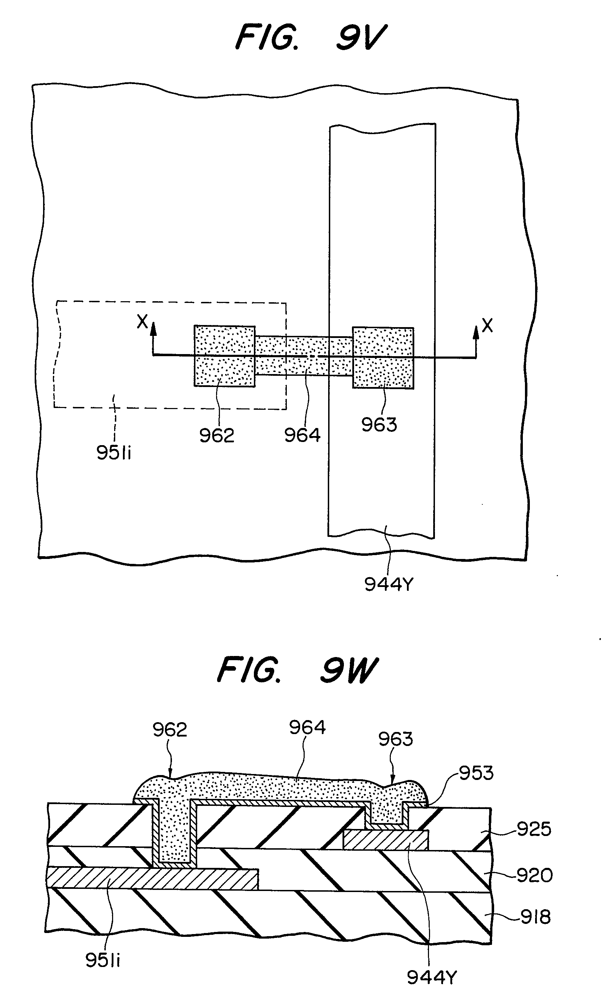

Fig. 9A is a sectional view showing a principal portion of a bipolar LSI according to an embodiment-9 of the invention;
Fig. 9B is a sectional view showing a pin grip array-type package sealing the bipolar LSI shown in Fig. 9A;
Figs. 9C to 9G are sectional views for explaining step by step how to manufacture the bipolar LSI shown in Fig. 9A;
Fig. 9H is a plan layout view of second to fourth aluminum wirings in a logic chip used in the embodiment-9 of the invention;
Fig. 9I is a layout diagram of various registering patterns and a wiring correction system tool used in the embodiment-9;
Fig. 9J is a plan layout view of an antenna wiring of an auxiliary gate cell in the embodiment-9;
Fig. 9K is a circuit diagram showing an auxiliary device in the auxiliary gate cell;
Fig. 9L to 9O are circuit diagrams showing various correction patterns;
Fig. 9P(a) to (d) are sectional views showing a process flow of correction by FIB and a laser CVD; and
Fig. 9Q to 9W are plan and sectional views of portions of wiring correction corresponding to various local correction techniques.

(1) Embodiment-1

Embodiment-1 of the present invention will be described below with reference to Figs. 1A, 1H, 1I and 1J.

In Fig. 1J, an ion beam emitted from an ion source 1 is focused onto a sample 8 through first, second and third lens electrodes (indicated at 2, 3 and 4, respectively, in the figure). The beam is bent and directed to a blanking aperture 6 by applying a voltage to a blanking electrode 5 as necessary, whereby the radiation of the beam to the sample 8 can be avoided. By applying a deflecting voltage to a deflector electrode 7 the beam can be scanned in a cutting region.

The sample 8 is fixed onto a stage 9 which is driven by a drive unit (not shown). During cutting, the stage 9 is fixed and the beam is deflected for scan.

Required voltages are fed to the blanking electrode 5 and the deflector electrode 7 from a blanking controller 11 and a deflector controller 10, respectively.

Fig. 1A is a flowchart for controlling the cutting depth using the system shown in Fig. 1J. In a cutting work, first a beam diameter $\underline{d}$ and cutting widths $L_1$ and $L_2$ (longitudinal and transverse widths, respectively) are set as cutting parameters, then a comparison is made between $\underline{d}$ and $L_1$, $L_2$ with respect to magnitude, then judgement is made as to whether a depth Z is proportional to a dose amount D or not, and with respect to the case where the answer is affirmative and a negative case, cutting is started along separate flows. The relation of $\underline{d}$, $L_1$ and $L_2$ for determining a proportional relation between Z and D changes depending on a workpiece, so it is necessary to determine it experimentally in advance. For example, in forming a multilayer interconnection of an LSI comprising aluminum wirings and sputtered $SiO_2$ films, $Z \propto D$ when $L_1 \geqq 4d$ and $L_2 \geqq 4d$, and Z is not proportional to D when $L_1 < 2d$ or $L_2 \lesssim 2d$. In an intermediate region, whether approximation to $Z \propto D$ can be made or not depends on the depth accuracy required. The present inventors obtained this relation experimentally.

Where Z is proportional to D, cutting is performed according to the flow shown on the left side in Fig. 1A. A timer is operated simultaneously with the start of cutting and a beam current $i_B$ is measured at every predetermined certain time $t_S$. The sampling time $t_S$ is selected to a time value within which a change in beam current is sufficiently small. In the measurement of a beam current, for example as shown in Fig. 1J, there is measured an ion current $i_{BL}$ flowing into the blanking aperture 6 and toward the earth upon blanking operation. If the blanking aperture 6 is formed in a structural shape which encloses all of emitted secondary electrons therein, the value of $i_{BL}$ coincides with the value of the beam current $i_B$.

At this time, the minimum unit of the sampling time $t_S$ corresponds to a single scan time, which is very short.

How to measure $i_{BL}$ will now be explained with reference to Figs. 1K, 1L and 1M. Upon blanking operation to intercept the ion beam at the blanking aperture 6, secondary ions 36 are generated from the same aperture due to collision of the ions therewith. The secondary ions 36 thus generated are attracted, for example, by an electric field developed by the blanking electrode 5 and fly away, resulting in that an electric current $i_{BL}$ including an additional current corresponding to the secondary electrons flow through an ammeter 12. This current $i_{BL}$ no longer coincides with a radiation beam current $i_B$ supplied for cutting. Therefore, in order to make the measured current $i_{BL}$ coincident with the radiation beam current $i_B$, it is necessary to have all of the generated secondary electrons 36 captured by the blanking aperture 6.

In the example shown in Fig. 1K, the upper portion of the blanking aperture 6 is provided with an eaves-like portion to shield it from the blanking electrode 5. As a result, the secondary electrons 36 are not influenced by the electric field formed by the blanking electrode 5, so can all be captured by the blanking aperture 6.

In the xample shown in Fig. 1L, the blanking aperture 6 is provided with a Faraday cup 37 so that an ion beam 28 is incident on the Faraday cup 37 during blanking operation. As a resuflt, all of the secondary electrons 36 can be captured into the Faraday cup 37 and the measured current $i_{BL}$ from the Faraday cup coincides with the radiation beam current $i_B$.

In the example shown in Fig. 1M, a secondary electron trapping electrode 38 is provided between the blanking aperture 6 and the blanking electrode 5 and a trap voltage is applied thereto from a secondary electron trapping power source. For example, the secondary electron trapping electrode 38 comprises a plate electrode centrally formed with a hole and a metallic mesh disposed in the central hole. Since the energy of the secondary electrons 36 is in the range of several eV to several ten eV, the trap voltage may be set to -100V or so. As a result, the secondary electrons 36 are all repelled toward the blanking aperture 6 and so can be trapped by the latter. The influence of the trap voltage upon the focusability of the ion beam 28 is slight and can be easily corrected by a lens voltage for example.

Now, the method of determining the value of $i_B$ indirectly by calculation from another current value will be explained below with reference to Figs. 1N, 1O, 1P and 1Q.

Fig. 1N shows an example of using as a measurement current all ion current (hereinafter referred to as the "source current $i_S$") provided from an ion source and flowing into a first lens electrode 2 (draw-out electrode). The source current $i_S$ flowing through a draw-out power source 41 is measured by an ammeter 42 and digitized by an A/D converter 43, then the measured value is transmitted to a CPU 45 by means of an optical data link 44. Since the $i_S$ measuring system floats to a degree corresponding to an acceleration voltage, the optical data link 44 is used for electrical insulation. In the CPU 45 the value of $i_B$ is calculated from the measured value $i_S$ using the following relation between the source current $i_S$ and the radiation beam current $i_B$ which has been obtained experimentally:

$i_B = F(i_S)$ (3)

As a result of an actual experiment the above $i_S$ - $i_B$ relation $F(i_S)$ could be expressed in a high accuracy using a linear function as shown in Fig. 1O:

$i_B = \alpha_1 i_S + \beta_1$ (4)

Reference will now be made to Fig. 1P showing an example of using as a measurement current an electric current (hereinafter referred to as "aperture current $i_A$") which is a current remaining after limiting the amount of radiation ions by the third lens electrode 4 (a beam limiting aperture). The aperture current $i_A$ flowing from the third lens electrode 4 is measured by an ammeter 46 and digitized by the A/D converter 43, then transmitted to the CPU 45. The CPU 45 calculates the value of $i_B$ from the measured value $i_A$ using the following relation between the aperture current $i_A$ and the radiation beam current $i_B$ which has been obtained experimentally, in the same manner as in the use of the source current is:

$i_B = G(i_A)$ (5)

According to an experiment, the above $i_A$ - $i_B$ relation $G(i_A)$ could also be expressed in a high accuracy using a linear fucntion as shown in Fig. 1Q:

$i_B = \alpha_2 i_S + \beta_2$ (6)

In these methods wherein the values of $i_S$ and $i_A$ are measured and the value of $i_B$ is determined by calculation, the accuracy of the function $F(i_S)$ or $G(i_A)$ used in the calculation has influence on the depth accuracy. Where the function $F(i_S)$ or $G(i_A$ is approximated by a linear function, it has been possible to make a depth control of $\pm 0.3$ μm for a cutting depth of 5 μm. However, where the cutting depth is above 5 μm or where a higher depth accuracy is required, it is possible that the accuracy of $F(i_S)$ or $G(i_A)$ will come into question.

The foregoing method of measuring the value of $i_B$ directly using $i_{BL}$ is suitable for attaining a higher depth accuracy although the structure of the blanking aperture becomes somewhat complicated.

The product of the $i_B$ [nA] and $t_S$ [sec] thus obtained is multiplied by a cutting rate coefficient $k_m$[μm$^3$/nc] to obtain an increment $\Delta V$ [μm$^3$] of the sputter volume within the sampling time:

$\Delta V = k_M i_B t_S$ (7)

$\Delta V$ is added to the sputter volume V [μm$^3$] from the start of cutting and the sum is divided by a cutting region opening area A [μm$^3$] ($A = L_1 \times L_2$), whereby the present cutting depth Z [μm] can be calculated.

$V = V + k_M i_B t_S$ (8)

$Z = V/A$ (9)

Cutting is repeated at every $t_S$ until the depth Z thus obtained exceeds a target depth Zo, whereupon the cutting is stopped.

In the above flow, the value of the cutting rate coefficient $k_M$ varies depending on the material M of a workpiece. Therefore, in the case of cutting a multilayer sample, it is necessary to judge the material M at every sampling time $t_S$ and determine the value of $k_M$. For example, the thickness of each layer of a workpiece is measured by means of an interferometer or the like and the material M is determined as a function f(Z) of the depth Z in advance, and judgement of the material is made in accordance with the value of Z at the time of sampling.

Fig. 1H shows an example of the material function f(Z). Where a multilayer structure shown in Fig. 1H is to be cut successively from upper to lower layer, the material changes like the graph shown in the same figure with progress of the cutting dedpth Z to obtain a material function f(Z).

Where Z is not proportional to D, cutting is performed in accordance with the flow shown on the right side in Fig. 1A. The timer is operated upon start of cutting and a beam current $i_B$ is measured at every certain time $t_S$. A dose amount increment $\Delta D = i_B \cdot t_S$ within the sampling time is determined by multiplying $i_B$ [nA] by $t_S$ [sec], and $\Delta D$ [nc] is added to the dose amount from the start of cutting to obtain a cumulative dose amount D[nc].

$D = D + i_B \cdot t_S$ (10)

The present cutting depth Z[$\mu$m] is obtained from the Z-D relation $Z = g(D)$ which has been determined beforehand and the D just obtained above. The cutting is repeated at every $t_S$ until Z exceeds the present target depth Zo, whereupon the cutting is stopped.

Fig. 1I shows an example of the cutting depth function $Z = g(D)$ which represents the relation of Z and D. Prior to an actual cutting, a trial cutting is performed while D is changed, using a sample of the same layer structure as that of a cutting region, and the depth Z of a cut-away hole is measured by an electron microscope for example to obtain the above functional relation $Z = g(D)$. $Z = g(D)$ is a monotone increasing function, so it is not necessary for the above trial cutting to fully cover the entire cutting depth. It is sufficient to effect cutting minutely only before and behind the taget depth Zo and approximate $Z = g(D)$ by a straight line with respect to the remaining region. For example, where the multilayer structure shown in Fig. 1I is to be cut up to an aluminum layer, that is, up to a target depth of 4 $\mu$m, a minute trial cutting is made for only the region of 4 $\mu$m or so in the depth Z and the remaining region is approximated by a straight line, whereby there is obtained such a relation as shown in the graph of the same figure, which relation corresponds to the cutting depth function g(D).

A constructional example of a control system for realizing the above cutting flow is shown in Fig. 1J. Necessary data such as $t_S$, d, $L_1$, $L_2$, $M = f(Z)$, $Z = g(D)$ and Zo are fed to a data memory 27. During cutting, a beam current $i_B$ detected by the blanking aperture 6 is measured by the ammeter 12 and the value obtained is digitized by an A/D converter 13 to obtain a digital signal, which is fed to the controller. Upon start of cutting, a timer 14 operates and a trigger signal is fed to the A/D converter 13 at every $t_S$, so that the converter 13 operates and the value of $i_B$ is fed to a switch circuit 15. The determination circuit 16 determines a proportional relation between Z and D on the basis of the values of input data d, $L_1$ and $L_2$, and the value of $i_B$ is distributed to the circuits which follow.

Where Z and D are proportional, the value $i_B$ is fed to a multiplier 17. A determination circuit 21 determines the material M from the depth Z and the material function $M = f(Z)$ and sets a value of $k_M$. The values of $i_B$, $t_S$ and $k_M$ are multiplied by the multiplier 17 and a value of the sputter volume V is determined in an adder 18. Further, V is divided by an opening area A in a divider 19 to calulate the present depth Z. The value of A is determined from the values of $L_1$ and $L_2$ by means of a multiplier 22. The depth Z is compared with the target depth Zo in a comparator 20. When Z exceeds Zo, a signal is fed to the blanking controller 11 to apply a voltage to the blanking electrode to stop cutting.

Where Z and D are not proportional, the value of $i_B$ is fed to a multiplier 23. The values $i_B$ and $t_S$ are multiplied by the multiplier and a cumulative dose amount D is determined by an adder 24. Further, in a determination circuit 25, the present depth Z is determined from $Z = g(D)$. The depth Z is compared with the target depth Zo by a comparator 26, and when Z exceeds Zo, a signal is fed to the blanking controller 11 to stop cutting.

According to the present invention, as set forth above, even when cutting is performed over a period of time wherein changes of the beam current are not negligible, the cutting depth can be controlled on the basis of current values measured at very short time intervals, so it is possible to form a hole of a high depth accuracy.

(2) Embodiment-2

Fig. 2A is an enlarged, partial sectional view of a wafer for explaining a cutting method using an ion beam according to an embodiment-2-I of the invention; Fig. 2B is a schematic block diagram of a cutting system used for practicing the said ion beam cutting method; Fig. 2C is a schematic perspective view showing a sample stage in the cutting system on a larger scale; Fig. 2D(a) is a schematic explanatory view showing an ion beam scanning state on the surface of a cutting reference mark; Fig. 2D(b) is an explanatory view showing the intensity of secondary electrons detected. Further, Figs. 2E(a) to (d) each show a modified example of a planar pattern of a cutting reference mark, and Figs. 2F(a) and (b) each show a modified example in sectional shape of a cutting reference mark. Fig. 2G(a) is an enlarged, partial sectional view showing a further example of a cutting reference mark and Fig. 2G(b) is a schematic plan view thereof.

As shown in Fig. 2B, the cutting system used for the ion beam cutting method of this embodiment comprises components 201 to 232.

In Fig. 2B, the reference numeral 201 denotes an ion source emitter disposed at an upper part of the system body and containing an ion source such as, for example, molten metal. Disposed under the ion source emitter

201 is a draw-out electrode 202 to release ions into vacuum. Below the draw-out electrode 202 are disposed a first lens electrode 208 which functions as an electrostatic lens and a first aperture electrode 203 which functions as an aperture mask. Provided below the first aperture electrode 203 are a second lens electrode 204, a second aperture electrode 209, a blanking electrode 205 for controlling ON-OFF of beam radiation, a third aperture electrode 206 and a deflecting electrode 207.

Under the construction using such various electrodes the ion beam B emitted from the ion source emitter 201 is formed as a focused beam, which is applied onto a wafer 212 as a workpiece while being controlled by the blanking electrode 205 and the deflecting electrode 207.

The wafer 212 is placed on a sample holder 213 disposed on the sample stage 215. The sample stage 215 is positioned by a stage driving motor 217 while its position is checked by a laser interference length measuring device 216 through laser mirrors 214 attached to side portions of the sample stage 215.

Above the wafer 212 is disposed a secondary ion/secondary electron detector 211 to detect secodnary ions and secondary electrons emitted from the wafer 212.

Postioned above the secondary ion/secondary electron detector 211 is an electron shower 210 having a structure which prevents the upper surface of the wafer 212 from being charged.

The interior of the cutting system described above is held in vacuum by means of a vacuum pump indicated at 218 in the figure. The operation of the cutting system is controlled by controllers 219 - 223, which in turn are controlled by a control computer 229 through interfaces 224 - 228. In the control computer 229 there are performed input, output and recording of data through a terminal 230, a magnetic disc 231 and an MT deck 232.

The cutting system described above is constructed so that in accordance with positional data stored in the magnetic disc 231 the sample stage 215 can be moved a predetermined distance in XY directions by the stage driving motor 217 which is controlled by the controller 222. In this case, a slight deviation between an actual moving distance and the positional data is determined by utilizing interference of laser beams. More particularly, a laser beam A emitted from the laser interference length measuring device 216 is reflected by wall surfaces in X and Y directions of the sample stage 215 through the laser mirrors 214 and the reflected beams are again incident on the laser interference length measuring device 216 and interfere with each other. The information of such positional deviation is fed as necessary to the deflecting controller 220 for controlling the deflecting electrode 207 so that a fine correction of a radiated position of the ion beam B can be effected.

In Fig. 2A, a part of the wafer 212 as a sample is shown on a larger scale. The body of the wafer 212 is constituted by a semiconductor substrate 212a comprising a single crystal of silicon (Si) for example. On the semiconductor substrate 212a is formed a multilayer interconnection comprising three layers. More specifically, as the lowest layer is formed a first wiring layer 235 comprising a first wiring 233 and a first insulation layer 234 formed thereon, a second wiring layer 235a laminated onto the first wiring layer 235 and comprising a second wiring 233a and a second insulation layer 234a formed thereon, and a third wiring layer 235b laminated as the top layer onto the second wiring layer 235a and comprising a third wiring 233b and a third insulation layer 234b formed thereon.

In the above multilayer interconnection, the first, second and third wiring layers 235, 235a and 235b are provided with cutting reference marks 236, 237 and 238, respectively, to be used for cutting the wiring layers. The cutting reference mark 236 may be formed in its planar shape as shown in Figs. 2E(a) to (d), although its planar shape is not limited thereto. Its section may be in a projecting shape [Fig. 2F(a)] of the same structure as that shown in Fig. 2A, or may be such a grooved shape as shown in Fig. 2F(b). Various materials, including aluminum ($A\ell$), are employable for forming the cutting reference mark 236. Especially, materials capable of forming the mark in a uniform thickness are desirable. The cutting reference marks 236, etc. are formed simultaneously with the forming of the multilayer wirings.

In Fig. 2A, over the cutting reference mark 236 are successively laminated the first insulation layer 234, second wiring 233a, second insulation layer 234a and third wiring 233b. The third wiring 233b of the top layer is exposed to the exterior. Each layer has a uniform thickness of a high accuracy, so that the shape of the cutting reference mark 236 is exactly reflected on the surface of the third wiring 233 positioned just above the mark 236, and the right and left upper edges of the reference mark 236 are reflected as edge portions $E_1$ and $E_2$ in the top third wiring 233b. The edge portions $E_1$ and $E_2$ has a certain extent in the planar direction as compared with the edges of the reference mark 236. The said extent is proportional to the number of laminated layers and the center between both edges of the reference mark 236 is in exact coincidence with the center of the edge portions $E_1$ and $E_2$. Therefore, it follows that if the edge portions $E_1$ and $E_2$ can be specified positionally, the center of the reference mark positioned in the lowest layer can also be accurately specified inevitably.

Such a position specifying technique will be explained below in more detail. The following description is of the case where positioning is performed on the basis of the cutting reference mark 236 and ion beam is directed to the first wiring 233 of the first wiring layer 235 to cut the wiring.

First, the wafer 212 is placed in a predetermined position of the sample stage 215 of the cutting system and thereafter the vacuum pump 218 is operated to make the interifor of the system vacuous to a predetermined degree. Then, the stage driving motor 217 is operated in accordance with the positional data stored in the magnetic disc 231 to move the sample stage 215 up to a position in which the ion beam is just above the reference mark 236 in the first wiring layer. Then, as schematically shown in Fig. 2D(a), on the surface of the third wiring 233b of the top layer with the reference mark 236 reflected thereon, the ion beam B is scanned over a range exceeding the edge portions $E_1$ and $E_2$ and secondary electrons C generated are detected. The position of the cutting reference mark located in the lowest layer is grasped on the basis of changes in the

amount of secondary electrons C detected. It is Fig. 2D(b) that shows a detected state of the secondary electrons C. The amount of the secondary electrons increases at the edge portions $E_1$ and $E_2$ of the third wiring 233b, giving peak values. From the peak positions in the intensity of the secondary electrons detected there can be calculated positional coordinates of the edge portions of the cutting reference mark 236 and that of the center of the reference mark 236.

According to this embodiment, the reference mark 236 is not directly exposed to the surface of the wafer 212, but its shape is exactly reflected in the difference in height, i.e. edge portions, of the third wiring 233b of the top layer in proportion to the number of layers. Consequently, a central position of the reference mark located in the lowest layer can be calculated with a high accuracy.

Since a central position of the reference mark 236 in the bottom layer can thus be specified, it is possible to accurately calculated a positional relation of the wiring formed in the bottom layer.

Then, on the basis of the positional information obtained as above, the positional coordinates of the cutting position prestored in the magnetic disc 231 are fed to the controller 222 to operate the stage driving motor 217 whereby the first wiring of the lowest layer can be cut. In Fig. 2A, the wiring is cut in a position spaced a distance $\ell$ from the cutting reference mark 236. In cutting the wiring 233 positioned in the lowest layer, it is possible to effect positioning on the basis of the edge portions $E_1$ and $E_2$ of the third wiring 233B of the top layer in which is accurately reflected the reference mark 236 positioned in the bottom layer. Consequently, it is possible to make a positional recognition of an extremely high accuracy, so it is possible to effectively prevent the wiring 233 from being cut erroneously for example.

A brief explanation will now be given about a cutting technique using the ion beam B. The wiring layers are etched at desired depth and width by radiating the ion beam B at a predetermined scanning width for a predetermined time while adjusting the amount of the ion beam B radiated, radiation time, acceleration voltage, or the voltage applied to the deflecting electrode 207.

In the above description the positioning is performed by recognizing the edge portions $E_1$ and $E_2$ of the top layer wiring 233b in which is reflected the shape of the cutting reference mark 236 positioned in the bottom layer. But the positioning method is not limited to this. The layer overlying the reference mark 236 may be removed by etching in a predetermined range to have the mark 236 exposed to the exterior directly and the bottom layer wiring 233 may be cut with reference to the exposed mark.

The cutting reference mark 236 may be of such a structure as shown in Fig. 2G, not such a single structure as shown in Fig. 2A. More specifically, a first pattern comprising two cutting reference marks 236 and 239 arranged side by side is formed at the same depth as the first wiring 233. On the first pattern is formed a second pattern 240 directly without interposition of the first insulation layer 234. Further, a third pattern 241 is directly formed on the second pattern 240. The first pattern, the second 240 and the third 241 can be formed in the same step as that for wirings (not shown) formed at the same depths as the respective layers. First, second and third insulation layers 234, 234a and 234b positioned above the reference marks 236 and 239 are removed by etching, so the third pattern 241 is in an exposed state. By adopting such a structure without interposition of insulation layers the cutting reference marks 236 and 239 in the lowest layer can be reflected in the shape of the top layer.

Where such parallel reference marks 236 and 239 are used, the right-hand edge of the reference mark 236 positioned left in Fig. 2G is exactly reflected in an edge portion $E_1$ of the third pattern 241, while the left-hand edge of the reference mark 239 positioned right is exactly reflected in an edge portion $E_2$ of the third pattern 241. Therefore, the central position of the edge portions $E_1$ and $E_2$ corresponds exactly to the central position of the reference marks 236 and 239. Therefore, when the surface of the third pattern 241 is scanned with an ion beam, the intensity of secondary electrons detected greatly varies at the edge portions $E_1$ and $E_2$ like the case explained in connection with Fig. 2A, so positional coordinates of the edge portions $E_1$ and $E_2$ can be determined accurately. As a result, from the positional coordinates of the edge portions $E_1$ and $E_2$ it is possible to specify a central position of the cutting reference marks 236 and 239 accurately and it is possible to effect positioning of the cutting region on the basis of the said central positions. Consequently, the cutting region can be positionally specified extremely accurately and can be cut with a high accuracy like the case of Fig. 2A.

Thus, according to this embodiment there can be attained the following effects.

(1) In ion beam cutting, a cutting reference mark 236 for positioning a cutting region is provided in the same layer as the first wiring which is the cutting region, and positioning is performed on the basis of the shape of the top layer wiring 233b in which is exactly reflected the shape of the reference mark 236, whereby the positioning of the cutting region can be effected with an extremely high accuracy even when there is a positional deviation in the horizontal direction between layers. Consequently, it is possible to apply a beam cutting to an exact position in a high accuracy.

(2) The surface of the third wiring 233b formed with edge portions $E_1$ and $E_2$ in which is reflected the edges of the cutting reference mark 236 shown in the above (1), is scanned with an ion beam, and positional coordinates of the edge portions $E_1$ and $E_2$ are specified on the basis of changes in intensity of secondary electrons produced, whereby coordinates of a central position of the reference mark 236 can be specified with a high accuracy, so it is possible to further improve the accuracy of a cutting work using an ion beam.

(3) Two cutting reference marks 236 and 239 are provided side by side and second and third patterns are laminated over those reference marks without interposition of an insulation layer, whereby the edges in opposed positions of those two marks can be reflected more accurately as edge portions $E_1$ and $E_2$ of

the top layer. Consequently, it becomes possible to accurately specify a central position of the cutting reference marks 236 and 239 on the basis of positional coordinates of the edge portions $E_1$ and $E_2$ and the cutting accuracy for the cutting region can be further enhanced.

Fig. 2H is an enlarged, partial sectional view of a wafer for explaining a cutting method using an ion beam according to an embodiment-2-II of the invention, and Fig. 2I is an enlarged plan view of both a cutting reference mark and a deviation detecting mark for explaining the relation of both marks.

Embodiment-2-II is for cutting a wiring disposed in a lower wiring layer of an LSI using a cutting system having substantially the same functions as in the cutting system used in the foregoing embodiment-2-I. A difference resides in how to specify a position of a cutting reference mark 236 which is provided for the purpose of cutting the first layer.

More specifically, a part of an LSI applied to this embodiment-2-II is shown in Fig. 2H. Like the prévious embodiment 2-I, this LSI has a multilayer interconnection comprising three layers which are a first wiring layer 235, a second wiring layer 235a and a third wiring layer 235b. The first wiring layer 235 is formed with a cutting reference mark 236 for use as a positioning reference in cutting the first wiring 233. In this embodiment-2-II, morevoer, a deviation detecting mark 242 for detecting a cutting deviation between layers is formed in the region of the third wiring layer 235b located above the cutting reference mark 236. The third wiring layer 235 is further formed with an auxiliary cutting mark 243. In Fig. 2H, a part of the third wiring layer 235b is removed by etching to expose the deviation detecting mark 242 and the auxiliary cutting mark 243 to the exterior.

In this embodiment-2-II, first an amount of deviation between the cutting reference mark 236 and the deviation detecting mark 242 is measured using an optical microscope 244. This amount of deviation appears as the total of interlayer deviation quantities between the first wiring layer 235 and the third wiring layer 235b. As shown in Fig. 2I, the deviation detecting mark 242 is provided in a plural number in a parallel direction. These marks are formed in such a positional relation that their spacings are wider at the rightmost end in Fig. 2I like, from the leftmost end, $m_1 = 3.6\ \mu m$, $m_2 = 3.8\ \mu m$, $m_3 = 4.2\ \mu m$ and $m_4 = 4.4\ \mu m$. On the other hand, the reference patterns 245 are formed at equal intervals of, say, $n = 4.0\ \mu m$.

The deviation detecting marks 242 and the reference patterns 245 are designed in such a positional relation that in the case where such five sets of patterns as shown in Fig. 2I are set, centrally positioned, deviation detecting mark 242 m and reference pattern 245 m are coincident in their ceter lines. In other words, when there is a planar, positional deviation between any layers from the bottom to the top layers, the centrally positioned, deviation detecting mark 242 m and reference pattern 245 m are not coincident in their axes. In Fig. 2I illustrating this embodiment-2-II, the axis of the central, deviation detecting mark 242 m and that of the central, reference pattern 245 m are not in coincidence, while the deviation detecting mark 242 and the reference pattern 245 both positioned second from the left are coincident in their axes. Therefore, it can be easily seen that in Fig. 2I the top layer is in deviation by 0.2 µm leftwards with respect to the lowest layer.

A central axis position of each reference pattern can be easily recongized by measuring the distance $\underline{m}$ of each deviation detecting mark 242 from each of the edge portion $E_1$ and $E_2$ of each reference pattern 245.

Thus, where there is a deviation of 0.2 µm between the deviation detecting mark 242 and the cutting reference mark 236, a coordinate value is corrected by 0.2 µm rightwards with respect to the auxiliary cutting mark 243 at the time of positioning the cutting region with reference to the auxiliary mark 243. As a result, even in the case of specifying a position of the cutting region with reference to the auxiliary cutting mark 243 located in the third wiring layer, this can be done in an extremely high accuracy and the first wiring 233 can be cut highly accurately in an exact position.

Although only transverse relations have been referred to in the above description, positional deviations in the vertical direction in the figure can also be dealt with in the same manner.

It is to be understood that the invention is not limited to the embodiment described above, but that various modifications may be made within the scope not departing from the gist of the invention.

For example, as means for positional recognition through scanning with an ion beam, the above embodiment utilizes changes in intensity of secondary electrons detected, there may be utilized the intensity of secondary electrons detected, there may be utilized the intensity of secondary ions detected or changes of ionic species.

In the above description the present invention has been applied mainly to wafers as a background utilization field of the invention, but the invention is not limited thereto. For example, the present invention is applicable to all of those having a multilayer structure.

An effect obtained by a typical invention disclosed herein will now be explained. In cutting a cutting region positioned in an internal layer at a predetermined depth of a sample under radiation of an ion beam, an ion beam radiating position is determined by reference to a cutting reference mark formed at a depth just the same or almost the same as the depth of the cutting region, the said reference mark serving as a reference in positioning the cutting region, whereby the cutting work using the ion beam can be done in an exact position.

(3) Embodiment-3

Fig. 3A is a block. diagram showing a principal portion of a cutting system using an ion beam according to an embodiment-3 of the present invention; Fig. 3B is a plan view showing an example of a semiconductor device of the present invention to be subjected to a cutting work using an ion beam; and Figs. 3C and 3D are each a sectional view of a part of the semiconductor device.

On an X-Y table 301 movable in a horizontal plane there is placed a semiconductor wafer 302 (workpiece)

removably at a predetermined posture, the wafer 302 having a plurality of semiconductor devices 302a formed by having a thin film of a predetermined material deposited thereon through repetition of photolithography.

Each semiconductor device 302a on the semiconductor wafer 302 is formed with not only an element region 302b (a second part) but also a trial cutting region 302c (a first part).

In the element region 302b of the semiconductor device 302a there is formed a logical element having a multilayer interconnection structure comprising an insulator substrate 302d and a laminate formed thereon which laminate comprises a first aluminum wiring layer 302e, an inter-layer insulating film 302f, a second aluminum wiring layer 302g, an inter-layer insulating film 302h, a third aluminum wiring layer 302i, an inter-layer insulating film 302j, a fourth aluminum wiring layer 302k and a final protective film 302ℓ. The trial cutting region 302c is the same as the element region 302b in the material deposition structure in the depth direction and also in the formation history of such deposition structure.

The X-Y table 301 is driven through a servomotor 301a and it is constructed so that a displacement thereof is detected by a laser interferometer 301b, which displacement can be controlled precisely in a closed loop by an X-Y table controller 301c.

Above the X Y table 301 is provided an ion source 303 facing downwards, which is constructed so that an ion beam 304 comprising gallium (Ga) ion for example is radiated toward the semiconductor wafer 302 placed on the X Y table 301.

In the path of the ion beam 304 extending from the ion sofurce 303 to the semiconductor wafer 302 there is disposed an ion beam optical system 305 comprising a draw-out electrode 305a, a convergent lens group 305b and an electrostatic deflecting lens group 305c, whereby there are performed acceleration, convergence and selection of ions constituting the ion beam 304 as well as control of an incident position of the ion beam 304 relative to the semiconductor wafer 302.

Also provided in the path of the ion beam 304 is an ion beam current detecting means 306 for detecting an ion beam current $I_B$.

In the vicinity of the X-Y table 301 with the semiconductor wafer 302 placed thereon is disposed a detecting means 307 for detecting charged particles such as secondary ions or secondary electrons or an emission spectrum, indicated at 304a, generated from the semiconductor wafer 302 upon incidence of the ion beam 304. Together with the ion beam current detecting means 306, the detecting means 307 is connected to a dose amount operator 308.

The dose amount operator 308 measures the time required for cutting each of the layers constituting the multilayer interconnection structure of each semiconductor device 302a formed on the semiconductor wafer 302, on the basis of a change of secondary ion species, a change in the amount of secondary electrons, or a change of emission spectrum, provided from the semiconductor wafer 302 and detected through the detecting means 307. The dose amount operator 308 further functions to integrate the ion beam current $I_B$ with respect to each required time to thereby calculate a dose amount required for cutting unit area of each constituent layer of the multilayer interconnection structure of the semiconductor device 302a. The dose amount thus calculated is stored in a dose amount storage 309.

The X-Y table 301, ion source 303, ion beam optical system 305, ion beam current detecting means 306 and detecting means 307 are disposed within a vacuum vessel 310.

To the vacuum vessel 310 is connected an exhausting means 311 constituted, for example, by connecting vacuum pumps in multi-stage, whereby the interior of the vessel 310 can be exhausted to a desired degree of vacuum.

Further, a stand-by exhaust chamber 314 having an outer door 313 is connected to the vacuum vessel 310 through a gate valve 312, and thus the semiconductor wafer 302 can be taken in and out with respect to the X-Y table 301 without impairment of the internal vacuum degree of the vacuum chamber 310.

The X-Y table controller 301c, ion beam optical system 305, dose amount operator 308 and exhausting means 311 are together controlled by a main controller 315 comprising a control computer, etc.

The operation of this embodiment will be described below.

First, the X-Y table 301 is moved as necessary whereby the trail cutting region 302c of a semiconductor device 302a formed on the semiconductor wafer 302 is positioned just under the ion source 303.

Next, upon radiation of the ion beam 304 there is started operation for cutting the trail cutting region 302c in a cutting plane area Ao [$\mu m^2$]. This area Ao is set sufficiently large relative to a required cutting depth so that the aspect ratio of the concave of the cutting region becomes small, that is, charged particles or emission spectrum 304a generated from the cutting region is detected sufficiently by the detecting means 307.

At this time, the dose amount operator 308 determines a time $t_i$ ($i = 1, 2, 3, ...$)[s] required for cutting each of the final protective film 302ℓ, fourth aluminum wiring layer 302k, inter-layer insulating film 302j, ..., on the basis of a switching time of secondary ion species, intensity of secondary electrons, or a changing time of emission spectrum, with respect to the charged particles or emission spectrum 304a detected through the detecting means 307. At the same time it measures an ion beam current $I_B$.[nA] through the ion beam current detecting means 306.

If the sputter rate of the constituent material of each layer is $k_i$ [$\mu m^3\ s^{-1}\ nA^{-1}$], a cutting depth $Z_i$ [$\mu m$] at a cutting time $t_i$ is given as follows.

$$Z_i = k_i A_0^{-1} \int_0^{t_i} I_B \, dt$$

Thus, the dose amount $D_i$ required for cutting unit area of each layer can be obtained as follows:

$$D_i = Z_i / k_i$$

$$= 1 / A_0^{-1} \int_0^{t_i} I_B \, dt$$

$$[nA \cdot s \cdot \mu m^{-2}]$$

Thus, the dose amount operator 308 calculates the dose amount $D_i = Z_i/k_i$ required for cutting per unit area of each layer, on the basis of the cutting time $t_i$ required for cutting each layer and the ion beam current $I_B$ during cutting, and then stores the calculated dose amount in the dose amount storage 309. (First stage)

Then, the main controller 315 reads the dose amount $D_i$ required for cutting per unit area of each layer stored in the dose amount storage 309 and calculates a target dose amount $D_{TOT}$ in cutting the element region 302b.

Where a hole of an area $A_1$ [$\mu m^2$] extending from the final protective film 302$\ell$ as the top layer to the second aluminum wiring layer 302g is to be formed in the element region 302b and the second aluminum wiring layer 302g is to be cut, the dose amount D required per unit area is:

$D = D_1 + \cdot \cdot D_6 + D_1 \cdot C_1$

$= Z_1/k_1 + \cdot \cdot + Z_6/k_6 + (Z_7/k_7)\ C_1$

$[nA \cdot S \cdot \mu m^{-2}]$

wherein $C_1$ represents an excess cutting coefficient which is determined in consideration of variations in cutting depth in the final cutting layer, and in this case it is set to say 0.2 or so, $Z_1/k_1 + \cdot\cdot + Z_6/k_6$ represents a predetermined cutting quantity and $(Z_7/k_7)C_1$ represents an excess cutting quantity.

The target dose amount $D_{TOT}$ required for cutting the entire hole to be formed in the element region 302b is obtained as:

$D_{TOT} = D \cdot A_1 \cdot (1/f(a))$

$[nA \cdot S]$

wherein f(a) is a coefficient indicative of a cutting efficiency which varies according to the aspect ratio a of the hole to be formed in the element region 302b.

$f(a) \leqq 1$.

With increase of the aspect ratio a the cutting efficiency lowers and f(a) decreases, so $D_{TOT}$ increases.

Simultaneously with the above calculation of $D_{TOT}$, the X-Y table is moved as necessary, whereby the object element region 302b is positioned just under the ion source 303.

Then, cutting for the region of a cutting area $A_1$ is started while observing the ion beam current $I_B$ capable of being measured easily without being influenced by the aspect ratio of the cutting region and also observing the cutting time. The cutting work is continued until a dose amount obtained by integrating the ion beam current $I_B$ with respect to a cutting time reaches the target dose amount $D_{TOT}$. At the end of cutting there will be obtained a hole in the element region 302b, having the area $A_1$ and a depth which is neither excessive nor deficient, and in this state the second aluminum wiring layer 302g is sure to be cut, whereby it is possible to effect logical correction of the semiconductor device 302a, take measures against a defective design or make analysis of a defect accurately without damage to the underlying insulating layer.

(Second stage)

Thus, according to this embodiment there can be obtained the following effects.

(1) The semiconductor devices 302a formed on the semiconductor wafer 302 are each provided with the element region 302b and the trial cutting region 302c and in the trial cutting region 302c there is performed cutting through the first stage of determining the dose amount $D_1$ required for cutting per unit

area of each constituent layer of a multilayer interconnection structure while fully detecting charged particles or emission spectrum 304 generated from the cutting region at a sufficiently large cutting area as compared with the depth in the trail cutting region 302c, and determining the target dose amount $D_{TOT}$ on the basis of the dose amount $D_1$, and further through the second stage of radiating the ion beam 304 to the object element region 302b while determining a dose amount on the basis of an ion bean current $I_B$ which can be observed easily regardless of the aspect ratio of the cutting region and also on the basis of a cutting time, and continuing the cutting work until the dose amount during cutting reaches the target dose amount $D_{TOT}$. Therefore, the depth of the hole of a high aspect ratio formed by the radiation of the ion beam 304 in the element region 302b can be controlled accurately.

(2) As a result of the above effect (1) it is possible to effect logical correction, take measures against a defective design or make analysis of a defect by cutting and exposing a wiring layer using an ion beam in a semiconductor device 302a or other high density logical elements.

(3) It is possible to effect a cutting work using an ion beam while controlling the cutting depth precisely even in a semiconductor device 302a wherein the thickness $Z_i$ of each layer in the depth direction and the sputter rate $k_i$ of the ion beam 304 for the constituent material of each such layer are unknown.

(4) As a result of the above effects (1) to (3) it is possible to improve the efficiency of such operations as logical correction, taking measures against a defective design or analysis of a defect in a cutting work using an ion beam in a high density logical element.

It goes without saying that the invention is not limited to the above concrete embodiment and that various modifications may be made within the range not departing the gist of the invention.

Although in the above description the invention was applied to making logical correction, taking measures against a defective design or making analysis of a defect using an ion beam in a logical element as a background utilization field of the invention, the invention is not limited thereto, but can be applied widely to ion beam cutting techniques at large for which is required a precise control for the depth of a cutting region having a high aspect ratio.

A brief description will be given below about effects which are obtained by a typical invention disclosed herein.

In the semiconductor device there is provided a trial cutting region having the same structure in the depth direction and formation history as the element region, so in performing a cutting work using an ion beam with a view to making logical correction, taking measures against a defective design or making analysis of a defect with respect to the semiconductor device, cutting is performed on trial in the trial cutting region, whereby the dose amount per unit area of each layer can be determined exactly in advance and so a hole of a high aspect ratio can be formed at an accurate depth in the element region by the radiation of ion beam.

The ion beam cutting system includes an ion source, an ion beam optical system for controlling an ion beam emitted from the ion source, a detecting means for detecting charged particles or emission spectrum generated from a cutting region of a workpiece, an ion beam current measuring means, a dose amount operator for determining a time required for cutting each constituent layer of the workpiece on the basis of a change of the charged particles or emission spectrum generated from the workpiece and integrating an ion beam current measured during cutting of each said layer with respect to the said required time, thereby calculating a dose amount required for cutting per unit area of each said layer in the workpiece, and a dose amount storage for storing the calculated dose amount required for cutting per unit area of each said layer. Cutting for a second region of the workpiece is performed through a first stage of determining a dose amount required for cutting per unit area of each said layer in a first region of the workpiece and storing it in the dose amount storage and further through a second stage of setting a target dose amount required for cutting up to a desired depth in the second region of the workpiece on the basis of the dose amount required for cutting per unit area of each said layer in the first region of the workpiece and stored in the dose amount storage, and continuing the cutting work until a dose amount obtained by integrating an ion beam current during cutting with respect to a cutting time reaches the target dose amount. For example, therefore, even when the second region of the workpiece is in a concave shape of a high aspect ratio having a large depth as compared with the cutting area and so it is difficult to control the cutting depth on the basis of a detected amount of secondary ions or secondary electrons generated from the cutting region, it is possible to set an exact target dose amount according to the cutting depth of the second region on the basis of the dose amount per unit area of each layer predetermined in the cutting of the first region and stored in the dose amount storage, and the cutting depth can be controlled precisely by monitoring the dose amount obtained by integrating an ion beam current detectable easily irrespective of the shape of the cutting region with respect to time.

(4) Embodiment-4

An embodiment-4 of the present invention will be described below concretely with reference to the drawings. In all of the drawings for illustration of this embodiment, the components having the same functions are indicated by the same reference numerals, and repeated explanations will be omitted.

Fig. 4A is a plan view showing a bipolar LSI according to an embodiment-4-I of the invention. As shown in the same figure, in the bipolar LSI of this embodiment, a large number of bumps 402 are provided throughout the whole surface of a semiconductor chip 401 such as, for example, a square, P-type silicon chip. The bumps 402 comprise bumps for the supply of an electric power as a power source of the LSI, including a negative potential $V_{EE}$ (e.g. -3V), a negative potential $V_{TT}$ (e.g. -2V) and $V_{CC}$ [e.g. GND(OV)] (see Fig. 4C), and bumps for the input

and output of signals. These bumps 402 are connected to an internal circuitry of the LSI through, for example, a fourth aluminum wiring layer not shown in Fig. 4A.

In this embodiment, auxiliary bumps 402a are provided at the four corners of the semiconductor chip 401 in addition to the bumps 402. In a completed state of the LSI, the auxiliary bumps 402a are not connected by wiring to the internal circuitry and are in an electrically floating state.

Numerals 403 and 404 represent auxiliary wirings comprising aluminum films of, for example the third and fourth layers respectively. In this embodiment they are provided each in a plural number perpendicularly to each other. Like the auxiliary bumps 402a, the auxiliary wirings 403 and 404 are also in an electrically floating state. Due to the provision of these auxiliary wirings 403 and 404, later-described connecting wirings 429a and 429b formed by laser CV can be made short. The connecting wirings 429a and 429b are relatively time-consuming in their formation and are usually constituted by a metal higher in resistivity than aluminum, so a smaller length thereof is advantageous in decreasing the wiring resistance. In this case, the auxiliary wirings 403 are disposed between signal wirings (not shown) comprising the aluminum film of the third layer, while the auxiliary wirings 404 are disposed between power wirings (not shown) comprising the aluminum film of the fourth layer.

Fig. 4B is a sectional view of a principal portion of the bipolar LSI shown in Fig. 4A.

In the bipolar LSI of this embodiment, as shown in Fig. 4B, a buried layer 405, which is $n^+$ type for example, is provided in the surface of the semiconductor chip 401 and an epitaxial layer 406 of n-type silicon for example is formed on the chip 401. Further, a field insulating film 407 such as, for example, $SiO_2$ film is formed at predetermined portions of the epitaxial layer 406 to effect inter-element separation and intra-element separation. Below the field insulating film 407 is provided a channel stopper region 408 of say $p^+$ type. In the portion of the epitaxial layer 406 surrounded by the field insulating film 407 there are formed an intrinsic base region 409 of say p type and a graft base region 410 of say $p^+$ type, with an emitter region 411 of say $n^+$ type being formed in the intrinsic base region 409. An npn type bipolar transistor is constituted by the emitter region 411, the intrinsic base region 409 and a collector region located below the intrinsic base region 409, the collector region comprising the epitaxial layer 406 and the buried layer 405. In this embodiment, a plurality of such npn type bipolar transistors and resistors (not shown) are used to constitute such an ECL (Emitter Coupled Logic) 3-input OR gate as shown in Fig. 4C. In Fig. 4C, $V_{BB}$ is say -1.2V and Vcs is say -1.85V.

Numeral 412 denotes a collector take-out region of say $n^+$ type connected to the buried layer 405 and numeral 413 denotes an insulating film such as, for example, $SiO_2$ film contiguous to the field insulating film 407. The insulating film 413 has openings 413a to 413c in corresponding relation to the graft base region 410, emitter region 411 and collector take-out region 412, respectively. Through the opening 413a a base draw-out electrode 414 constituted by a polycrystalline silicon film is connected to the graft base region 410, while through the opening 413b there is provided a polycrystalline silicon emitter electrode 415 on the emitter region 411. Numerals 416 and 417 each denote an insulating film such as, for example, $SiO_2$ film.

Numerals 418a to 418d represent first-layer wirings each formed by an aluminum film for example. The wiring 418a is connected to the base draw-out electrode 414 through an opening 417a formed in the insulating film 417; the wiring 418b is connected to the polycrystalline silicon emitter electrode 415 through an opening 417b; and the wiring 418c is connected to the collector take-out region 412 through an opening 417c and the opening 413c. Numeral 419 denotes an inter-layer insulating film comprising, for example, an SiN film formed by plasma CV, a spin-on-glass (SOG) film and an SiO film formed by plasma CV. On the inter-layer insulating film 419 there are provided second-layer wirings 420a and 420b each formed by an aluminum film. The wiring 420a is connected to the wiring 418a through a through hole 319a formd in the inter-layer insulating film 419. Numeral 421 denotes an inter-layer insulating film like the film 419. On the inter-layer insulating film 421 are formed thrid-layer wirings 422a to 422f each constituted by an aluminum film for example. The wiring 422a is connected to the wiring 420a through a through hole 421a formed in the inter-layer insulating film 421 and the wiring 422e is connected to the wiring 420b through a through hole 421b. Further, numeral 423 denotes an inter-layer insulating film like the films 419 and 421. On the inter-layer insulating film 423 is formed a fourth-layer wiring 424 by an aluminum film for example. The wiring 424 has large width and thickness as compared with the wirings of the lower layers so as to permit a large current flow. Numeral 425 denotes a protective film comprising an SiN film by plasma CV for example and an SiO film formed in the same manner. On the protective film 425 is formed an opening 425a and, for example, a chromium (Cr) film is formed on the wiring 424 through the opening 425a. And on the Cr film 426 are formed the bumps 402 by, for example, a lead (Pb) - tin (Sn) alloy solder through say a copper (Cu) - tin (Sn) intermetallic compound 427. The auxiliary bumps 402a, also formed by a Pb-Sn alloy solder, are provided on the fourth-layer aluminum film not connected to the internal circuitry, through the Cr film 426 and the intermetallic compound layer 427.

The following description is now provided about the method of measuring a potential of a defective part in the bipolar LSI constructed as above. This potential measurement may be made in a state of either wafer or chip.

As shown in Fig. 4A, the LSI is subjected to a probe check using an LSI tester in accordance with a predetermined test program. A probe card used in this probe check is provided with probes 428 in the same number as the bumps 402 and auxiliary bumps 402a. The probe card permits the probes 428 to be raised for all of the bumps 402 and auxiliary bumps 402a. It is here assumed that as a result of having probed the LSI the internal circuitry proved to involve a defective gate and the position of a defective part became clear, which defective part is indicated by the mark "x" in Fig. 4A.

Next, by a later-described method there are formed a connecting wiring 429a by say molybdenum (Mo) which wiring connects the above defective part to the auxiliary wiring 403 located at the shortest distance from the defective part, as well as a connecting wiring 429b by say Mo which wiring connects the said auxiliary wiring 403 to an auxiliary bump 402a, whereby the defective part is connected to the defective bump 402a.

Thereafter, a probe check is made again using the LSI tester to measure a potential of the defective part.

According to this embodiment, as described above, a defective part can be measured for potential by raising the probes 428 for the auxiliary bumps 402a using the probe card; besides, in the potential measurement, the probes 428 can be raised for all the power bumps to effect the supply of electric power. Therefore, the potential of the defective part can be measured certainly and that accurately. Thus, the analysis of a defect in the LSI can be done with a high accuracy and that rapidly. By feeding the result of this analysis of a defect back to the LSI design or manufacturing process there can be attained shortening of the period required for the development of LSI.

The following description is now provided about the method of forming the aforementioned connecting wirings 429a and 429b.

As shown in Fig. 4E, a focused ion beam (FIB) of say gallium (Ga) is applied to the surface portion of the semiconductor chip 401 indicated by the mark "x" in Fig. 4A to form a through hole 430 through the fourth-layer wiring 424, thereby exposing the surface of, for example, the second-layer aluminum wiring 420c (an output wiring of the gate) of the portion to be measured for potential. The through hole 430 has a square sectional shape, for example 5 μm in side length and a depth of say 8 μm (see Fig. 4I). In Fig. 4E, numerals 418e, 418f dnd 418g denote aluminum wirings of the first layer and numerals 422a and 422h represent aluminum wirings of the third layer.

Next, as shown in Fig. 4F, the focused ion beam is again applied to a peripheral part of the through hole 430 to form a groove 431 reaching the inter-layer insulating film 423. For example, the groove 431 has a width of 2 μm and a depth of 6 μm. With the groove 431 it is possible to prevent contact of the connecting wiring 429a with the wiring 424 of the fourth layer, so it is possible to prevent short-circuit between the wirings 429a and 424.

Then, as shown in Fig. 4G, a Cr film 432 having a thickness of 200 to 300Å is formed throughout the entire surface by, for example, sputtering and thereafter a connecting wiring 429a is formed by laser CV using a reactive gas such as, for example, $Mo(CO)_6$. As the laser beam there may be used an argon laser beam for example. The aluminum wiring 420c of the second layer at the defective part and a corresponding auxiliary wiring 403 are connected together through the connecting wiring 429a (see Fig. 4A). In this case, the Cr film 432 prevents Mo from becoming difficult to be deposited due to reflection of the laser beam at the surface of the aluminum wiring during the foregoing laser CV. It also functions to improve the adhesion of the connecting wiring 429a to the substrate. In place of the Cr film 432 there may be used, for example, a gold (Au) film. Further, the connecting wiring 429a may be constituted by say tungsten (W) and in this case there may be used $W(CO)_6$ as the reaction gas in the laser CV.

Next, as shown in Fig. 4H, the lower portion of the connecting wiring 429a is removed by, for example, sputter etching and the Cr film 432 is etched off. This condition is shown in plan view in Fig. 4I.

The connecting wiring 429b can also be formed in the same manner as above.

The following is an explanation about how to repair the defective part after the potential measurement in the same part.

First, it is assumed that the presence of a defective gate in the internal circuitry of the LSI and the position of a defective part became clear as a result of a probe check made using an LSI tester in the same manner as above. The gate shown in Fig. 4C is assumed to be this defective gate.

Then, using the above laser CV technique, portions A and B in Fig. 4C are connected to auxiliary bumps 402a different from each other. In this case, in the same manner as above, first the portion A and an auxiliary wiring 403 are connected through the connecting wiring 429a, then this auxiliary wiring 403 and an auxiliary bump 402a are connected through the connecting wiring 429b. The connection between the portion B and an auxiliary bump 402a is also performed in the same way.

Then, high level (H) and low level (L) voltages are applied as input voltages Vin to the portion A by the auxiliary bump 402a, and an output voltage Vout of the portion B is measured. In both the cases of Vin = H and L, if Vout = L, there is a great possibility of disconnection of, for example, the aluminum wiring 420c which constitutes an output wiring of the gate. Therefore, a minute observation of the appearance of the LSI is made using a microscope or the like in order to find out a disconnected part. It is assumed that as a result of the observation the aluminum wiring 420c proved to be disconnected, for example at the part indicated by the mark "x".

Thereafter, the connecting wiring 429c is connected using the foregoing laser CV technique, whereby the disconnection can be repaired.

Although the invention has been described on the basis of the above embodiment, it goes without saying that the invention is not limited thereto and that various modifications may be made within the scope not departing from the gist of the invention.

For example, the number and position of the auxiliary bumps 402a can be selected as necessary, and it is not always necessary to provide the auxiliary wirings 403 and 404, which may be omitted. Moreover, in an LSI using pads, as shown in Fig. 4H, auxiliary pads 433 may be provided in addition to the power supplying and signal inputting/outputting pads 403. Further, the present invention is applicable to various other

semiconductor integrated circuit devices, e.g. MOSLSI, than bipolar LSIs.

An effect attained by a typical invention disclosed herein is that the potential measurement for the internal circuitry can be done accurately.

(5) Embodiment-5

An embodiment-5-I of the present invention will be described below with reference to Figs. 5A and 5I to 5K.

In Fig. 5I, an ion beam emitted from an ion source 501 is focused onto a sample 508 by first, second and third lens electrodes 502, 503 and 504. The beam is bent and directed to a blanking aperture 506 by applying a voltage to a blanking electrode 505 whereby the beam can be prevented from being applied to the sample 508 where required. By applying a deflecting voltage to a deflector electrode 507 the beam can be scanned in a cutting region.

The sample 508 is fixed onto a stage 509 which is driven by a drive unit (not shown). During cutting, the stage is fixed and the beam is deflected by a deflector 507.

A required voltage is supplied to this system by means of a deflector controller 510, a blanking controller 511, an accelerating power source 512 and a draw-out power source 513.

Fig. 5A shows a flow of monitoring the cutting depth in the system illustrated in Fig. 5I. A timer is operated upon start of cutting and a beam current $i_B$ is measured at every certain time $t_S$. The time $t_S$ is set to a time wherein a change in the beam current can be ignored. During monitoring of the beam current, the stage 509 is shifted from the cutting position to let the beam fall into a Faraday cup 519, as shown in Fig. 5J. During movement of the stage 509 the beam is kept under blanking, and the timer is not operated during movement of the stage 509 and measurement using the Faraday cup 519 because the cutting work is not under way. A dose amount W, a cut-away volume V and a cutting depth Z are determined according to the following equations by means of a computer 517:

$W = \Sigma\, i_B t_S$ [A·sec]

$V = k \cdot W$ [$\mu m^3$]

$Z = V/A$ [$\mu m$]

where,

k: cutting rate coefficient [$\mu m^3 A^{-1} sec^{-1}$]

A: beam scan area [$\mu m^2$]

The cutting rate coefficient k depends on the material of a sample, ion energy and ion material. In a normal cutting work, ion energy and ion material are constant, so in the case of cutting a single material, the cutting rate coefficient k may be treated as a constant. According to an experiment, when there were used an ion energy of 20 kV and gallium as an ion material, there was obtained $k_{SiO_2} = 0.28\ \mu m^3 nA^{-1} sec^{-1}$] for $SiO_2$. In the case of a sample of a multilayer structure comprising plural materials, it must be taken into account that the cutting rate coefficient differs depending on materials.

This embodiment will now be explained with reference to Fig. 5K. As shown in Fig. 5K, a material M being cut is determined on the basis of the thickness of each layer of a sample which has been measured in advance, according to the depth Z detected when the beam current $i_B$ was monitored. Then, the present cut-away volume V is determined by adding a cut-away volume increment $\Delta V$ to the out away volume obtained in the previous measurement of beam current:

$\Delta V = k i_B t_S$ [$\mu m^3$]

$(k = k_M)$

The present depth Z is obtained by dividing the cut-away volume V by a beam scan area A:

$Z = V/A$ [$\mu m$]

When this depth Z reaches a target depth $Z_o$, the cutting is stopped.

Since in this embodiment-5-I the stage 509 is moved at every sampling time $t_S$, the cutting time is so much wasted. As a solution to this problem, an embodiment-5-II will be described below with reference to Figs. 5L to 5N.

In Fig. 5L, an ammeter 514 is for measuring a source current $i_S$ flowing through the first lens electrode 502. The beam current $i_B$ is represented as a function of the source current $i_S$ as shown in Fig. 5M:

$i_B = f(i_S)$

This is measured in advance and stored in a computer 517. As to this function, usually a sufficient accuracy is obtained in terms of the following linear function:

$i_B = \alpha i_S + \beta$

Since the ammeter 514 floats to a degree corresponding to the acceleration voltage relative to the earth, a measured analog value is converted to a digital value by means of an A/D converter 515, followed by coupling by an optical isolator 516, and then fed to the computer 517. A flow of this embodiment-5-II can be expressed by measuring the source current $i_S$ and calculating the beam current $i_B = f(i_S)$ from the measured value, in place of measuring the beam current $i_B$ in the flowchart of Fig. 5A or 5K.

Fig. 5N shows the results of an experiment conducted according to this embodiment. In this experiment, since the cutting rate is about 0.3 $\mu m^3$/S and the cut-away hole is 5 $\mu m^2$, the time required for obtaining a cutting depth of 8 $\mu$m is about 11 minutes. Even during this period the beam current is drifting, so according to the prior art which controls the cutting time on the basis of a beam current value at the start of cutting, the

deviation of the cutting depth from the target depth is ±1 μm.

On the other hand, when the source current $i_S$ was measured at a sampling time of 20 seconds according to the method of the present invention, the cutting depth deviation decreased to ±0.25μm. The thickness of a wiring layer and that of an inter-layer insulating film in a common LSI are both 1 μm or so and therefore a sufficient accuracy can be attained by the present invention.

An embodiment-5-III of the invention will now be described with reference to Figs. 5O and 5P. In Fig. 5O, an ammeter 518 is for measuring an aperture current $i_A$ flowing into the third electrode (beam limiting aperture) 504. Since the beam current $i_B$ can be expressed as a function of the aperture current $i_A$:

$i_B = g(i_A)$

the cutting depth can be monitored in the same manner as in the embodiment-5-II. This function can also be expressed with a high accuracy in terms of the following linear function:

$i_B = \alpha i_A + \beta$

The current $i_S$ flowing in the ion sofurce 501 shown in Fig. 5L can also be measured at portion A. Where the electrode 502 is in an enclosing shape from above as in Fig. 5L, the formation of secondary electrons by ion radiation is suppressed, so the source current can be measured accurately even in the position of the ammeter 514. But where the electrode 502 is in the shape of a plate, secondary electrons are developed by ion radiation, so that the ammeter 514 will measure a larger current than the ion current which has entered the meter. In this case, it is desirable that the ammeter be placed in portion A of Fig. 5L.

Further, an embodiment-5-IV will now be described with reference to Fig. 5Q. Like Fig. 5L, a source current $i_S$ is measured, then passes through the A/D converter, optical isolator 516 and D/A converter 526 to obtain an analog signal $i_S$ of an earth level. This analog signal is fed to an adder-multiplier 527, which in turn outputs a beam current value $i_B$. The beam current thus obtained passes through a multiplier 528 and an integrator 529 to obtain a cut-away volume V. The volume V thus obtained is divided by a beam scan area A in a multiplier 530 to obtain a depth Z, which is dispiayed on a diaplay unit 531.

Further, the depth Z is compared with a target depth $Z_o$ by a comparator 532, which outputs cutting end signal when $Z \geqq Z_o$. With this signal, the blanking controller 511 operates to blank the beam for termination of the cutting work.

According to this invention, even when cutting is performed over a period of time wherein a change in beam current is not negligible, the cutting depth can be monitored on the basis of current values measured at very short time intervals, so it is possible to form a hole with a high depth accuracy.

(6) Embodiment-6

Fig. 6A is a plan view of various wirings extending on a region with logical gates constituted thereon of a semiconductor substrate; Fig. 6B is a plan view of a crossing portion of a lower auxiliary wiring and an overlying auxiliary wiring; Fig. 6C is a sectional view taken on line A-A of Fig. 6B. In Figs. 6A and 6B there are not illustrated other insulating films than field insulating film in order to make the layout of wiring easy to understand.

In Fig. 6A, the marks $G_1$, $G_2$, $G_3$, $G_4$ and $G_n$ represent logical gates, which are each constituted in this embodiment by a bipolar transistor formed on a semiconductor substrate 601 comprising a $p^-$ type single crystal silicon, though not shown. The bipolar transistors are separated from each other by means of a field insulating film 602.

Above the logical gates G there extend from above to below (a first direction) a plurality of signal lines 605, circuit earth potential Vss lines 605 and supply potential Vcc lines 605, comprising a second-layer aluminum film. The first-layer aluminum film is used as an electrode connecting to the base and collector of each bipolar transistor.

As to the lines 605, their layout and to which logical gates G they are to be connected, are decided at the time of designing wiring for a logical IC. If there is no change of logic or change of layout of the basic gate for implementing the logic, there will be made no correction for the connection. Therefore, the lines 605 will hereinafter be referred to as "normal lines".

In a direction (a second direction) intersecting the normal lines 605 there extend signal lines 606, circuit earth potential Vss lines 606 and supply potential Vcc lines 606. Like the normal wirings 605, the layout of the lines 606 is made at the time of wiring design, so the lines 606 will hereinafter be referred to as "normal lines".

Auxiliary lines 605A comprising the same layer of aluminum film as the normal lines 605, namely, the second-layer aluminum film, extend in parallel with the normal lines 605. The auxiliary lines 605A are disposed one for several of the normal lines 605. Further, auxiliary lines 606A comprising the same layer of aluminum film as the normal lines 606 extend in parallel with the normal lines 606. The auxiliary lines 606A are disposed one for several of the normal lines 606.

The construction of each crossing portion (the portion of CR surrounded with dotted line) of an auxiliary line 605A of a lower layer and an auxiliary line 606A of an upper layer is as shown in Figs. 6B and 6C. As illustrated therein, the auxiliary line 605A is divided in three at the portion where it intersects the auxiliary line 606A. The auxiliary line 605A located above the auxiliary line 606A and the auxiliary line 605A just under the auxiliary line 606A are connected through an electrocondutive layer 606B. Numeral 608 denotes a connection hole for the connection of the electroconductive layer 606B with the auxiliary line 605A. The auxiliary line 605A located below the auxiliary line 606A and the auxiliary line 605A just under the auxiliary line 606A are connected together by the electroconductive layer 606B through the connection hole 608.

The sectional structure shown in Fig. 6C will now be explained. Numeral 603 denotes an insulating film which is a silicon oxide film formed by CV for example. Though not shown, the insulating film 603 covers an electrode comprising a polycrystalline silicon film connected to the emitter of each bipolar transistor. Numeral 604 denotes an insulating film which is a silicon oxide film formed by CV for example. The insulating film 604 covers an electrode comprising the first-layer aluminum film connected to the base and collector of the bipolar transistor. Above the insulating film 604 there extend the normal lines 605 and auxiliary lines 605A of the lower layer. The normal lines 605 and auxiliary lines 605A of the lower layer are insulated from the normal lines 606 and auxiliary lines 606A of the upper layer as well as the electroconductive layer 606B through an insulating film 607 which is a phospho-silicate glass (PSG) formed by CV for example. The normal lines 606 and auxiliary lines 606A of the upper layer as well as the electroconductive layer 606B are covered with a protective film 609 comprising a silicon nitride film and a PSG film formed by CV for example.

The following description is now provided about how to correct connection between logical gates G in this embodiment.

Fig. 6D is a plan view of the same portion as Fig. 6A for explaining correction of connection between logical gates.

In Fig. 6A the logical gates $G_1$ and $G_2$ are connected through a normal line (signal line) 605 of the lower layer. But, it is here assumed that according to the results of simulation the logical gate $G_1$ must be connected not to the logical gate $G_2$ but to the logical gate $G_3$.

So, in this embodiment, first an aluminum line (indicated by solid line, not marked) of the second layer which connects the logical gate $G_1$ with the signal line 605 is cut at point K surrounded with dotted line. This is done by partially opening the protective film 609 and the third-layer insulating film 607 (see Fig. 6C) utilizing a sputter effect which is obtained when, for example, gallium ion ($Ga^+$) is accelerated by an electric field, and further by etching the second-layer aluminum film. As a result, the logical gates $G_1$ and $G_2$ are electrically separated from each other. Next, a connection hole 610 is formed in a position $H_1$ on the auxiliary line 606A extending near the logical gate $G_1$, by etching the protective film 609 with a microion beam, as shown in Fig. 6E. The auxiliary line 605A is exposed from the connection hole 610. Likewise, a connection hole 610 is formed to expose the auxiliary line 605A in a position $H_2$ on an auxiliary line 605A extending near the logical gate G3, by etching the protective film 609 and the insulating film 607, as shown in Fig. 6F. Further, in the crossing portions indicated by CR out of the crossing portions of auxiliary lines 605A and 606A in Fig. 6D, a connection 610 is formed by etching the protective film 609 and the insulating film 607, as shown in Figs. 6G and 6H, Fig. 6H being a sectional view taken on line A-A of Fig. 6G.

Next, at the portion shown in Fig. 6E, a correction line 611 comprising a molybdenum (Mo) film for example is formed from the upper surface of the auxiliary line 606A exposed from the connection hole 610, to the upper surface of the protective film 609, as shown in Fig. 6I. In forming the correction line 611, the wafer (the semiconductor substrate 601) is placed, for example, in an $Mo(CO)_6$ gas atmosphere and laser La is applied to the portion where the correction line 611 is to be formed, resulting in that there occurs reaction of the above gas in the radiated portion of the laser La, allowing molybdenum (Mo) film to be deposited. Thus, by movement under radiation of the laser La there can be formed a correction line 611 (selective CV). The correction line 611 is formed so that the upper surface exposed from the connection hole 610 of the auxiliary line 606A is connected with the logical gate $G_1$, as shown in Fig. 6M. The reaction of $Mo(CO)_6$ gas in forming the correction line 611 is represented by the following formula (1):

(1) $Mo(CO)_6 \rightarrow 6CO + Mo$

As the correction line 611 there may be used a tungsten (W) film. In this case, the wafer (semiconductor substrate 601) is placed in a $W(CO)_6$ atmosphere and laser La is radiated, thereby allowing reaction to take place, which reaction is represented by the following formula (2):

(2) $W(CO)_6 \rightarrow 6CO + W$

Then, as shown in Fig. 6J, a correction line 611 is formed at the portion shown in Fig. 6F in the same manner as above. This correction line 611 is formed so that the upper surface exposed from the connection hole 610 of the preliminary line 605A shown in Fig. 6J is connected with the logical gate G3 as shown in Fig. 6M.

Next, as shown in Figs. 6K and 6L, a correction line 611 is formed at a crossing portion of lower- and upper-layer auxiliary lines 605A and 606A so that the upper surface exposed from the connection hole 610 of the auxiliary line 606A is connected with the upper surface exposed from the connection hole 610 of the electroconductive layer 606B. The correction line 611 for connecting the lower- and upper-layer auxiliary lines 605A and 606A is formed in the portion CR surrounded with dotted line.

In this way the logical gates $G_1$ and $G_3$ are connected through the auxiliary lines 605A, 606A and the correction line 611.

Fig. 6N shows connection between the logical gates $G_1$ and $G_3$ in an equivalent manner using a solid line.

According to this embodiment there can be obtained the following effects.

(1) Since the lower auxiliary line 605A is provided with the electroconductive layer 606B of the same layer as the upper auxiliary line 606A, the connection hole 610 on the auxiliary line 605A can be made shallow. This means that the breaking of the correction line 611 in the connection hole 610 can be eliminated because the hole 610 is formed in a tapered shape wherein the deeper, the narrower. Consequently, the connection between the auxiliary lines 605A and 606A can be made more reliable, that is, the yield can be improved.

(2) In the presence of the auxiliary lines 605A and 606A the correction line 611 formed by selective CV

can be shortened. Consequently, the time required for forming the correction line 611 by selective CV can be shortened and hence it is possible to shorten the time required for the correction of logic.

(3) As a result of the above (2), the correction line 611 comprising a high-melting metal film such as Mo or W film can be shortened, and since almost all portions of the logical gates $G_1$ and $G_3$ are connected through auxiliary lines 605A and 606A each comprising an aluminum film of small resistance, the operating speed between the logical gates $G_1$ and $G_2$ Can be set at the same as the operating speed of the other logical gates not corrected in their connection. In other words, it is possible to enhance the reliability of logical correction.

(4) The freedom of connection between the logical gates G and the auxiliary lines 605A or 606A can be enhanced because the connection between an auxiliary line 605a and the logical gate $G_3$ and that between an auxiliary line 606A and the logical gate $G_1$ are performed at any desired points on the auxiliary line 605A or 606A through the correction line 611 formed by selective CV and also because the correction line 611 is formed on the protective film 609 of the top layer.

In Fig. 6K, the electroconductive layer 606B located above the auxiliary line 606A may be cut using a microion beam, whereby the upper and lower auxiliary lines 605a can be separated from each other. Although the upper auxiliary line 605a is not used for logical correction, it may be used for correcting the connection between other logical gates.

As shown in Fig. 6L, moreover, the auxiliary line 605A located just under the auxiliary line 606A and each auxiliary line 605A spaced from the auxiliary line 606A are separated at a lower portion A of the electroconductive layer 606B. The auxiliary lines 605A may together intersect the auxiliary line 606A without separation into plural portions. In this case, there may be provided only one connecting hole 608 for connection between the electroconductive layer 606B and the auxiliary line 605A.

As mentioned above, the auxiliary line 605A is separated at the lower portion of the electroconductive layer 606B and thus the separation of an unnecessary auxiliary line 605a can be done at the overlying electroconductive layer 606B.

Although in this embodiment the auxiliary lines 605A and 606a comprising an aluminum film are provided to correct the connection of the lines 605 and 606, the logical gates $G_1$ and $G_2$ may be connected by only the correction line 611 formed by selective CV without provision of the auxiliary lines 605A and 606A. In this case, the correction line 611 formed by CV can extend at any desired pattern on the protective film 609 of the top layer, so the freedom of correction wiring for logical correction is extremely high.

The present invention has concretely been described on the basis of the above embodiment, but is goes without saying that the invention is not limited thereto and that various modifications may be made within the scope not departing the gist thereof.

For example, this embodiment is applicable not only to a logical correction for a logical IC but also to the correction of wiring on a printed circuit board.

The following is a brief description of an effect obtained by a typical invention disclosed herein. Since an electroconductive layer of the same layer as an upper-layer auxiliary line is provided on a lower-layer auxiliary line, a connection hole can be formed in the latter shallowly and hence the connection between the lower- and upper-layer auxiliary lines can be done positively.

As set forth above, the present invention relates to a wiring technique and is particularly effective in its application to a technique for correcting the connection between wirings.

The following description is now provided about the usefulness of the invention. In the development stage of a logical IC used in a computer, there is often made a change of its logical construction. This is performed by changing the wiring pattern of the aluminum wiring which connects between logical gates.

However, if the change of logic is made by changing the wiring pattern, it will take two weeks or so to complete the IC. In view of this point it has been proposed by the present inventors to provide an auxiliary line beforehand between logical gate connecting lines and correct the connection using the said auxiliary line.

Having studied the above technique, the present inventors found out the following problem.

Like a normal wiring whose layout is for connection between logical gates at the time of logical design, an auxiliary wiring comprises an aluminum film of a lower layer, e.g. the first layer, and an aluminum film of an upper layer, e.g. the second layer. Therefore, for connection between the lower- and upper-layer auxiliary lines it is necessary to form a deep connection hole by removing from the protective film of the top layer to the insulating film which covers the auxiliary line of the lower layer. Due to such a deep connection hole, the electroconductive layer which connects the lower- and upper-layer auxiliary lines deteriorates in its reliability of connection.

On the other hand, the present inventors found that the connection hole for the connection of a correction line could be made shallow by providing an electroconductive layer of the same layer as an upper-layer auxiliary line on a lower-layer auxiliary line in the vicinity of a crossing portion of both auxiliary lines and connecting the electroconductive layer to the lower-layer auxiliary line and that therefore the reliability of wiring correction could be improved.

(7) Emboiment-7

An embodiment-7-I of the invention will now be described. Usually, a power line is disposed on an aluminum wiring of the top layer (e.g. the fourth layer) of an LSI. The power line has a large width as compared with a signal line of a lower layer in order to supply an electric power stably. So even if it is partially separated, the

operation of the LSI will be scarcely influenced. Therefore, as shown in Fig. 7A, a part of a top-layer wiring 718 is notched using an FIB (focused ion beam).

Then, windows 709 are formed in two positions of the top-layer wiring. The portion of such a shape is formed at every position where CV (laser CV lines 705 are crossed.

Next, in a CV (laser CV) wiring process there is formed a wiring as in Fig. 7A, whereby the CV lines 705 are prevented from being short-circuited.

The above is an example of using the wide wiring 718 of the top layer, but if the LSI wiring of any other layer is cut and then window-formed as in Fig. 7B, this portion can be utilized as a crossing point of laser CV lines.

Another embodiment-7-II of the invention will now be described. In the previous embodiment, the existing LSI wiring is cut off, window-formed and used as a crossing point of CV lines. However, the separation of the LSI wiring is time-consuming; besides, in the cut-away part, e.g. a notch, the LSI wiring layer is exposed, so the laser CV wiring must be laid while avoiding that portion, resulting in that the wiring forming path becomes complicated. In this embodiment, therefore, an initially isolated island region is incorporated on the ISI.

More specifically, for crossing the laser CV lines 705, windows are formed at both ends of an island region 711 and a laser CV line 705 is connected thereinto. Then, another CV line 705 is laid in an overhead crossing fashion to pass therebetween. By so doing, the separation time can be saved and it is no longer necessary to bend wiring.

An embodiment-7-III of the invention will now be described. In the above embodiment-II there was used laser or FIB for forming windows, while in this embodiment there is fabricated an LSI in an initially-bored (completed) state of windows to save the window forming time.

Fig. 7D shows a structure of crossing point of laser selective CV lines utilizing a bonding pad for a bump electrode. As shown in the embodiment-4, the metal exposed to the bonding pad is aluminum. Aluminum is oxidized easily, with an alumina layer 712 formed on the surface. In this state, even if laser CV lines 705 are attached thereto, the contact resistance is too high. Therefore, where a crossing utilizing this pad is used, it is necessary to either let alumina fly off by sputter-etching the aluminum surface of the pad just before the formation of laser CV lines, or subject the exposed aluminum surface of the pad portion to a light sputtering treatment at the end of cutting or perforating step using FIB and passing to the next laser CV line forming step without breaking vacuum.

Where the aluminum pad is exposed as above, cleaning of the surface is absolutely necessary. If the aluminum pad surface is coated with a noble metal such as gold, platinum or palladium, such cleaning becomes unnecessary. Fig. 7E shows a structure of a crossing pad having such a coating. In Fig. 7E, a gold (Au) film is formed on an aluminum pad portion 702 of an LSI wiring through a substrate barrier metal 713 comprising a Cr-Cu Au alloy of a lower layer and a Pb-Sn alloy of an upper layer. A crossing can be realized effectively by using the corssing pad shown in Figs. 7D and 7E in the same manner as in Fig. 7B.

As shown in Fig. 7F, if an end portion of a long power line is cut off and a plurality of perforated structures 715 are disposed along the line, it is easy to realize a crossing of many lines and even a long-distance connection can be effected using short CV lines 705. If necessary, the aluminum wiring of the above structure can be cut off with laser or FIB and used. The right-hand structure of Fig. 7F shows this example, wherein the central part is separated and utilized for the crossing of lines separately up and down.

(8) Embodiment

The following is an explanation of an example wherein the above (1) to (7), namely, the embodiments 1 to 7, are applied to a GaAs.

First, a manufacturing method for a GaAs will be described below with reference to Figs. 8A to 8R.

As shown in Fig. 8A, a semi-hermetic GaAs substrate 801 (generally disc-like) is prepared by slicing a 3-inch GaAu ingot which has been drawn up by an LEC (liquid Encapsulated Czochralski) method, into an approximately 700 μm thickness, and an $SiO_2$ film of about 500 Å is formed on the surface thereof by CV (Chemical Vapor Deposition).

Next, as shown in Fig. 8B, a photo resist 803 having a thickness of 1 to several μm (spin application) is patterned to cover the other portion than a predetermined active element region by photolithography. To form an N-type channel with this resist as a mask, Si (silicon) is dosed by ion implantation (2 x $10^{12}/cm^2$, 75 Kev) and thus there is formed an $N^-$ channel 804. Further, using the same mask, Mg (magnesium) is dosed by ion implantation (1 x $10^{13}/cm^2$, 200 Kev) to form a P-well region 805.

Then, as shown in Fig. 8C, the resist film 803 is removed by $O_2$ asher and ozonized sulfuric acid (sulfuric acid whose oxidation effect is enhanced by bubbling of ozone) and thereafter the $SiO_2$ film 802 is etched for about 60 - 120 seconds using a mixed solution ($HF : H_2O = 1 : 100$) of HF and $H_2O$ to remove its surface a little. Then, by CV there is formed and $SiO_2$ film 806 having a thickness of 2,000Å in combination with the previous $SiO_2$ film 802. In this state, annealing is made in an $H_2$ (hydrogen) atomosphere at 800°C for 13 to 20 minutes to activate the ion implantation region.

Next, as shown in Fig. 8D, the $SiO_2$ film 806 is removed throughout the whole surface thereof (using hydrofluoric acid), and while the surface is clean, $WSi_x$, i.e. tungsten silicide, 807 ($x = 0.4 \sim 0.5$) of 3,000 Å or so is formed on the entire surface by sputtering.

Then, as shown in Fig. 8E, using as a mask a photo resist 809 which has been patterned by photolithography, a Schottky gate 808 is patterned by reactive ion etching (RIE).

Next, as shown in Fig. 8F, the resist 809 is removed and an $SiO_2$ film 810 having a thickness of 500 Å is

formed on the whole surface by plasma CV (P-CVD).

Then, as shown in Fig. 8G, a photo resist film 811 having a thickness of 1 to several µm is formed on the other portion than the active region by photolithography. Using this resist film and the gate 808 as a mask, Si as an N-type impurity corresponding to a light region of LDD (Lightly Doped Drain) is doped by ion implantation (3 ~ 5 x $10^{12}/cm^2$, 75 Kev) to form an N region 812.

Next, as shown in Fig. 8H, the resist film 811 is removed throughout the whole surface thereof and thereafter a P-$SiO_2$ film 813 ($SiO_2$ film formed by plasma CV) is formed on the entire surface at a thickness of about 3,000 Å in combination with the previous $SiO_2$ film.

Then, as shown in Fig. 8I, the P-$SiO_2$ film 813 is subjected to anisotropic etching by RIE, leaving thick side walls 816 comprising P-$SiO_2$ on both sides of the gate and P-$SiO_2$ of about 1,000 Å on the whole surface. At this time, a photo resist film 815 having a thickness of 1 to several µm is patterned by photolithography to cover the whole surface of the other portion than the active region. Using the gate 808, side walls 816 and resist film 815 as a mask, Si for forming an $N^+$ region deeper than the shallow region 812 of the LDD type source-drain is doped by ion implantation (2~ 5 x $10^{13}/cm^2$, 100 Kev) to form an $N^+$ region 814.

Next, as shown in Fig. 8J, the resist film 815 is removed throughout the entire surface thereof and an $SiO_2$ film 818 is formed by CV at a thickness of about 3,000 Å in combination with the previous $SiO_2$ film 817. At this time, annealing is performed in an $H_2$ atmosphere (800° C, 10 to 20 minutes) to activate the N region 812 and the $N^+$ region 814.

Then, as shown in Fig. 8K, a contact metal layer is formed by a lift-off method. More specifically, a photo resist film 819 having a thickness of 1 to several µm is patterned by photolithography.

Next, as shown in Fig. 8L, contact holes 820 are formed in the $SiO_2$ film 818 by dry etching, using the resist film 819 as a mask.

Then, as shown in Fig. 8M, a contact metal layer 821 is formed maltilayerwise on the whole surface by sputtering. This multilayer film comprises, successively from lower to upper layers, an AuGe film of 400 to 800 Å, a W (tungsten) film of 80 to 150 Å, an Ni (nickel) film of 80 to 150 Å and an Au (gold) film of 1,200 to 1,500 Å.

Next, as shown in Fig. 8N, only the contact metal layer 821 of the contact portion is allowed to remain by light-off of the resist film 819.

Then, as shown in Fig. 80, a first inter-layer insulating film 822 is formed on the whole surface and through holes are formed by RIE using $CHF_3$ gas. Subsequently, multilayer metal films 823 and 824 as a first wiring layers (WR-1) are formed by sputtering or vapor deposition and patterned by dry etching. The insulating film (IL-1) 822 comprises, successively from lower to upper layers, P-$SiO_2$ 500 - 1,500 Å, SOG (Spin-On-Glass) 1,000 - 2,000 Å and P-$SiO_2$ 2,000 - 5,000 Å. On the other hand, the multilayer metal film, i.e. WR-1, comprises Mo (molybdenum) 1,000 - 1,500 Å, Au (gold) 3,000 - 5,000 Å and Mo (molybdenum) 500 - 1,000 Å successively from lower to upper layers.

Next, as shown in Fig. 8P, a second inter-layer insulating film 826 is formed on the whole surface. This insulating film comprises a P-$SiO_2$ film of 500 to 1,500 Å, an SOG film of 2,000 to 3,000 Å and a P-$SiO_2$ film of 3,000 to 5,000 Å successively from lower to upper films. Further, through holes are formed in predetermined portions of the film IL-2. Then, an $Si_3N_4$ film 827 (P-SiN film) of 300 to 600 Å as a barrier member for the through hole portions is formed on the whole surface by plasma deposition and only the through hole is covered with a photo resist, while the P-SiN barrier of the other portion is removed. Further, a second wiring layer 828 or WR-2 is formed on the whole surface and patterned like the previous WR-1. The WR-2 film comprises Mo (molybdenum) of 1,000 to 2,000 Å, Au (gold) of 6,000 to 9,000 Å and Mo (molybdenum) of 300 to 600 Å successively from lower to upper layers.

Then, as shown in Fig. 8Q, a third inter-layer insulating film 829 or IL-3 is formed on the whole surface and through holes are formed in the same manner as above, then a barrier layer is patterned (not shown). The IL-3 comprises P-$SiO_2$ of 500 to 1,000 Å, SOG of 2,000 to 3,000 Å and, P-$SiO_2$ of 3,000 to 4,000 Å successively from lower to upper layers. Further, a third wiring layer 830 or WR-3 is formed on the whole surface by sputtering. The WR-3 comprises Mo (molybdenum) of 1,500 Å, Au (gold) of 8,000 Å and Mo (molybdenum) of 500 Å successively from lower to upper layers. Further, the WR-3 is patterned like 830 in the same manner as above. Then, a fourth inter-layer insulating film 831 or IL 4 is formed on the whole surface and through holes are formed in the same way as above. The IL-4 comprises films of P-$SiO_2$ of 1,000 Å, SOG of 3,000 Å and P-$SiO_2$ of 4,000 Å successively from lower to upper layers. An SiN barrier (not shown) is applied to the interior of each through hole in the same manner as above and a fourth wiring layers 832 or WR-4 is formed on the whole surface by sputtering. The WR-4 comprises Mo (molybdenum) of 1,500 Å, Au (gold) of 8,000 Å and Mo (molybdenum) of 500 Å successively from lower to upper layers. Further, a final passivation film 833 having a thickness of 1.2 µm is formed on the whole surface. The final passivation film 833 comprises, from lower to upper layers, a 1 µm thick PSG (Phospho-Silicate Glass) formed by CV at a low temperature of 350° C or so and at an atmospheric pressure and a 0.2 mµ thick P-SiN (Plasma $Si_3N_4$ film) or silicon nitride film formed by plasma CV, successively from lower to upper layers. Further, bonding pad portions 834 are formed. In this state, probes are put on these bonding pads and each chip is checked for electrical characteristics and quality by means of a prober.

Next, as shown in Fig. 8R, the GaAs on the back of the wafer 801 is removed about 100 µm by chemical etching using an $NH_3$-based etching solution, then an AuGe layer (gold-germanium alloy layer) 835 of about 500 Å is formed by sputtering and thereafter an Au (gold) film 836 of about 1 µm is formed by vapor deposition or plating, followed by alloying treatment. Further, the wafer is divided into chips by dicing.

Then, as shown in Fig. 8S, a metallized pattern for die pad is formed centrally on the upper surface of a package substrate 837 comprising alumina- ceramics (by screen printing and plating). This metallized layer comprises a W (tungsten) film 838, an Ni (nickel) film 839 and an Au (gold) film 840 successively from lower to upper layers. In this state, each chip 801 is placed on the die pad through an Au-Sn (gold-tin) foil 841 of about the same size as the chip and die bonding is performed by Au-Sn eutectic. In this state, each device is stocked and the following circuit correction is made if necessary. The correction is performed using the FIB system and technique exemplified above as well as the system to be shown in a later-described embodiment-9. First, through holes 842 and 843 are formed using FIB in a final passivation film and IL-4 thereunder on a portion 832a of WR-4 and a portion 830a of WR-3.

Next, as shown in Fig. 8T, an Mo (molybdenum) wiring 844 is formed selectively by laser CV so as to connect the through holes 842 and 843 with each other. More particularly, a Cr (chromium) film is formed below the Mo film to improve adhesion, though not shown.

Then, as shown in Fig. 8U, each bonding pad on the chip and each metallized lead provided at a part of the ceramic package 837 are connected together by ball wedge bonding using an Au (gold) wire about 30 μm in diameter.

The layout of component circuits on the chip as well as the arrangement and how to use of the correction system, auxiliary lines and auxiliary gates in this embodiment are almost the same as in the other embodiments described above, so will not be explained here.

(9) Embodiment-9

Like the other embodiments, this embodiment constitutes a part of the invention concerning the technique of an IC manufacturing process using FIB. Inevitably, this embodiment premises application of the FIB systems of Embodiments 1 and 5 as well as the techniques shown in the other embodiments. But there may be used any other system or technique and object of application. In this embodiment, the foregoing embodiments 1 to 8 are synthesized into a single system for IC design, correction and manufacture. Since the invention is applicable substantially directly in conformity with the characteristics of the preceding embodiments, repeated explanations will be omitted. For example, as to the GaAs of the embodiment-8, the system of the invention is applicable as necessary on the basis of the foregoing illustrative descriptions and the descriptions of the other embodiments, including this embodiment. So detailed explanations will be omitted.

The whole of an LSI and a manufacturing process according to this embodiment will be described below.

Fig. 9A is a sectional view showing a principal portion of a bipolar LSI according to an embodiment-9 of the invention.

In the bipolar LSI of this embodiment, as shown in Fig. 9A, a buried layer 902 of say $n^+$ type is provided in the surface of a semiconductor chip (substrate) 901 comprising p-type silicon for example, and an epitaxial layer 903 of say n-type silicon is formed on the semiconductor chip. Further, a field insulating film 904, e.g. $SiO_2$ film, is provided at a predetermined portion of the epitaxial layer 903, whereby there are effected inter- and intra-element separtion. Below the field insulating film 904 is formed a channel stopper region 905 of say $p^+$ type. In the portion of the epitaxial layer 903 surrounded by the field insulating film 904 there are formed an intrinsic base region 906 of say p type and a graft base region 907 of say $p^+$ type, and an emitter rgion 908 of say $n^+$ type is provided in the intrinsic base region 906. An npn-type bipolar transistor is constituted by the emitter region 908, the intrinsic base region 906 and a collector region located below the intrinsic base region and comprising the eptaxial layer 903 and the buried layer 902. Numeral 909 denotes a collector take-out region of say $n^+$ type connected with the buried layer 902. Numeral 910 denotes an insulating film, e.g. $SiO_2$ film, which is contiguous to the field insulating film 904. The insulating film 910 is formed with openings 910a to 910c in corresponding relation to the graft base region 907, emitter region 908 and collector take-out region 909. A base draw-out electrode 911 comprising a polycrystalline silicon film is connected to the graft base region 907 through the opening 910a, while a polycrystalline silicon emitter electrode 912 is provided on the emitter region 908 through the opening 910b. Numerals 913 and 914 represent insulating films such as $SiO_2$ films for example.

Numerals 915a to 915c each denote a first-layer wiring constituted by an aluminum film for example. The wiring 915a is connected to the base draw- out electrode 911 through an opening 914a formed in the insulating film 914; the wiring 915b is connected to the polycrystalline silicon emitter electrode 912 through an opening 914b; and the wiring 915c is connected to the collector take-out region 909 through an opening 914c and the opening 910c. Numeral 916 denotes an inter-layer insulating film comprising an SiN film formed by plasma CV for example, a spin-on-glass (SOG) film and an SiO film formed by plasma CV. On the inter-layer insulating film 916 is provided a second-layer wiring 917 constituted by an aluminum film for example. The wiring 917 is connected to the wiring 915c through a through hole 916a formed in the inter-layer insulating film 916. The through hole 916a has a stepped shape to thereby improve the step coverage of the wiring 917 in the through hole 916a. Numeral 918 denotes an inter-layer insulating film similar to the inter-layer insulating film 916. Provided on the inter-layer insulating film 918 are third-layer wirings 919a to 919c each constituted by an aluminum film for example. The wiring 919a is connected to the wiring 917 through a through hole 918a formed in the inter-layer insulating film 918. Further, numeral 920 denotes an inter-layer insulating film similar to the inter-layer insulating films 916 and 918. Provided on the inter-layer insulating film 920 are fourth-layer wirings 921a to 921c each constituted by an aluminum film for example. The wirings 921a to 921c are formed thicker than the lower-layer wirings so as to handle large amounts of current. For example, they have a thickness of 2 μm. The grooves formed among the wirings 921a - 921c are 2 μm in thickness for example and hence the

aspect ratio (depth to width) of the grooves is a large value, say, 1.

Numeral 922 denotes an insulating film for surface levelling such as, for example, an $SiO_2$ film, which is formed by bias sputtering of $SiO_2$ or by a combination of plasma CV and sputter etching. The grooves among the wirings 921a - 921c are completely filled up by the insulating film 922, so the surface of the film 922 is substantially flat. As the insulating film 922 there may be used a silicate glass film such as a PSG (phospho-silicate glass) film, a BSG (boro-silicate glass) film or a BPSG (boro-phospho-silicate) glass formed by, for example, a combination of atmospheric CV and sputter etching. On the insulating film 922 is provided an SiN film 923 formed by plasma CV for example. As well known, the SiN film 923 is moistureproof. In this case, the surface of the insulating film 922, including the groove portions among the wirings 921 - 921c, is flat, so the surface of the SiN film 923 is also flat. Consequently, the thickness and quality of the SiN film 923 are uniform and hence the moistureproofness of a later-described protective film 925 can be improved as compared with the prior art. As a result, a non-hermetic seal type package can be used as an LSI package. Provided on the SiN film is an SiO film 924 formed by plasma CV for example. A chip protecting film 925 is constituted by the insulating film 922, the SiN film 923 and the SiO film 924. The SiO film functions to not only ensure the adhesion of a later-described chromium (Cr) film 926 to the protective film 925 but also prevent the SiN film 923 from being etched during dry etching of the Cr film 926.

An opening 925a is formed in the protective film 925 and the Cr film 926 provided on the wiring 921b through the opening 925a. Further, solder bumps 928 of a lead (Pb) - tin (Sn) alloy are provided on the Cr film 926 through a copper (Cu) - tin (Sn) intermetallic compound layer 927.

Fig. 9B is a sectional view showing a pin grid array (PGA) type package sealing the bipolar LSI.

In this pin grip array type package, as shown in Fig. 9B, the semiconductor chip 901 is connected, using the solder bumps 928, onto a chip carrier 929 constituted by mullite ($3Al_2O_3 \cdot 2SiO_2$) for example. Numeral 930 denotes a cap constituted by silicon carbide for example. The back (element-free face) of the semiconductor chip 901 is in contact with the cap 930 through a solder material 931 for example, whereby heat dissipation from the semiconductor chip 901 to the cap 930 can be done effectively. In the case of mounting this package onto a module substrate or the like, radiation fins (not shown) are brought into contact with the cap 930 to effect the radiation of heat from the package effectively. Numeral 932 denotes a resin, e.g. epoxy resin, whereby the semiconductor chip 901 is sealed. This package is a non-hermetic seal type package. Since the protective film 925 is superior in moistureproofness as previously noted, it is possible to use such a non-hermetic seal type package, whereby the reduction in cost of the package can be attained. The elements indicated by the reference numeral 933 are input-output pins which are connected to the solder bumps 928 through a multilayer interconnection (not shown) formed on the chip carrier 929.

The manufacturing method for the bipolar LSI shown in Fig. 9A will now be described. Explanation about the steps up to formation of the interlayer insulating film 920 will be omitted.

As shown in Fig. 9C, after formation of the wirings 921a to 921c on the inter-layer insulating film 920, an insulating film 922, e.g. $SiO_2$ film, is formed by, for example, bias sputtering of $SiO_2$ or a combination of plasma CV and sputter etching. As previously noted, the surface of the insulating film 922 can be made substantially flat. If the depth and width of the grooves among the wirings 921a - 921c are each 2 μm, a substantially flat surface is obtained at a thickness of the insulating film 922 of say 3.5 μm or so in the case of forming the same film by bias sputtering of $SiO_2$. Where the insulating film 922 is to be formed by a combination of plasma CV and sputter etching, a substantially flat surface is obtained at a thickness of the film of say 1.5 μm or so.

Next, as shown in Fig. 9D, an SiN film 923 having a thickness of say 5,000 Å is formed on the insulating film 922 by plasma CV for example.

Then, as shown in Fig. 9E, an SiO film 924 having a thickness of say 1 μm is formed like the SiN film 923 by plasma CV for example. In this way there is formed a protective film 925 superior in moistureproofness.

Next, as shown in Fig. 9F, a predetermined portion of the protective film 925 is removed by etching to form an opening 925a, allowing the surface of the wiring 921b to be exposed to the opening thus formed. In this state, a Cr film 926 having a thickness of say 2,000Å, a Cu film 934 having a thickness of say 500Å and a gold (Au) film 935 having a thickness of say 1,000Å are formed on the whole surface successively by vapor deposition for example. Thereafter, the Au film 935, Cu film 934 and Cr film 926 are patterned into a desired shape by etching. In this case, the Au film 935 is for preventing oxidation of the Cu film 934, while the Cu film 934 is for ensuring wetting characteristic with respect to the substrate of the solder bumps 928. The etching for the Au film 935 and the Cu film 934 is performed, for example, according to a wet etching process, while the etching for the Cr film 926 is performed, for example, according to a dry etching process using a gaseous mixture of $CF_4$ and $O_2$. In dry etching, as noted above, the SiO film 924 acts as an etching stopper, so it is possible to prevent the SiN film 923 of the lower layer from being etched. The Au film 935, Cu film 934 and Cr film 926 are usually called BLM (Ball Limiting Metalization).

Then, as shown in Fig. 9G, a regist pattern 936 of a predetermined shape is formed on the SiO film 924 and thereafter a Pb film 937 and an Sn film 938 are formed successively on the whole surface by vapor deposition for example to cover the Au film 935, Cu film 934 and Cr film 926. The thickness of the Pb film 937 and Sn film 938 is selected so that solder bumps 928 to be formed later have a predetermined value of Sn content.

Next, the regist pattern 936 is removed (so-called lift-off) together with the Pb film 937 and Sn film 938 formed thereon, followed by heat treatment at a predetermined temperature, whereby the Pb film 937 and the Sn film 938 are alloyed to form generally spherical solder bumps 928 of Pb-Sn alloy. In this alloying step, the Sn in the Sn film 938 is alloyed with the Cu in the Cu film 934, whereby an intermetallic compound layer 927 of

Cu-Sn system is formed between the solder bumps 928 and the Cr film 926. Actually, the Au from the Au film 935 is also contained in the solder bumps 928.

The following description is now provided about an intra-chip construction of VLSI (Very Large Scale Integration) which is an application example of the present invention.

The chip referred to herein is used as a CPU section and other logical operation and memory elements of a main frame computer (ultra-high speed computer). Therefore, it is necessary for the chip to have a very large number of input and output terminals, so the chip is mounted or connected to an external package or circuit board by wire bonding up to 200 pins or so or by TAB (Tape Automated Bonding) or CCB (Controlled-Collapse Solder Bumps) for a larger number of pins.

The chip is in the form of a square or rectangular plate 10 to 20 mm in length of one side, and on its element-forming main surface there are formed ECL (Emitter-Coupled Logic) circuit and CMOS (Complementary MOS) circuit as necessary. There is selected an intra-chip construction corresponding to specifications required according to the same method (design and manufacturing method) as the so-called gate array.

Fig. 9H is a schematic top view showing a construction of aluminum wirings of second to fourth layers on the chip. In the same figure, numeral 921 represents a fourth-layer metal wiring group or Aℓ-4 (or WR-4). The wiring group 921 comprises a large number of lines extending mainly in the Y-axis direction so as to traverse the chip vertically. Numeral 919 represents a third-layer metal wiring group or Aℓ-3 (or WR-3) extending mainly in the X-axis direction. Numeral 917 represents a second-layer metal wiring group or Aℓ-2 (or WR-2) extending mainly in the Y-axis direction. Although these aluminum wiring groups are shown only partially, they are provided throughout the entire surface of the chip as necessary. Numerals 941a to 941g denote power lines or reference voltage lines 50 - 200μm in width (in the Case of ECL, $V_{ESL}$ ... -4V, $V_{EE}$ ... -3V, $V_{TT}$ ... -2V; $V_{CC1}$, $V_{CC2}$ and $V_{CC3}$ ... 0V). The lines indicated by 944Y are fourth-layer auxiliary lines or AℓS-4 having a width of 10 μm and extending so as to substantially traverse the upper surface of the chip 901 vertically. But they may be provided as in the other embodiments. Numerals 943a to 943h represent lines or Aℓ-3 having a pitch of 5 μm and a width of 3.5 μm. Numeral 943x represents third-layer auxiliary lines or AℓS-3 disposed at every five pitch and extending so as to substantially traverse the upper surface of the chip laterally. These floating auxiliary lines AℓS-3 and AℓS-4 can substantially cover the whole area of the chip. Numerals 942a to 942f represent lines or Aℓ-2 having a pitch of 5 μm and a width of 3.5 μm. Their layout is made automatically according to the necessity of interconnection in association with the wiring Aℓ-3.

Fig. 9I is a layout diagram of wiring correction process supporting tools and others corresponding to the foregoing embodiments 2 and 3. In the same figure, numerals 945a and 945b each represent an origin detecting pattern for detecting an angle θ between an origin of a pattern on the chip 901 and a reference axis. They are formed by Aℓ-4. Numeral 946 denotes a trial cutting region shown in the embodiment 3; numeral 947a denotes a cutting reference mark or inter-layer deviation detecting metal pattern shown in the embodiment 2, constituted by Aℓ-3; and numeral 947b also represents the same inter-layer deviation detecting metal pattern, constituted by Aℓ-4. The details thereof are as described in the embodiment. Numerals 948a to 948d represent auxiliary gate cells, and numeral 949 represents a region for the formation of a pattern or mark using FIB or by laser selection CV in order to record wiring correction history, specification, name and type of article, etc.

Fig. 9J is a plan view showing only an antenna wiring constituted by Aℓ-3 in the planer layout of the auxiliary gate cell. In the same figure, numerals 951a to 951j represent antenna lines or AℓA-3.

Fig. 9K is a schematic circuit diagram of built-in elements and gates of the auxiliary gate cell. In the same figure, $SR_1$ and $SR_2$ denote auxiliary resistors, and $SG_1$ and $SG_2$ denoe ECL auxiliary gates.

The following is an explanation of various patterns used in the wiring correcting method of the invention. (The circuit shown below is an example of AN ECL circuit.)

Fig. 9L is a schematic circuit diagram showing a correction pattern called "Input Low Clamp". In the same figure, $G_1$ denotes an already wired gate as one gate of the VLSI; $I_1$ to $I_3$ represent input lines thereof; $O_1$ represents an output line of the gate; and $C_1$ represents a part of the input line $I_1$ which has been cut using FIB.

Fig. 9M is a schematic diagram showing a correction pattern called "Input High Clamp". In the same figure, $G_2$ and $G_3$ represent wired gates; $I_4$ to $I_8$ represent input lines of the gates; $O_2$ and $O_3$ represent output lines of the gates; $V_{CC}$ represents one of $V_{CC1}$ to $V_{CC3}$ and it is $V_{CC2}$ in the case of an internal gate; and $C_2$ represents a jumper line formed by laser CV or vapor-phase selection CV using FIB.

Fig. 9N denotes a schematic circuit diagram showing a correction pattern called "Use of Reverse Output". In the same figure, $G_4$ and $G_5$ represent wired gates; SG represents an auxiliary gate (corresponding to $SG_1$ and $SG_2$ in Fig. 9K) in the auxiliary gate cell 948 corresponding to one of 948a to 948d in Fig. 9I; $I_9$ to $I_{14}$, and $I_{24}$, $I_{25}$ represent input lines of the gates; $O_4$ and $O_5$ represent output lines of $G_4$ and $G_5$; and $C_3$ and $C_4$ represent jumper correction lines formed by vapor-phase selection laser CV or other means like the foregoing.

Fig. 9O is a schematic circuit diagram of a correction pattern called "Addition of Auxiliary Gate". In the same figure, G6 to G8 represent wired gates; SG represents an auxiliary gate in the auxiliary gate cell 948 like before; $I_{15}$ to $I_{23}$ represent gate input lines; $O_6$ represents an output line of the gate G; and $C_5$ to $C_7$ represent correction lines formed by, fcr example, laser CV using Mo (molybdenum).

The process of this correction system will be described below.

In developing a main frame computer, it is necessary to develop several hundred kinds of logical LSIs at a time and made debugging and adjustment of the system using them. Where there is a logical defect or a changing point, it is necessary to again make LSIs immediately. In the present invention, LSIs in the form of a

chip after dicing, with CCB electrode already formed (corresponding to Fig. 9A), are stocked and the foregoing correction patterns or such corrections as shown in the foregoing embodiments are applied to them, whereby the re-fabrication of LSIs can be completed in 5 to 30 hours.

The wiring correction can be done not only in the state of chip but also in the state of wafer and it is easy to make alignment, although the turnaround time until correction and refabrication becomes longer. Therefore, the correction in the state of wafer can be made in the field where such demerit is allowed. For exmaple, it is useful in WSI (Wafter Scale Integration) because such demerit is avoided.

As to the correction in the state of chip, the wiring correction can be done not in a bare chip but also in a die-bonded state to a package base or in a completely wire-bonded state. In this case, it is possible to further shorten the turnaround time. This is also true of the case where the TAB technique is applied.

For example, as mentioned above, divided auxiliary chips in the state of Fig. 9A are stocked for various kinds and correction is made in response to the results of debugging.

First, for the trial cutting region 946 shown in Fig. 9I, there is performed trial cutting as shown in the embodiment-3 using FIB and detected data are stored. Further, using the inter-layer deviation detecting patterns 947a and 947b in the same figure, there is detected a registration error of Aℓ-3 and Aℓ-4 as shown in the embodiment-2 and the detected data is stored. Then, using the origin and θ detecting patterns 945a and 945b, there is performed operation and calculation to make design pattern data and actual pattern on the chip coincident in origin and axis, and such corrections as shown in Figs. 9Q to 9H are executed. Devices and conditions used in these processes as well as other correction techniques for wiring were already described in detail in the embodiments 1 to 8, so will not be repeated here.

Fig. 9Q is an enlarged top view of a correction part on the main chip surface corresponding to Figs. 9H and 9I. In the same figure, numeral 941 denotes a wide, Aℓ-4, power line (incl. reference power line); numeral 943X denotes an AℓS-3 or an auxiliary line using Aℓ-3, extending in the X-axis direction, (this may be one of Aℓ-3 or the third-layer aluminum wiring group already connected to elements); numeral 944Y denotes an AℓS-4 or a fourth-layer, auxiliary Aℓ line extending in the Y direction; numeral 956 denotes an Mo (molybdenum) layer embedded by laser CV in a vertical hole which has been formed using FIB.

Fig. 9R is a sectional view taken on line X-X of Fig. 9Q. In the same figure, numeral 918 denotes a third layer, inter-layer insulating film; numeral 943X represents the foregoing third-layer auxiliary line; numeral 920 represents IL-4 or a fourth-layer, inter-layer insulating film; numeral 941 represents a power line; numeral 925 represents a final passivation film; numeral 944Y represents a fourth-layer auxiliary line; numeral 953 represents a substrate Cr (chromium) film; and numeral 954 represents an Mo laser CV layer.

Fig. 9S is an enlarged top view of a portion to which was applied another correction technique. Only the portions different from Figs. 9Q and 9R will now be explained. In Fig. 9S, numeral 959 represents a ⊐– shaped notch (formed using FIB) for preventing short-circuit of the Mo jumper line and the power line 941; numerals 957 and 958 each represent an Mo layer formed in a vertical hole which has been formed using FIB; and numeral 960 represents an Mo jumper line same as the said Mo layer.

Fig. 9T is a sectional view taken on line X-X of Fig. 9S. The numerals shown therein are the same as those explained previously, so repeated explanation will be omitted. The technique illustrated therein is effective particularly when 943X does not extend up to the position just under 944Y or when 943X is a conventional Aℓ-3.

Figs. 9U, 9V and 9H are a plan view, an enlarged view of a principal portion and an X-X sectional view thereof, respectively, showing an example of another correction technique, particularly using an auxiliary gate. In those figures, numeral 948 denotes an auxiliary gate cell, and numerals 951a to 951j denote antenna lines, which are connected to either $SG_{1-2}$ or $SR_{1-2}$ terminals through Aℓ-2 and Aℓ-1. Numeral 941 represents a wide power line constituted by Aℓ-4; numeral 944Y represents AℓS -4; numeral 943X represents AℓS-3; and numeral 961 represents a principal portion for correction. Further, numerals 962 and 963 each represent an Mo (molybdenum) layer embedded by laser CV in a vertical hole which has been formed using FIB; and numeral 964 represents an Mo jumper line formed by laser scanning contiguously to the layers 962 and 963.

The following is an explanation about a process for perforating using FIB and for forming a jumper line by laser CV.

Figs. 9P(a) to (d) are sectional views of a principal portion showing a flow of that process. As shown in Fig. 9P(a) and as illustrated in the preceding embodiment, coordinates of the object for correction are determined on the basis of prestored data and a hole 952 is formed using FIB (internal pressure of the processing chamber: $1 \times 10^{-5}$ Pa). Then, as shown in Fig. 9P(b), the aluminum surface and the surface of the final passivation film 925 are subjected to sputter etching in an Ar (argon) atmosphere. Thereafter, Cr is allowed to adhere about 100Å to the whole surface by sputtering to form a Cr (chromium) substrate film 953. Next, as shown in Fig. 9P(c), an Mo (molybdenum) correction line 954 of about 0.3-1 μm in thickness and 3-15 μm in width is formed in a sublimation phase atmosphere (gas phase) of approx. 10 Pa of molybdenum-carbonyl [$Mo(CO)_6$] (for example, under the following conditions: laser output ... 200mW, laser scanning speed ... 1 mm/sec, using a continuous oscillation, high output, Ar laser). Then, as shown in Fig. 9P(d), the Cr film of an unnecessary portion 955 is removed, using the line 954 as a mask, by sputtering in an Ar atmosphere.

In practicing the correction pattern of Figs. 9L to 9O, as explained above, the techniques shown in Figs. 9Q to 9H are combined together to execute wiring correction on the chip after completion of the final passivation. After or almost simultaneously with the completion of this correction, correction data, etc. are marked in the

position of 949 in Fig. 9I by laser CV (simultaneous processing in the correction system), or by metal film deposition using FIB, or by notching A-3, A-4 or Mo film. For this marking there may be used characters, numerals, suitable symbols, bar codes, and various other codes for computer recognition. In the case where a complicated high-density wiring is formed in the region of 949, it is effective to use a code in the form of a diffraction grating pattern formed by notching with FIB or a similar pattern formed by Mo laser CV.

The entire layout, etc. in the case of making correction (Figs. 9L to 9O) by combining the above partial (local) techniques (Figs. 9Q to 9H) actually, has already been fully described in the embodiment-6, so will not be repeated (10) References cited for supplementing the description of each embodiment:

Laser cutting, connection and laser CV are described in Mader's U.S. Patent 4,240,094; Uesugi et al, "Extended Abstracts of the 17th Conference of Solid State Devices and Materials", pp. 193 - 196; Black et al., "Appl. Phys. Lett. 50(15), 13 April 1987, pp. 1016 - 1018; European Patent Publication EP 25347A2; Hall et al's U.S. Patent 4,181,751; and Kamioka et al's U.S. Patent 4,503,315.

FIB processing technique at large is described in Musil et al, "IEEE Electron Device Letters", Vol. EDL-7, No. 5, May 1986 pp. 285 - 287; Shaver et al, "Journal of Vacuum Science and Technology", B(4), Jan./Feb. 1986 pp. 185 - 188; Mashiko et al, "International Reliability Physics Symposium", April 1987; and S.M. Sze, "VLSI Technology", pp. 426 - 429 Mcgraw-Hill (1983).

Further, in Chapman, "Glow Discharge Processes", pp. 231 - 249 John Wiley & Sons Inc. (1980) there are described bias sputtering (flattening technique) and sputter etching technique.

On pages 93 - 129 of the above Sze's literature there are described various insulating film deposition techniques.

Further, dry etching techniques at large and the technique for forming metallized films are described on pages 303-384 of the above Sze's literature.

Ion beam diagnostic technique and sputtering technique are described in Townsend et al., "Ion Implantation Sputtering and their Applications" Academic Press (1976), pp. 181-261.

Further, in Soong, "Principles of Instrumental Analysis", CBS College Publishing, (1985), pp. 292-303, there are described method and apparatus for visible ray spectrochemical analysis to detect light emitted from a hole being formed using FIB which is used in the end point detection of the invention, namely, a spectrograph, a photomultiplier for spectral detection and other techniques.

Further, the wiring correction method involving notching a wide wiring (e.g. Aℓ wiring) of an upper layer in U-shape or arcuately using FIB and making wiring correction using the FIB technique between an aluminum wiring of a lower layer and another wiring, is described in Takahashi et al's U.S. Patent Application Serial No. 134,460 (filed December 17, 1987) and corresponding Japanese Patent Application No. 298731/86 (filed December 17, 1986) and No. 303719/86 (filed December 22, 1986).

## Claims

1. A semiconductor integrated circuit device comprising:
(a) a substantially rectangular or square plate-like substrate for forming a monolithic integrated circuit having first and second main surfaces opposed to each other;
(b) a very large number of circuit elements formed on said first main surface;
(c) a metal wiring group comprising plural layers for connecting said circuit elements on said first main surface with each other or with the exterior; and
(d) an upper surface protecting insulating film formed on the top metal wiring layer of said metal wiring group so as to substantially cover the whole of said first main surface,
said semiconductor integratd circuit device further including:
(e) a first auxiliary wiring group formed by the same layer as the top metal wiring layer of said metal wiring group.

2. A semiconductor integrated circuit device according to Claim 1, further including:
(f) a least one auxiliary pad or bump electrode provided on said first main surface.

3. A semiconductor integrated circuit device according to Claim 2 , further including:
(g) inter-layer deviation detecting metal patterns formed on said first main surface by the same layers as the metal wiring layers in positions close to each other for detecting a registration error between the metal wiring layers.

4. A semiconductor integrated circuit device according to Claim 3, further including:
(h) at least one trial cutting region formed on said first main surface and having a film structure almost the same as a cutting region.

5. A semiconductor integrated circuit device according to Claim 4, further including:
(i) a coordinates detecting pattern for detecting coordinates on the substrate of a pattern of at least one of said metal wiring layers, said coordinates detecting pattern being formed from the same layer as said one wiring layer.

6. A semiconductor integrated circuit device according to Claim 1, further including:
(j) an opening formed in said upper surface protecting insulating film using FIB for changing a

connective relation of a desired circuit element on said first main surface; and

(k) an interconnection correcting wiring formed by vapor-phase selective CV using laser, one end of said interconnection correcting wiring being connected through said opening to said desired circuit element or one of said first auxiliary wiring group and the other end thereof extending continuously on said upper surface protecting insulating film and being connected to another predetermined circuit or element or electrode.

7. A method of making a semiconductor integrated circuit device, characterized in that a pellet of the semiconductor integrated circuit device of Claim 59 is subjected to the following step (1):

(l) detecting a coordinate origin of a desired wiring layer using said coordinates detecting pattern, forming an opening or a notch in a portion of said upper surface protecting insulating film corresponding to a desired wiring pattern, using the FIB, on the basis of the detected coordinate origin, and making wiring correction through said opening or notch.

8. A method according to Claim 7, wherein, in cutting the protective film, wiring layer or inter-layer insulating film on said first main surface using FIB, the amount of ions to be implanted is integrated analogwise or digitally, and the cutting depth is controlled while monitoring the thus-integrated value.

9. A method according to Claim 8 , further including the following step (m):

(m) detecting an inter-layer deviation using a metal pattern for the detection of an inter-layer deviation and determining a corrective position on the basis of the result of the detection.

10. A cutting method using an energy beam for cutting a workpiece by focusing the energy beam and deflecting it for scanning, which method comprises measuring an electric current of a radiation beam at every predetermined time, obtaining a timewise integrated value with respect to the measured beam current and calculating a cutting depth from said timewise integrated value.

11. A cutting method using an energy beam for cutting a workpiece by focusing the energy beam and deflecting it for scanning, which method comprises determining a cutting rate coefficient represented in terms of a sputter volume of the workpiece relative to unit radiation ion quantity, measuring an electric current of a radiation beam at every predetermined time, obtaining a timewise integrated value with respect to the measured beam current, then determining a total radiation ion quantity from said timewise integrated value, further determining a beam scanning area, and calculating a cutting depth on the basis of said cutting rate factor, said total radiation ion quantity and said beam scanning area.

12. A cutting method using an energy beam for cutting a workpiece by forcusing the energy beam and deflecting it for scanning, which method comprises determining a cutting depth function as a relation between a radiation ion quantity and a cutting depth, measuring an electric current of a radiation beam at every predetermined time,(obtaining a timewise integrated value with respect to the measured beam current) then determining a total radiation ion quantity from said timewise integrated value, and calculating a cutting depth on the basis of said cutting depth function and said total radiation ion quantity.

13. A cutting system using an energy beam for cutting a workpiece by focusing the energy beam and deflecting it for scanning, said cutting system comprising:

measuring means for measuring an electric current of a radiation beam at every predetermined time;

timewise integrated value extracting means for obtaining a timewise integrated value with respect to the beam current measured by said measuring means; and

cutting depth calculating means for calculating a cutting depth from the timewise integrated value obtained by said timewise integrated value extracting means.

14. A cutting system using an energy beam for cutting a workpiece by focusing the energy beam and deflecting it for scanning, said cutting system comprising:

cutting rate coefficient specifying means for specifying a cutting rate coefficient represented in terms of a sputter volume of the workpiece relative to unit radiation ion quantity;

measuring means for measuring an electric current of a radiation beam at every predetermined time;

total radiation ion quantity extracting means for obtaining a total radiation ion quantity from a timewise integrated value obtained with respect to the beam current measured by said measuring means;

beam scanning area extracting means for obtaining a beam scanning area; and

cutting depth calculating means for calculating a cutting depth on the basis of the cutting rate coefficient specified by said cutting rate coefficient specifying means, the total radiation ion quantity obtained by said total radiation ion quantity extracting means and the beam scanning area obtained by said beam scanning area extracting means.

15. A cutting system using an energy beam for cutting a workpiece by focusing the energy beam and deflecting it for scanning, said cutting system comprising:

cutting depth function specifying means for specifying a cutting depth function as a relation between a radiation ion quantity and a cutting depth;

measuring means for mesuring an electric current of a radiation beam at every predetermined time;

total radiation ion quantity extracting means for obtaining a total radiation ion quantity from a timewise integrated value obtained with respect to the beam current measured by said measuring means; and

cutting depth calculating means for calculating a cutting depth on the basis of the cutting depth function specified by said cutting depth function specifying means and the total radiation ion quantity obtained by said total radiation ion quantity extracting means.

16. A cutting method using an ion beam for cutting a cutting region by radiating an ion beam to the

cutting region positioned in an inner layer of a predetermined depth of a laminated sample of two or more layers, using ion beam generating means, means for focusing the ion beam generated by said ion beam generating means, means for deflecting the ion beam for scanning with respect to the surface of the sample, and blanking means for intermitting the radiation of the ion beam, characterized in that an ion beam radiating position is determined with reference to a cutting reference mark of a predetermined shape formed at a depth just the same or almost the same as said cutting region and that the ion beam is radiated in said radiation position to cut the cutting region.

17. A cutting method using an ion beam according to Claim 16, wherein the position of said cutting reference mark is specified from the surface shape of an exposed layer laminated on said cutting reference mark, in which exposed layer is exactly reflected the shape of said cutting reference mark.

18. A cutting method using an ion beam according to Claim 17, wherein the surface of said exposed layer in which is exactly reflected the shape of said cutting reference mark is scanned with the ion beam, and the position of the cutting reference mark is specified on the basis of a change of secondary electrons or secondary ions produced during said scanning.

19. A cutting method using an ion beam according to Claim 16, wherein the surface of said cutting reference mark is scanned directly with the ion beam, and the position of the cutting reference mark is specified from a change of secondary electrons or secondary ions produced during said scanning.

20 . A cutting method using an ion beam according to Claim 19, wherein a layer-forming material positioned on said cutting reference mark is removed by radiating the ion beam thereto, thereby exposing the cutting reference mark, and thereafter the surface of the cutting reference mark is scanned with the ion beam.

21. A cutting method using an ion beam according to Claim 16, wherein a deviation detecting mark is formed on a layer different from the inner layer formed with said cutting reference mark; an auxiliary cutting mark is formed on the same layer as that on which said deviation detecting mark is formed; an amount of a positional deviation between said deviation detecting mark and said cutting reference mark is measured; an inter-layer deviation correction is made for said auxiliary cutting mark on the basis of said amount of a positional deviation; and positioning of the cutting region is performed on the basis of said auxiliary cutting mark after the correction.

22. A cutting method using an ion beam according to Claim 21, wherein said deviation detecting mark and said auxiliary cutting mark are positioned on the top of the sample.

23. A cutting method using an ion beam according to Claim 21, wherein the surface of said auxiliary cutting mark is scanned with the ion beam and the position of the auxiliary cutting mark is specified from a change of secondary electrons or secondary ions produced during said scanning.

24. A semiconductor device having a trial cutting region same as an element region in the structure in the depth direction and in formation history.

25. A semiconductor device according to Claim 24, wherein, prior to cutting for said element region with an ion beam, said trial cutting region is cut with the ion beam to grasp a dose amount required for cutting up to a desired depth in the cutting for said element region.

26. A semiconductor device according to Claim 24, characterized by being a logical element for which logical correction, taking a measure against a defective design or analysis of a defect is effected by cutting and exposing a wiring using an ion beam.

27. A cutting method using an ion beam, which method comprises a first step of cutting a first region of a predetermined area of a workpiece constituted by at least one layer, by radiating a focused ion beam thereto, measuring a time required for cutting each said layer on the basis of a change of charged particles or emission spectrum generated from the workpiece during cutting, and integrating an ion beam current measured during cutting, with respect to said required time, to thereby determine a dose amount required for cutting per unit area of each said layer, and a second step of setting a target dose amount required for cutting up to a desired depth in any second region of the workpiece on the basis of said dose required for cutting per unit area of each said layer, integrating an ion beam current during cutting with respect to a cutting time, and cutting said second region until the dose amount obtained by said integral reaches said target dose amount.

28. A cutting method using an ion beam according to Claim 27, wherein said charged particles are secondary electrons or secondary ions generated from the region where the ion beam is incident on the workpiece.

29. A cutting method using an ion beam according to Claim 27 , wherein said workpiece is a semiconductor wafer having a plurality of semiconductor devices formed thereon, and which is used for cutting a wiring positioned at any depth of any said semiconductor device to make logical correction or take a measure against a defective design or for forming a hole up to a depth of a desired wiring to make analysis of a defect.

30. A cutting system using an ion beam, said cutting system comprising:

an ion source;

an ion beam optical system for controlling an ion beam emitted from said ion source;

detecting means for detecting charged particles or emission spectrum generated from a cutting region of a workpiece;

ion beam current measuring means;

dose amount calculating means for calculating a dose amount required for cutting per unit area of each constituent layer of the workpiece by measuring a time required for cutting each said constituent layer of the workpiece on the basis of a change of said charged particles or emission spectrum generated from the workpiece and by integrating an ion beam current measured during cutting of each said layer, with respect to said required time; and

dose amount storage means for storing the thus-calculated dose amount required for cutting per unit area of each said layer,

in which cutting for a second region of the workpiece is performed through a first stage of determining a dose amount required for cutting per unit area of each said layer in a first region of the workpiece and storing it in said dose amount storage means and further through a second stage of setting a target dose amount required for cutting up to a desired depth in the second region of the workpiece on the basis of the dose amount required for cutting per unit area of each said layer in the first region of the workpiece and stored in said dose amount storage means, and continuing the cutting work until a dose obtained by integrating an ion beam current during cutting with respect to a cutting time reaches said target dose amount.

31. A cutting system using an ion beam according to Claim 30, wherein said charged particles are secondary electrons or secondary ions generated from the region where the ion beam is incident on the workpiece.

32. A cutting system using an ion beam according to Claim 30, wherein said workpiece is a semiconductor device and which is used for cutting and exposing a wiring positioned at any depth of said semiconductor device to make logical correction, take a measure against a defective design or make analysis of a defect.

33. A semiconductor integrated circuit device having an auxiliary bump or an auxiliary pad in a floating state.

34. A semiconductor integrated circuit device according to Claim 33, wherein said auxiliary bump or pad is for measuring a potential of a defective part of an internal circuitry.

35. A semiconductor integrated circuit device according to Claim 34, wherein said defective part is connected to said auxiliary bump or pad through a connecting wiring formed by laser CV.

36. A semiconductor integrated circuit device according to Claim 33, including an auxiliary wiring in a floating state.

37. A semiconductor integrated circuit device according to Claim 36, wherein said defective part is connected to said auxiliary bump or pad through a connecting wiring formed by laser CV and said auxiliary wiring.

38. A semiconductor integrated circuit device according to Claim 33, including plural said auxiliary bumps or said auxiliary pads.

39. A semiconductor integrated circuit device according to Claim 33, wherein said auxiliary wiring comprises an aluminum wiring of a third layer and an aluminum wiring of a fourth layer.

40. A semiconductor integrated circuit device according to Claim 33, wherein said connecting wiring is a molybdenum wiring or a tungsten wiring.

41. A semiconductor integrated circuit device according to Claim 33, which is a bipolar LSI.

42. A depth monitoring method using a cutting system having an energy beam such as a focused ion beam, a deflecting scan system for deflecting the energy beam on the surface of a sample to scan said surface and a mechanism for blanking the beam, which method comprises the steps of:

(a) determining in advance a cut-away volume of a workpiece per unit time based on unit current;

(b) measuring a beam current or any other physical quantity capable of calculating a beam current accurately, at every predetermined time during cutting; and

(c) integrating said beam current and the cutting rate coefficient with respect to time to obtain a cut-away volume and then dividing it by the area of a beam scan region to obtain a cutting depth.

43. A depth monitoring method according to Claim 42, further involving the following steps when the workpiece is a multilayer sample comprising a plurality of materials:

(d) determining in advance a cutting rate coefficient and a layer thickness of each said material;

(e) determining a beam current in the same manner as in step (b); and

(f) integrating the product of said beam current and a cutting rate coefficient according to the quality of the material being cut, with respect to time, to obtain a cut-away volume and dividing it by the area of a beam scan region to obtain a cutting depth.

44. A depth monitoring system comprising means for measuring a source current value, a circuit for calculating a beam current value form the source current value, a circuit for calculating a cut-away volume and a cutting depth from the beam current value, and means for displaying the cutting depth.

45. A semiconductor device having a first normal wiring extending in a first direction on a substrate, a first auxiliary wiring of the same layer as the first normal wiring, extending in the same direction as the first normal wiring, a second normal wiring extending in a second direction on an insulating film which covers said first normal wiring and first auxiliary wiring, and a second auxiliary wiring of the same layer as the second normal wiring, extending in the same direction as the second normal wiring; wherein an electroconductive layer of the same layer as said second normal wiring and second auxiliary wiring is formed on a predetermined portion of said first auxiliary wiring in a connected state to the first auxiliary

wiring.

46. A semiconductor device according to Claim 45, wherein said electroconductive layer connected to the first auxiliary wiring is provided in the vicinity of a crossing portion of the first and second auxiliary wirings.

47. A semiconductor device according to Claim 45, wherein said first and second auxiliary wirings and said electroconductive layer connected to the first auxiliary wiring are used for the change of wiring.

48. A semiconductor device according to Claim 47, wherein said change of wiring is performed by sputtering using an ion beam or selective CV.

49. A semiconductor device according to Claim 45, wherein said first auxiliary wiring is cut off in the vicinity of a crossing portion thereof with respect to the second auxiliary wiring and the resulting two first auxiliary wirings are connected together through said electroconductive layer which is provided above the spacing between those first auxiliary wirings.

50. A wiring forming method in a semiconductor integtrated circuit device for crossing CV wirings formed from an electroconductive material on the surface of the semiconductor device by radiating an energy beam onto the surface of the semiconductor device to have the electroconductive material deposited in the presence of a CV gas which causes the electroconductive material to be deposited upon radiation of the energy beam, and at the same time by shifting the radiated position of the energy beam relative to the semiconductor device, characterized in that a CV wiring is connected to a part of a wiring present in the semiconductor device and then drawn out from another point of said part of the wiring, and another CV wiring is formed so as to avoid the connection of said part of the wiring, thereby crossing one or plural said CV wirings.

51. A wiring forming method according to Claim 50, wherein as said part of the wiring there is used a region formed by cutting off a part of a wiring layer of the semiconductor device in a cutting step using radiation of the energy beam.

52. A wiring forming method according to Claim 50 , wherein as said part of the wiring there is used an island region not connected to any other wiring formed in the manufacturing process for the semiconductor device.

53. A wiring forming method according to Claim 50 , wherein as said part of the wiring there are used portions of an island region not connected to any other wiring formed in the manufacturing process for the semiconductor device, said portions of the island region being obtained by removing portions of a protective film present on two portions of the island region.

54. A wiring forming method according to Claim 53 , using portions of the island region corresponding to the partially removed portions of said protective film onto which is formed a coating of a metal having a low reaction rate with respect to oxygen or into which said metal is embedded.

55. A semiconductor integrated circuit device comprising a substrate, a semiconductor layer, an electroconductive layer and an insulating layer, characterized in that an island-like electroconductive region not connected to any other electroconductive wiring is formed in the electroconductive layer close to an upper layer.

56. A semconductor integrated circuit device according to Claim 55, wherein a protective film overlying said island-like electroconductive region is removed at two portions.

57. A semconductor integrated circuit device according to Claim 56, wherein said protective film-removed portions are filled or coated with a metal having a low reactioin rate with respect to oxygen.

58. A semiconductor integrated circuit device according to Claim 57, wherein a different kind of a metal is interposed between the metal having a low reaction rate with respect to oxygen and a metal which forms said island region.

59. A semiconductor integrated circuit device suing a GaAs substrate and comprising:

(a) a substantially rectangular or square plate-like, semi-hermetic GaAs substrate having first and second main surfaces opposed to each other;

(b) a very large number of elements formed on said first main surface;

(c) a first metal wiring group extending in a large number mainly in an X-axis direction through a first inter-layer insulating film on said first main surface;

(d) a second metal wiring group extending in a large number mainly in a Y-axis direction through a second inter-layer insulating film formed on said first inter-layer insulating film and metal wiring group;

(e) at least one second auxiliary wiring formed by a metallic layer simultaneously with said second metal wiring group, said second auxiliary wiring group extending in the Y-axis direction approximately in parallel with the second metal wiring group; and

(f) an upper surface protecting insulating film formed substantially on the whole upper surface of said second inter-layer insulating film, second metal wiring group and second auxiliary wiring.

60. A semiconductor integrated circuit device according to Claim 59, further including:

(g) a third wiring group of a lower layer extending in a large number mainly in the Y-axis direction and a fourth wiring group of an upper layer extending in a large number mainly in the X-axis direction, said third and fourth wiring groups being provided between said first wiring group and said second insulating film through an inter-layer insulating film.

61. A semiconductor integrated circuit device according to Claim 59, further including:

(h) at least one auxiliary gate provided on said first main surface.

62. A semiconductor integrated circuit device according to Claim 61, further including:

(i) an antenna wiring formed by the same layer as said first metal wiring group and connected to said auxiliary gate provided on said first main surface, said antenna wiring extending over a length which traverses at least one said second metal wiring approximately in the X-axis direction.

63. A semiconductor integrated circuit device according to Claim 60, further including:

(j) an auxiliary wiring group formed by a metal layer of the same layer as said fourth wiring group on said first main surface, said auxiliary wiring group extending in the X-axis direction so as to traverse at least plural adjacent lines of said second metal wiring group.

64. A method of making a semiconductor integrated circuit device, which method comprises forming a final passivation film using an auxiliary pad or bump in a floating state and thereafter making a desired wiring correction using FIB.

65. A method of making a semiconductor integrated circuit device, which method comprises forming a final passivation film using an auxiliary wiring in a floating state and thereafter making a desired wiring correction using FIB.

66. A method of making a semiconductor integrated circuit device, which method comprises integrating the amount of ions implanted analogwise or digitally in real time, controlling the cutting depth while monitoring the thus-integrated value, and making a wiring correction after formation of a final passivation film, using FIB.

67. A method of developing a main frame computer using a multitude of logic or memory LSI chips, which method comprises providing at least two sets of said LSI chips, assembling a computer using a first set of LSIs, making debugging, thereafter making wiring correction for the second set of LSIs on the basis of the debugging data, and assembling a computer

0295065

FIG. 1A

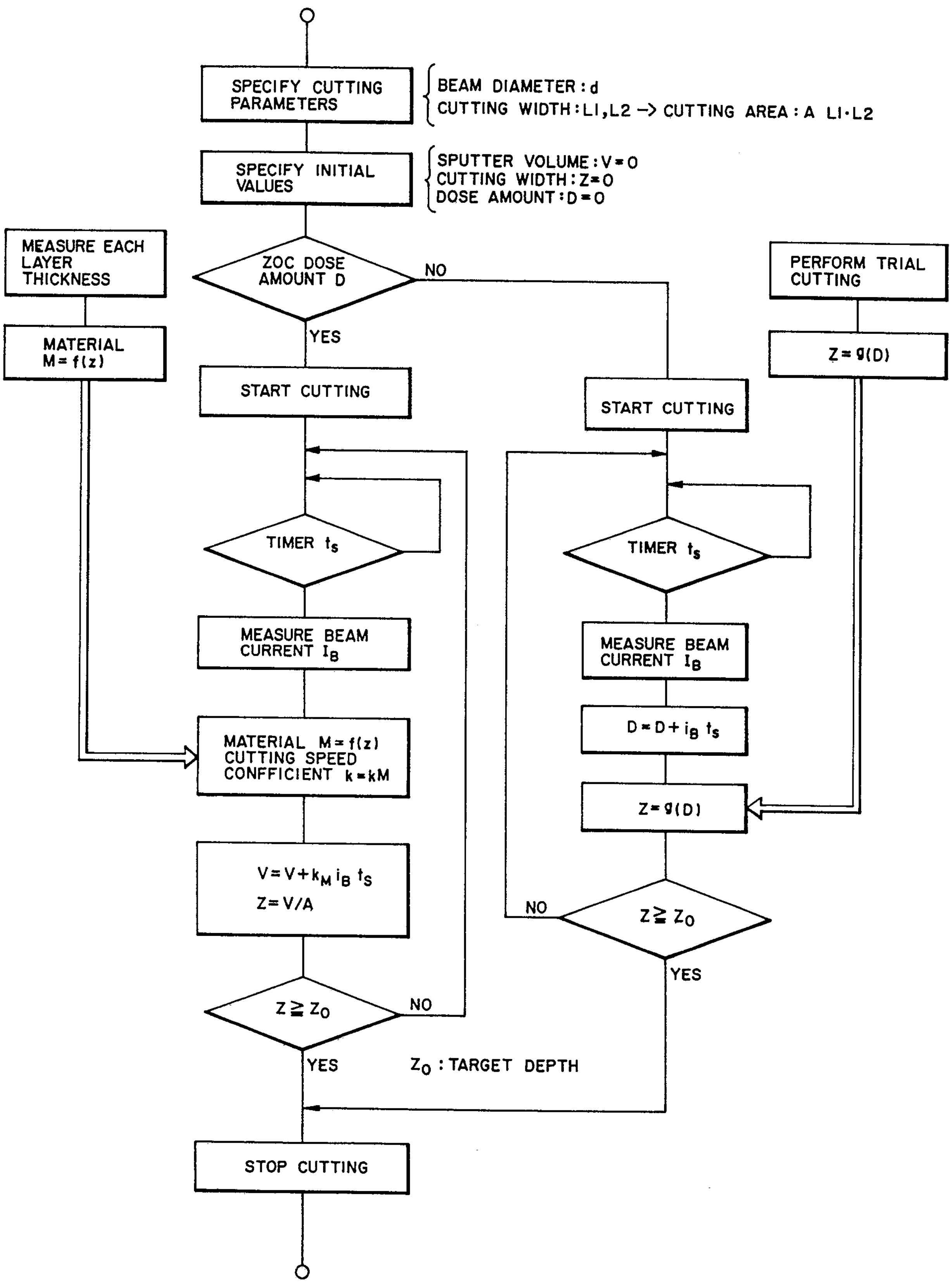

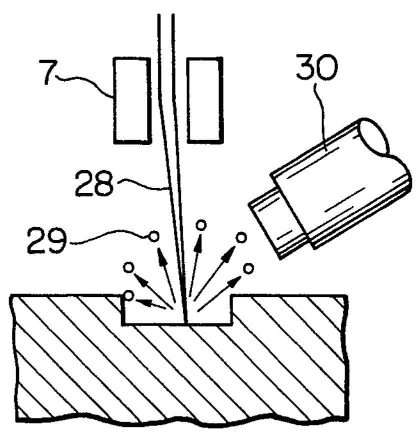


FIG. 1B

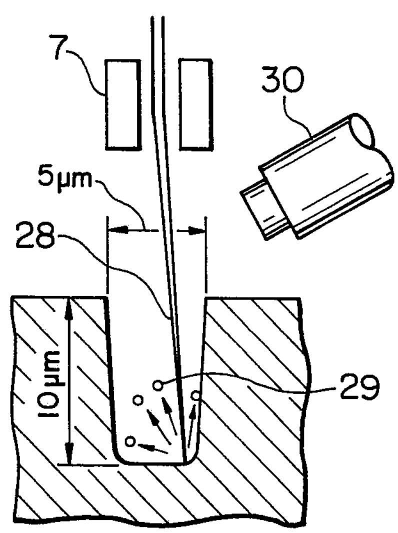


FIG. 1C

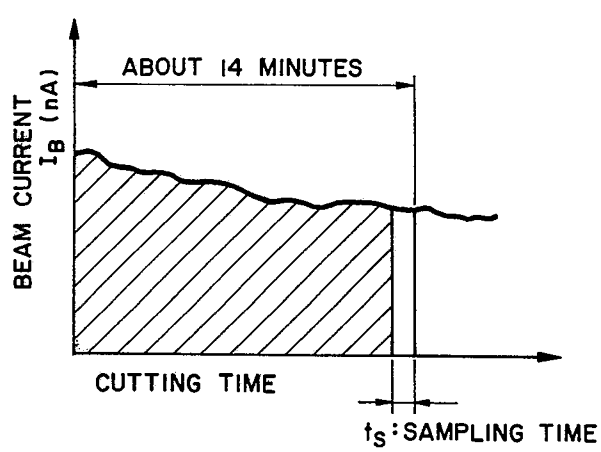


FIG. 1D

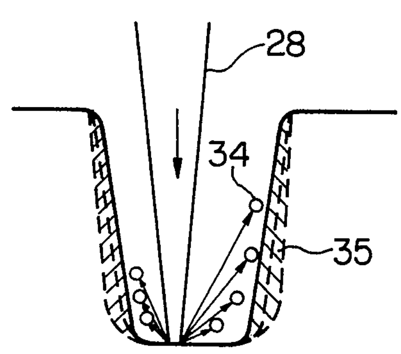


FIG. 1F

0295065

FIG. 1E

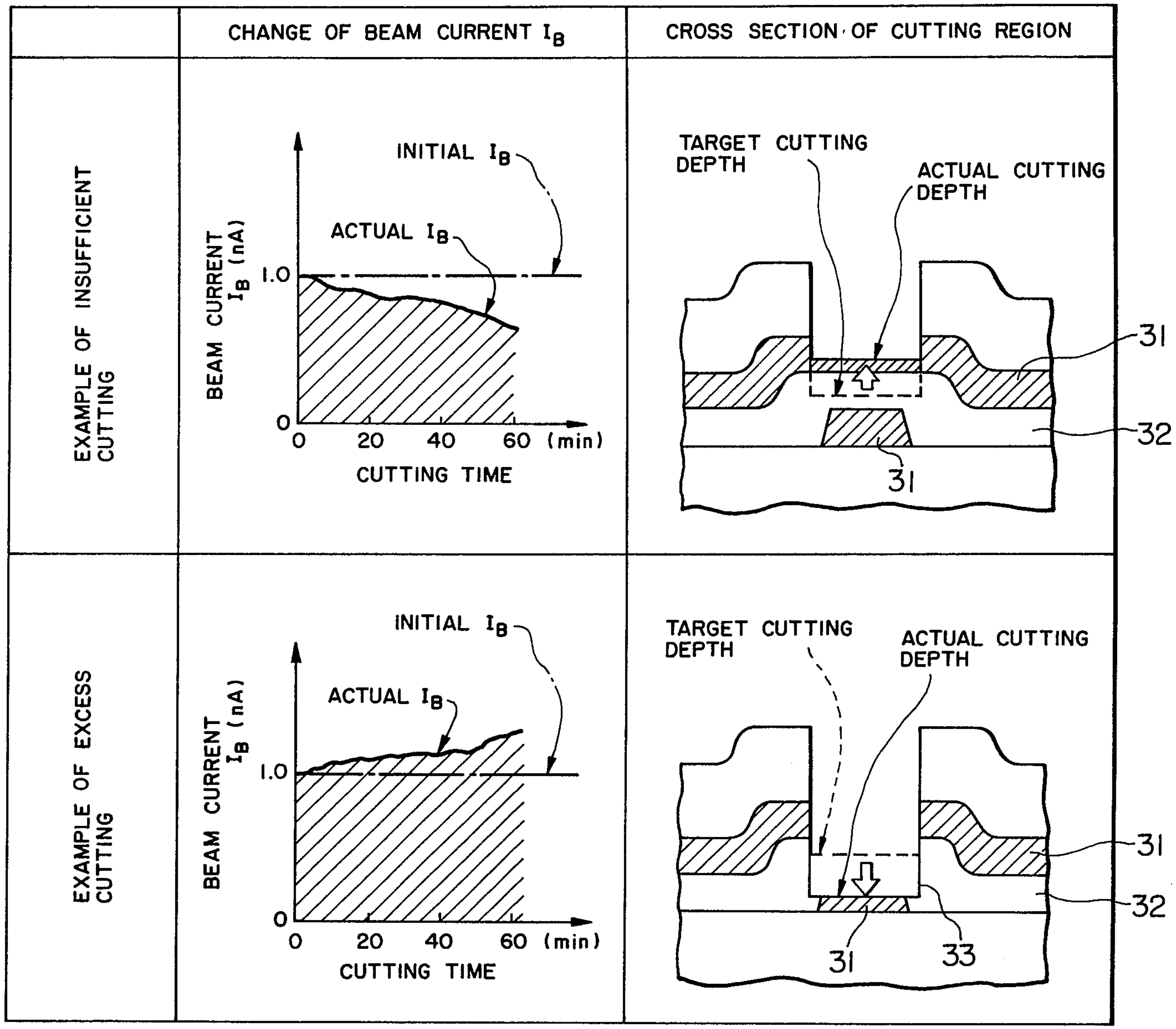

FIG. 1G

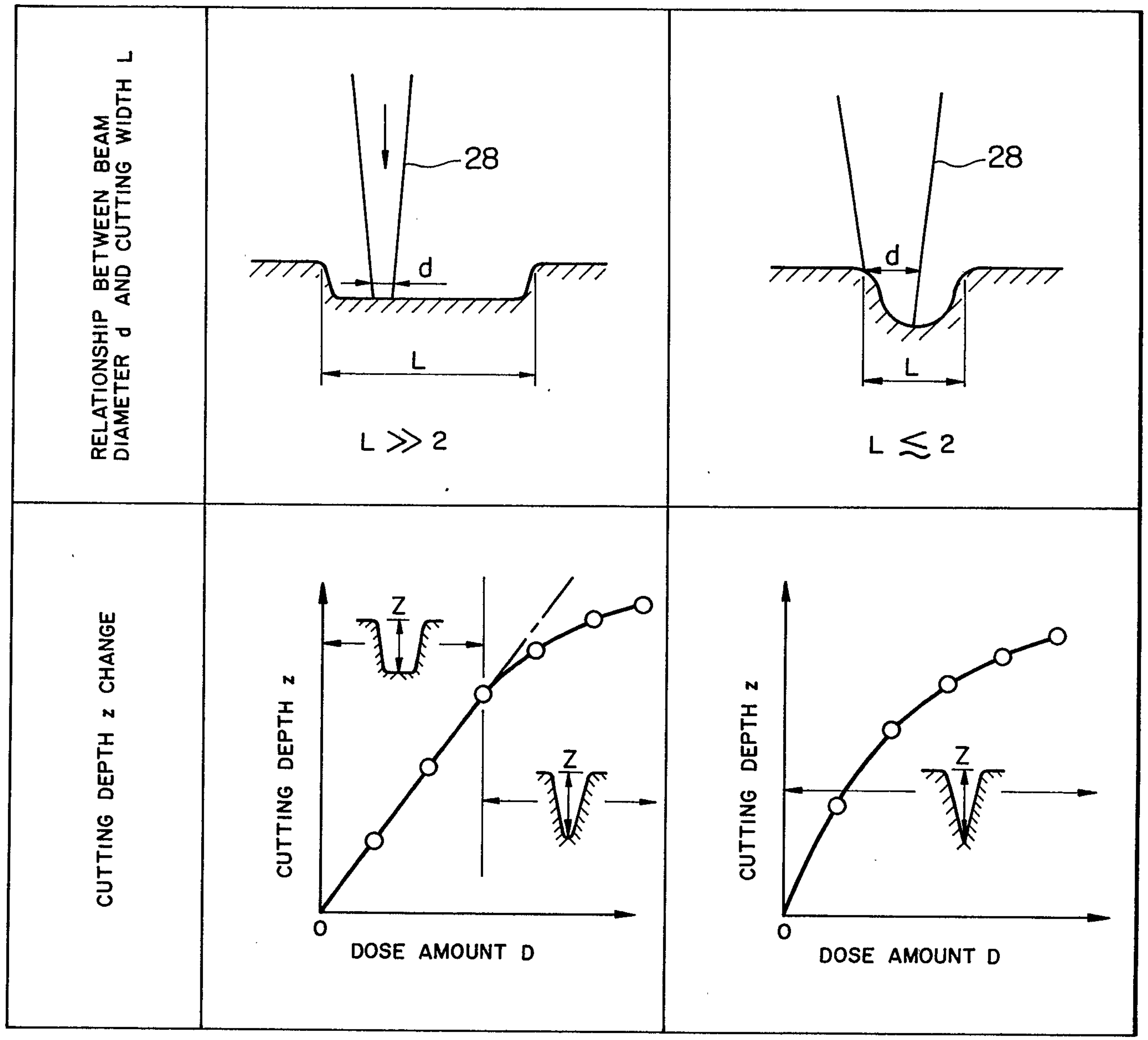
RELATIONSHIP BETWEEN BEAM DIAMETER d AND CUTTING WIDTH L
28
d
L
L ≫ 2
28
d
L
L ≲ 2
CUTTING DEPTH z CHANGE
Z
CUTTING DEPTH z
DOSE AMOUNT D
0
Z
CUTTING DEPTH z
DOSE AMOUNT D
0

FIG. 1H

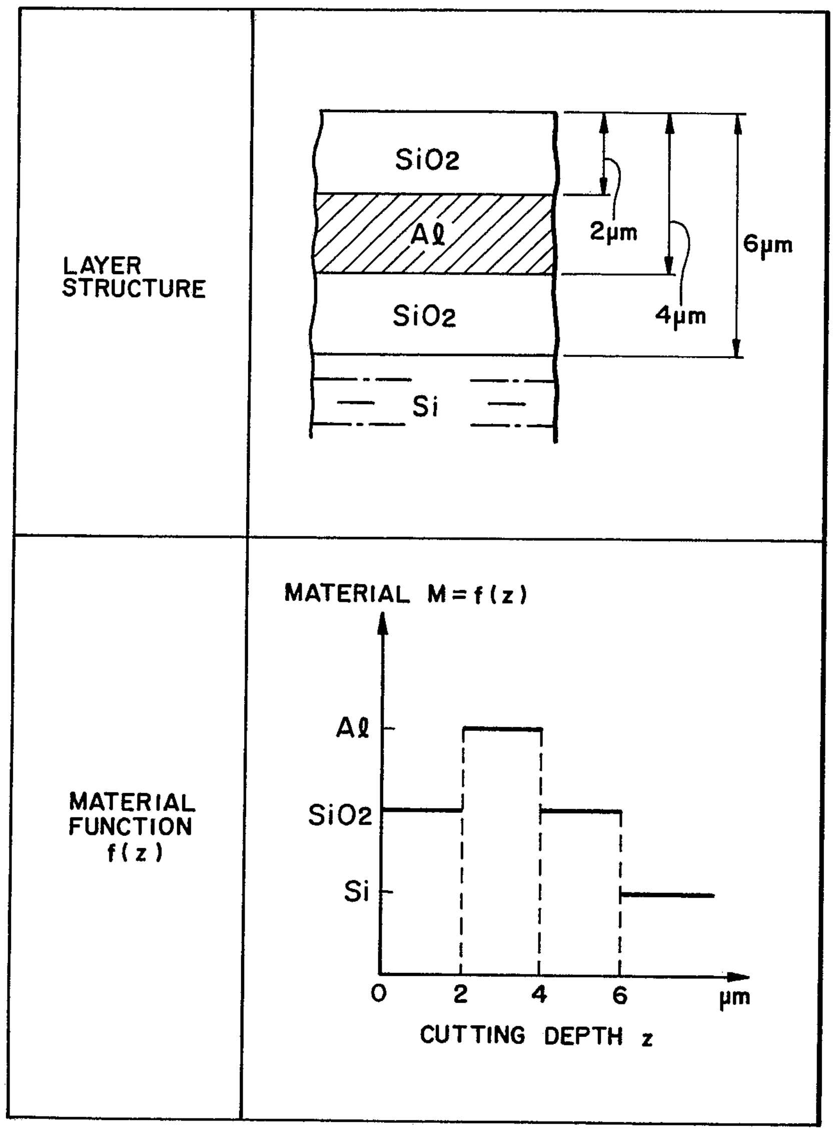

LAYER STRUCTURE
SiO2
Aℓ
SiO2
Si
2μm
4μm
6μm
MATERIAL FUNCTION f(z)
MATERIAL M=f(z)
Aℓ
SiO2
Si
0
2
4
6
μm
CUTTING DEPTH z


FIG. 1I

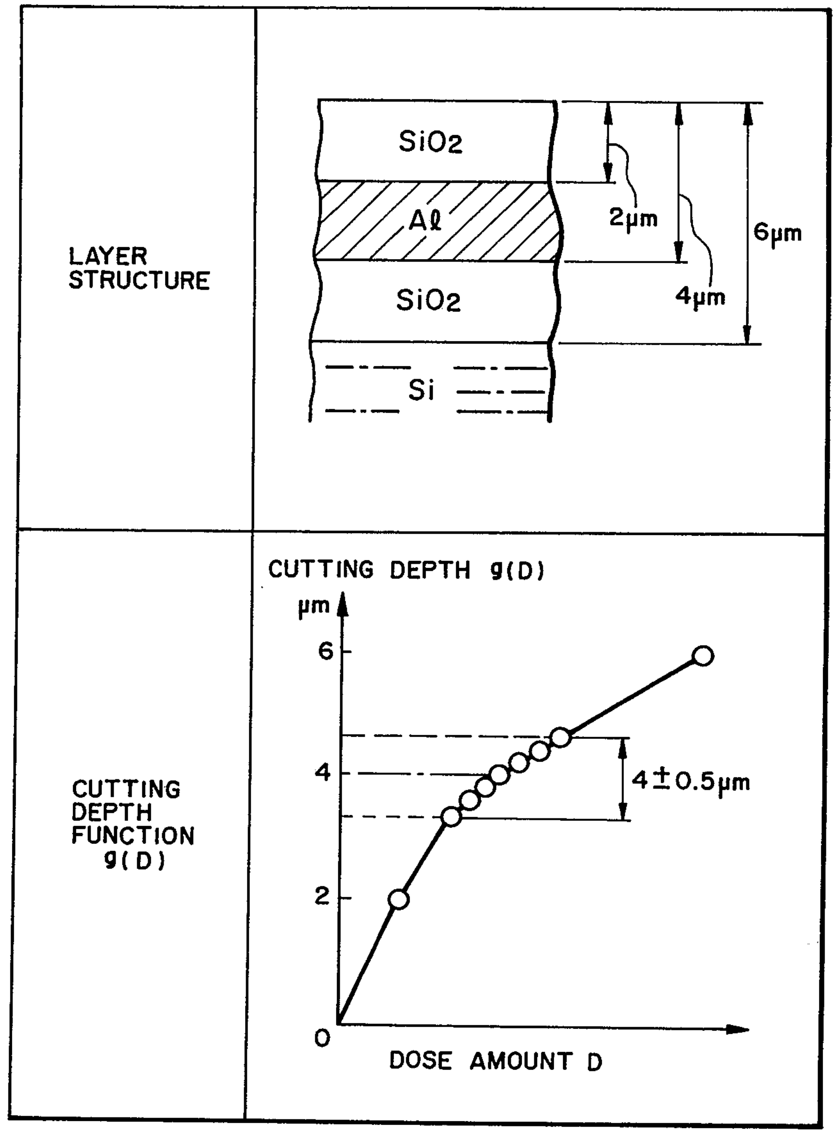

LAYER STRUCTURE
SiO2
Aℓ
SiO2
Si
2μm
4μm
6μm
CUTTING DEPTH FUNCTION g(D)
CUTTING DEPTH g(D)
μm
6
4
2
0
4±0.5μm
DOSE AMOUNT D

0295065

FIG. 1J

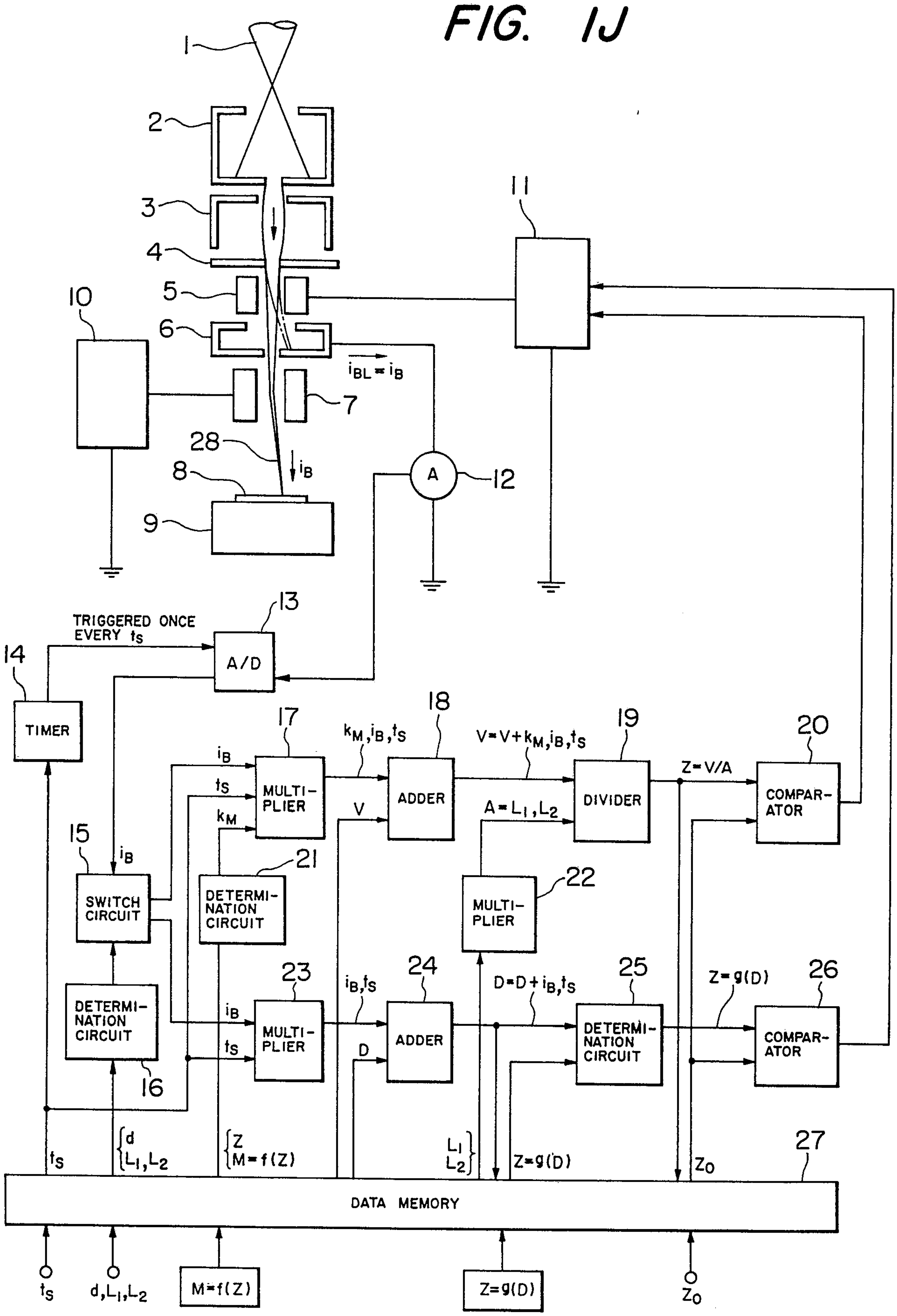

0295065

FIG. 1K

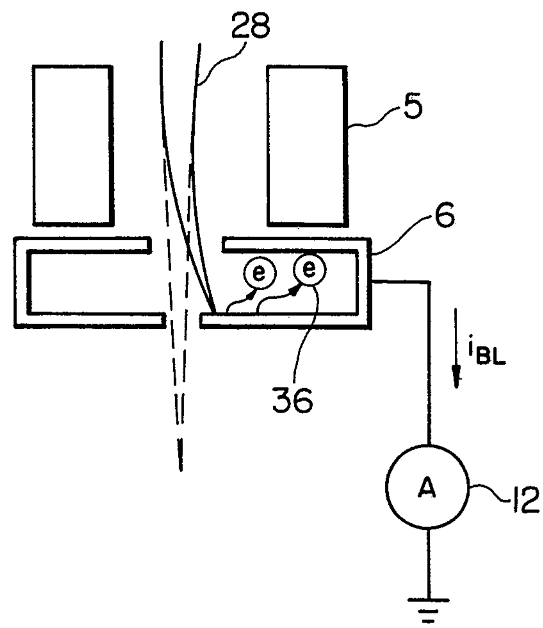


FIG. 1L

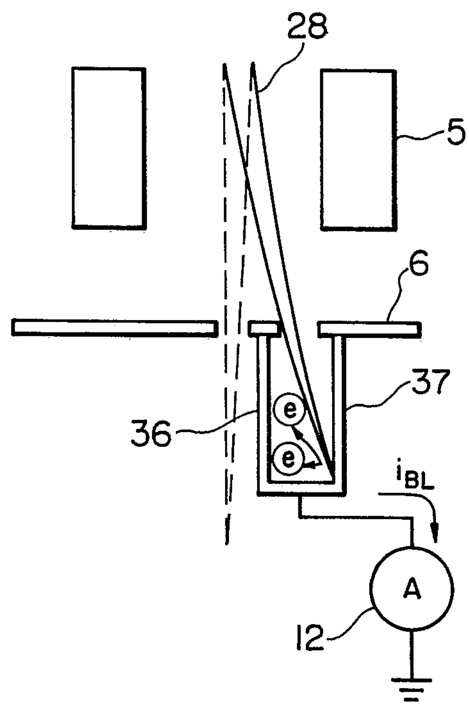


FIG. 1M

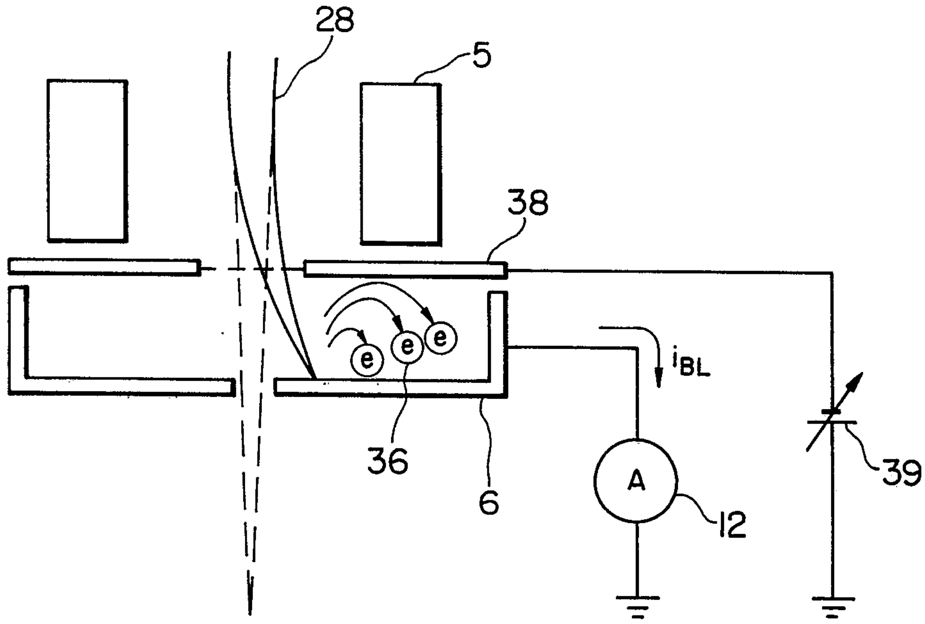

0295065

FIG. 1N

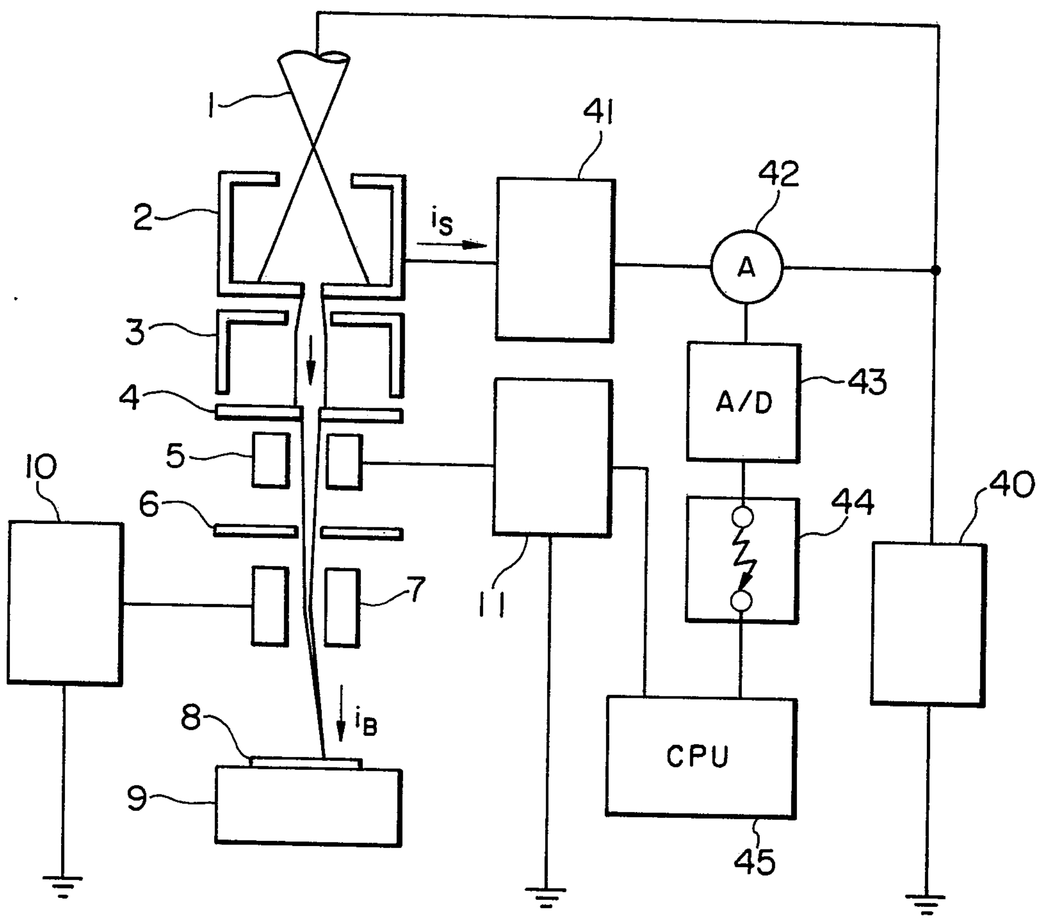


FIG. 10

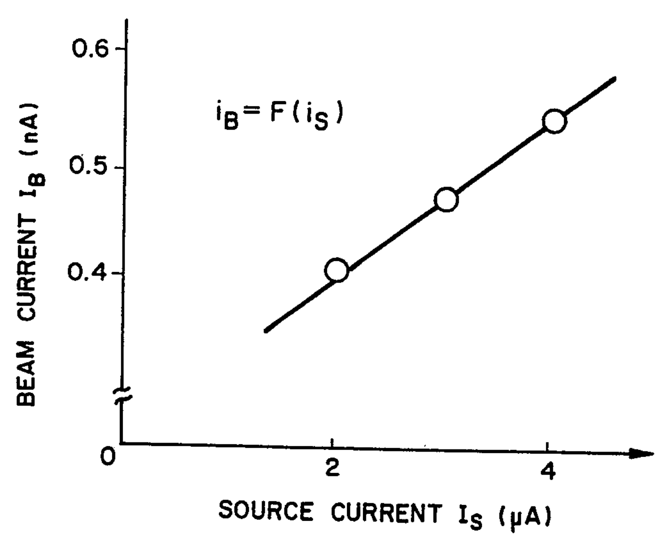

FIG. 1P

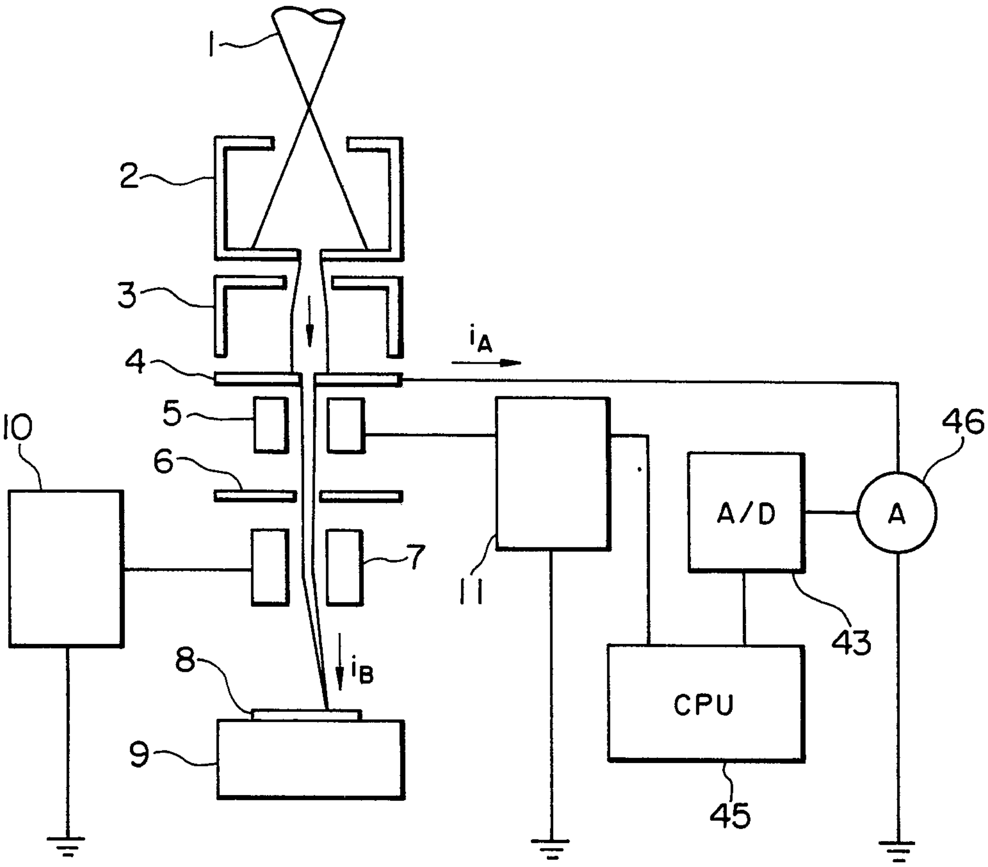
1
2
3
4
5
6
7
8
9
10
11
$i_A$
$i_B$
46
A
A/D
43
CPU
45

FIG. 1Q

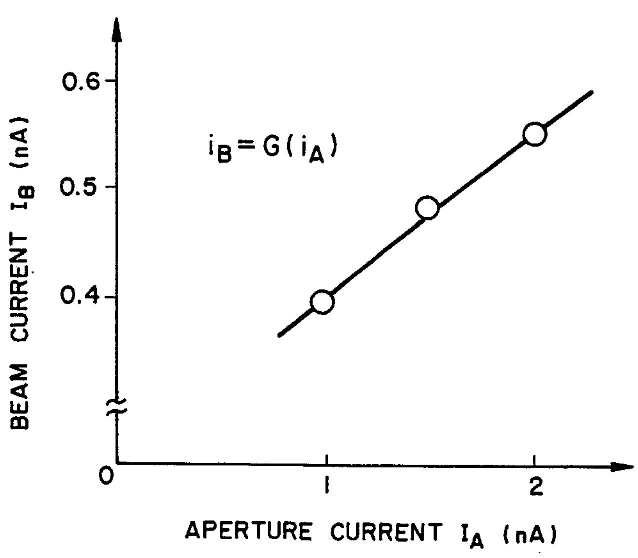
$i_B = G(i_A)$
BEAM CURRENT $I_B$ (nA)
0.6
0.5
0.4
0
1
2
APERTURE CURRENT $I_A$ (nA)

0295065

FIG. 2A

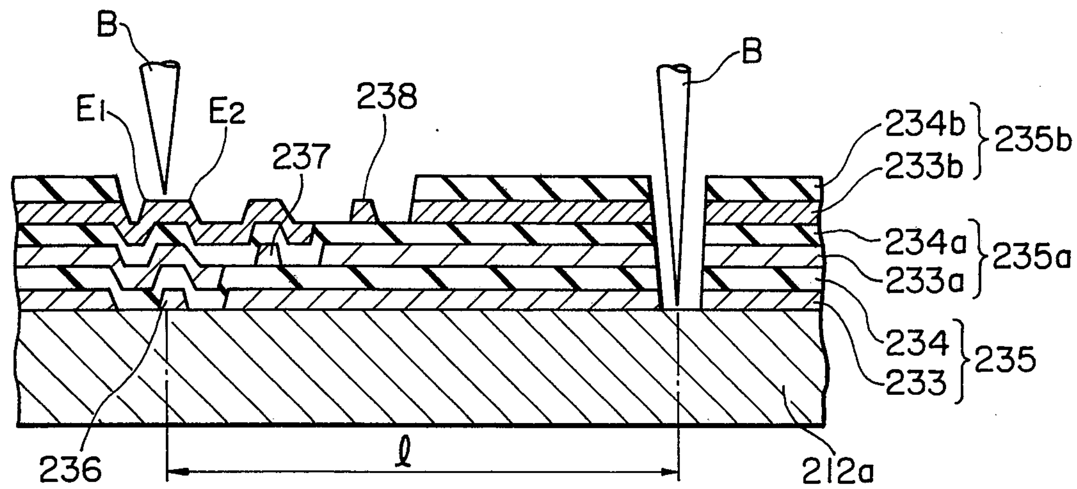


FIG. 2B

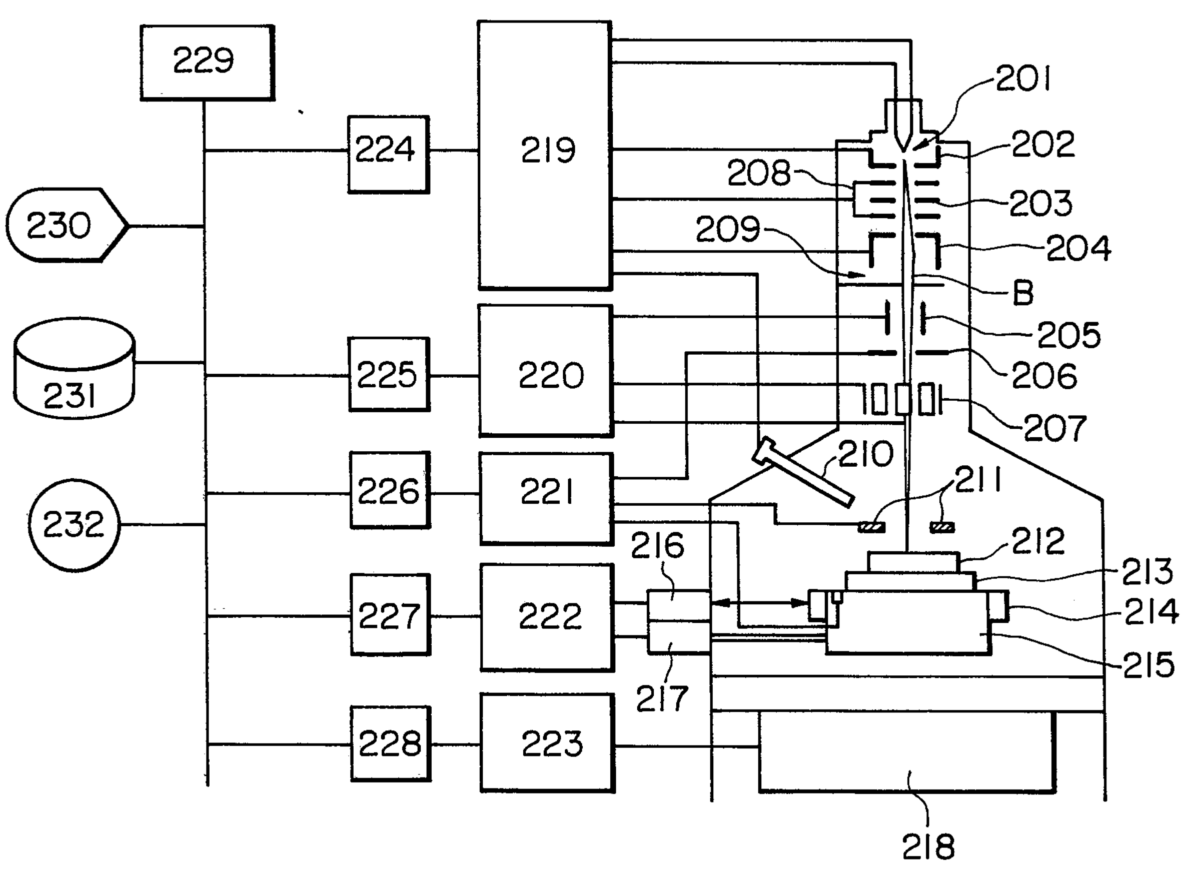

FIG. 2C

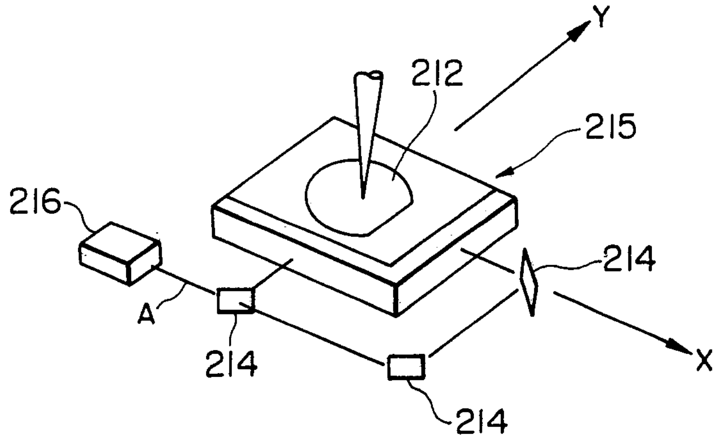


FIG. 2D

(a)

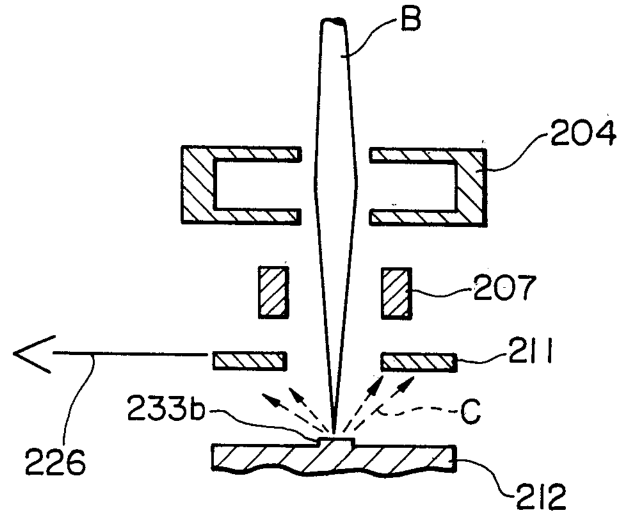


(b)

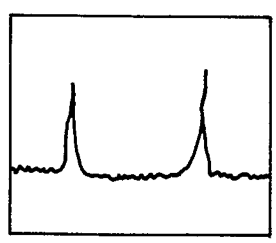

FIG. 2E

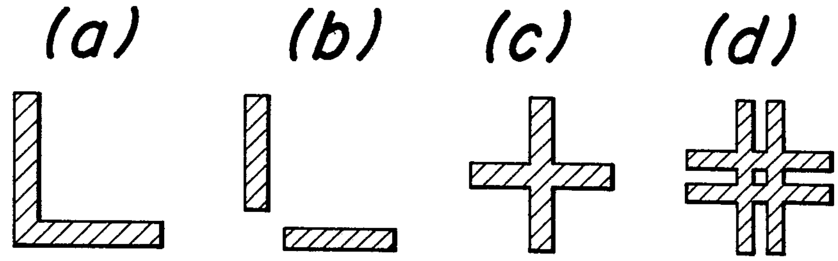


FIG. 2F

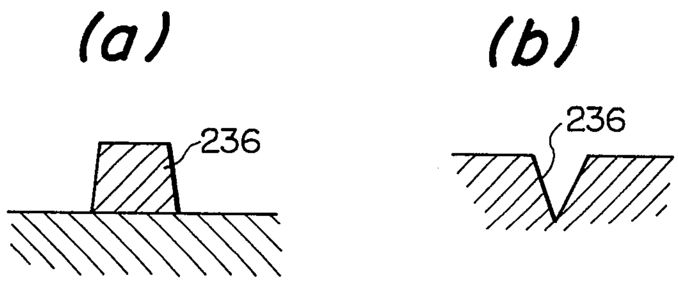


FIG. 2G

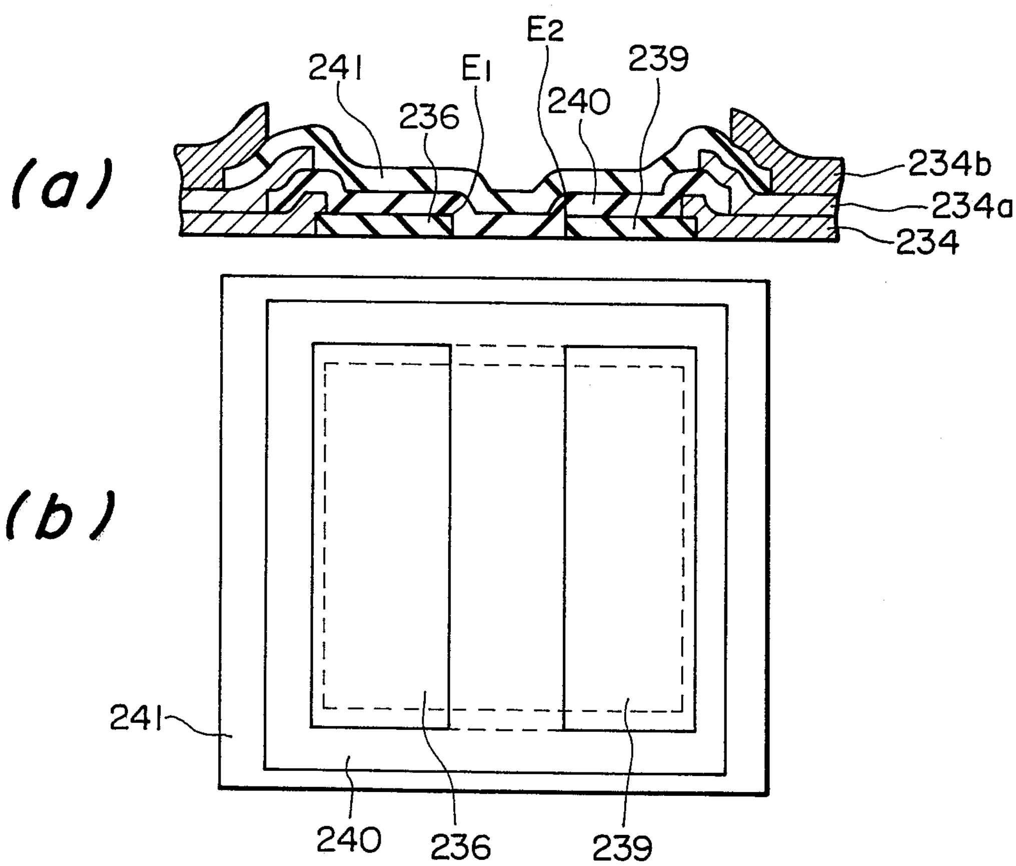

FIG. 2H

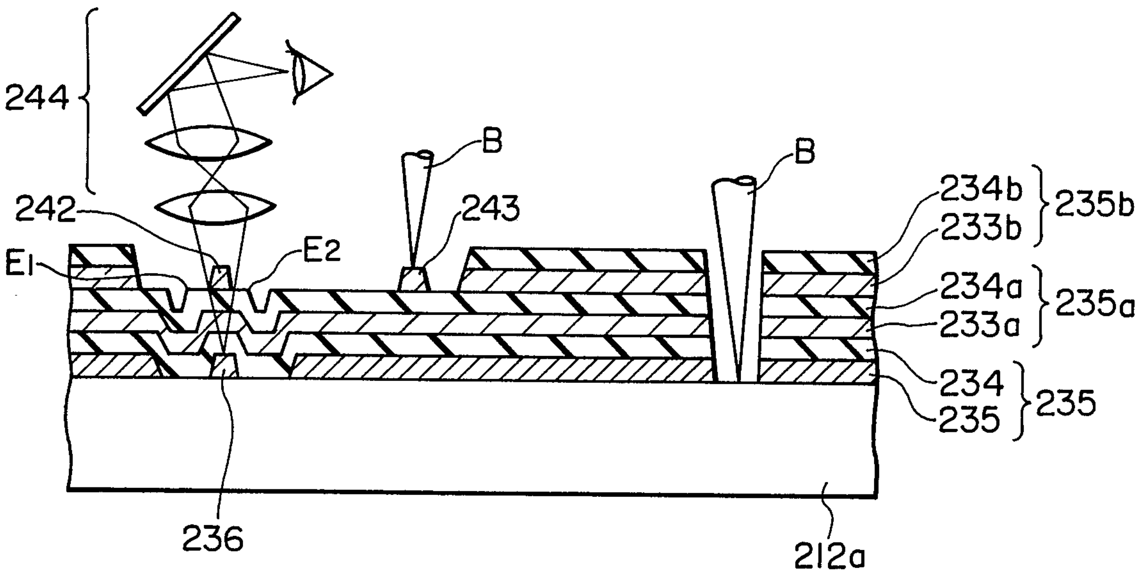
244
B
B
242
243
E1
E2
234b
233b
235b
234a
233a
235a
234
235
235
236
212a

FIG. 2I

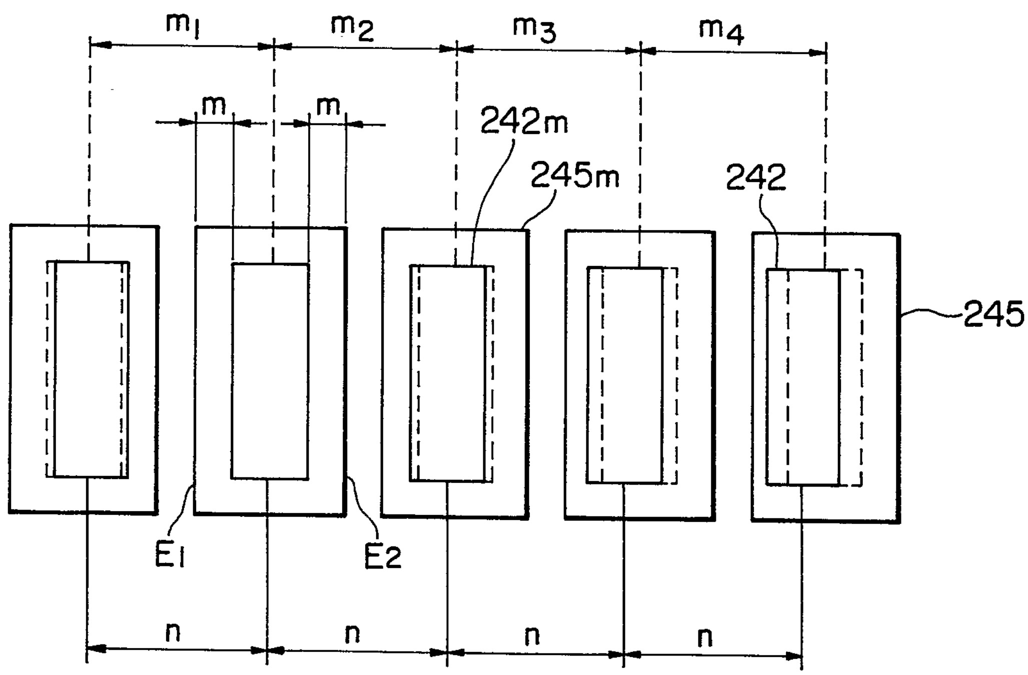
m1
m2
m3
m4
m
m
242m
245m
242
245
E1
E2
n
n
n
n

FIG. 3A

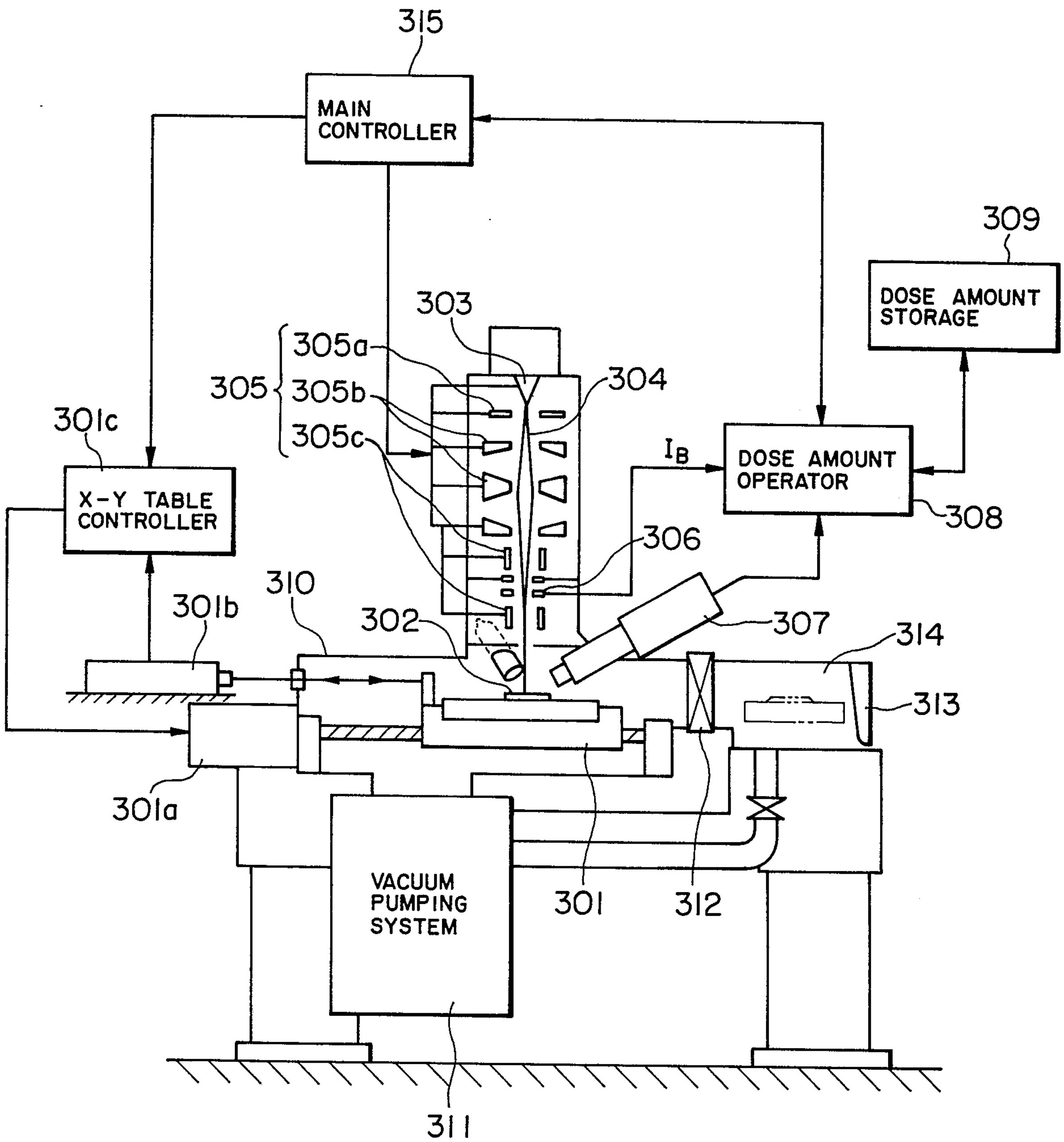
315
MAIN CONTROLLER
309
DOSE AMOUNT STORAGE
303
305
305a
305b
305c
304
301c
X-Y TABLE CONTROLLER
$I_B$
DOSE AMOUNT OPERATOR
308
306
310
301b
302
307
314
313
301a
VACUUM PUMPING SYSTEM
301
312
311

0295065

FIG. 3B

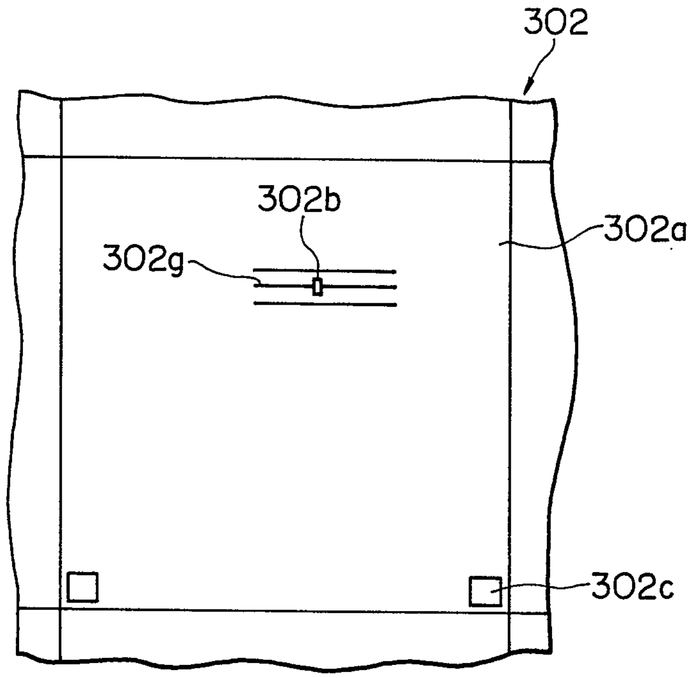


FIG. 3C

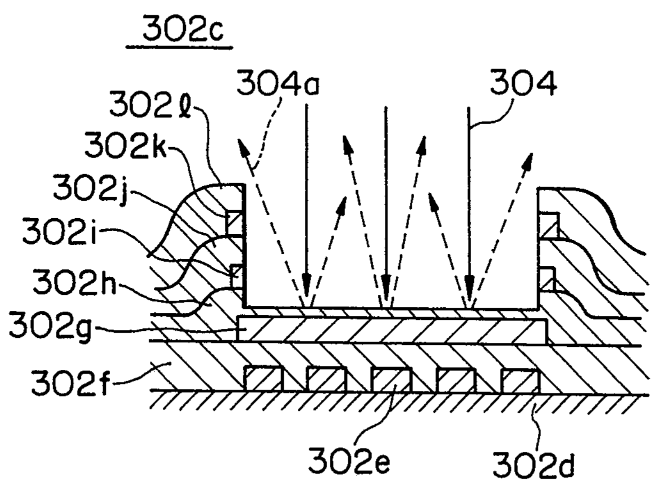


FIG. 3D

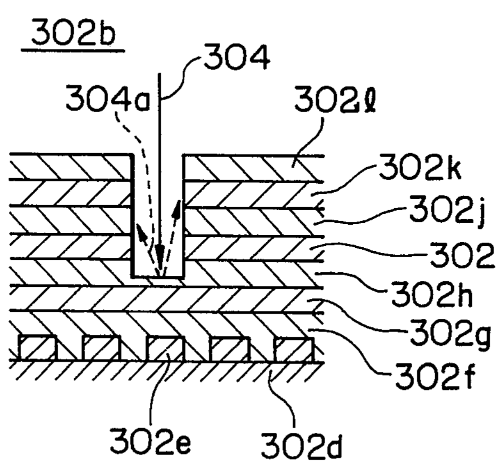

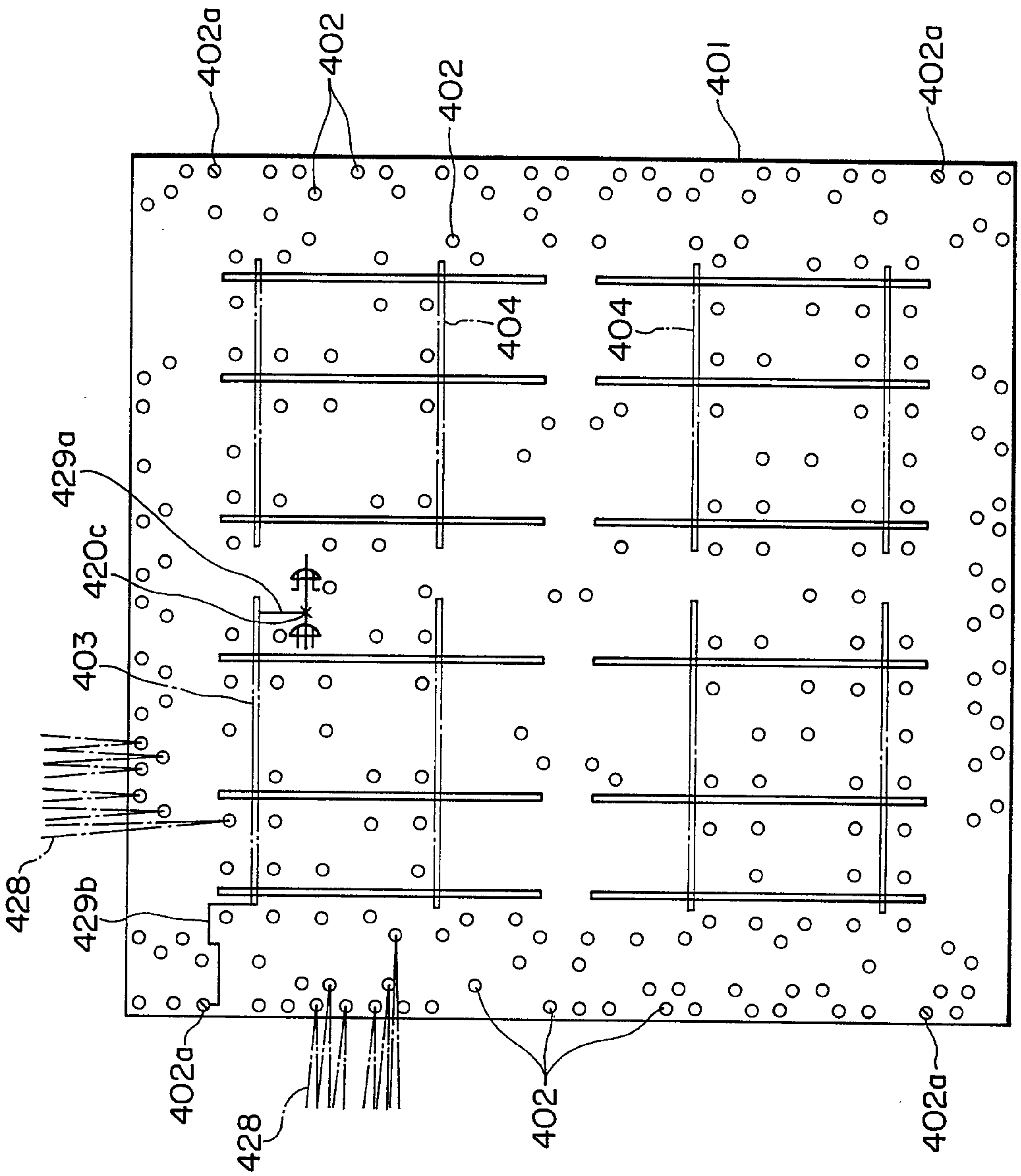
402a
402
402
401
402a
404
404
429a
420c
403
428
429b
402a
428
402
402a

FIG. 4A

FIG. 4B

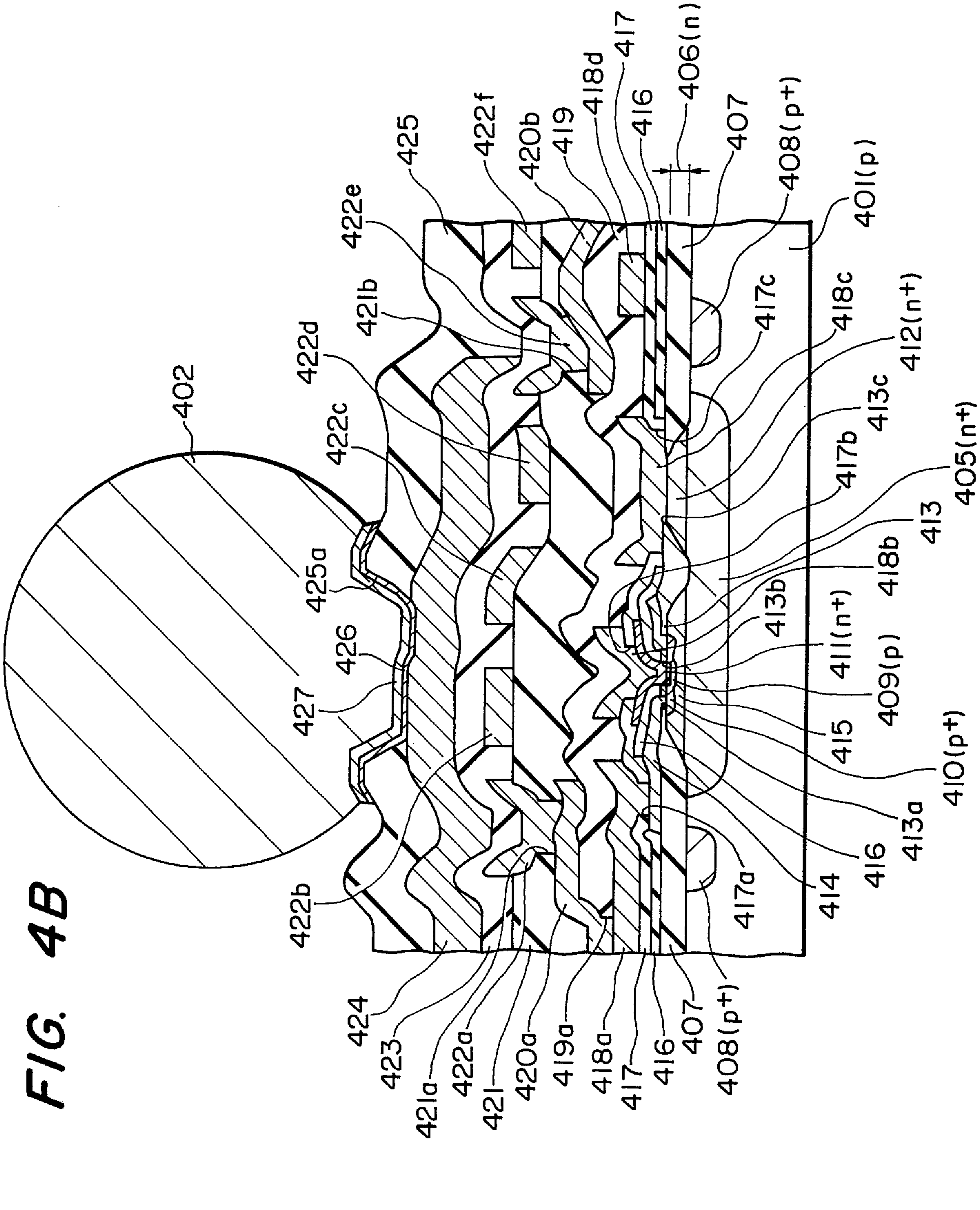

402
425a
426
427
422e
425
422f
420b
419
418d
417
416
406(n)
407
408(p+)
401(p)
421b
422d
422c
417c
418c
412(n+)
413c
417b
405(n+)
413
418b
413b
411(n+)
409(p)
415
410(p+)
413a
416
414
417a
422b
424
423
421a
422a
421
420a
419a
418a
417
416
407
408(p+)

0295065

FIG. 4C

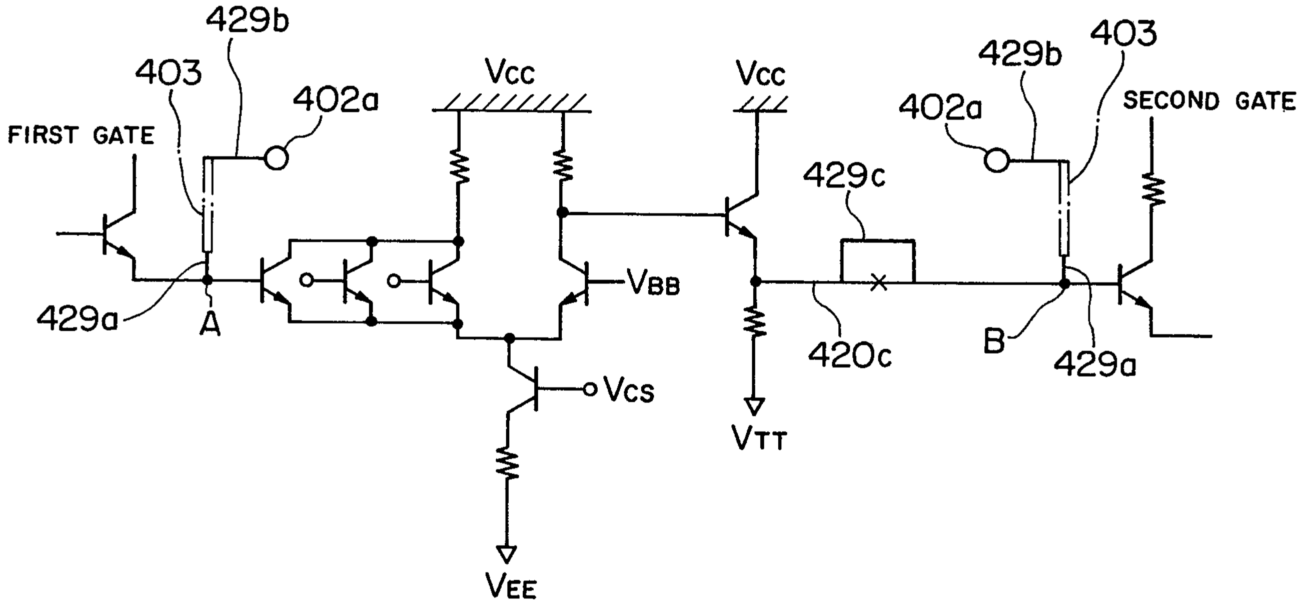


FIG. 4D

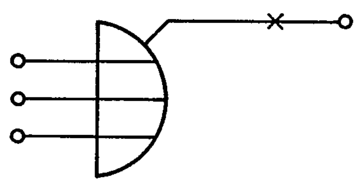

0295065

FIG. 4E

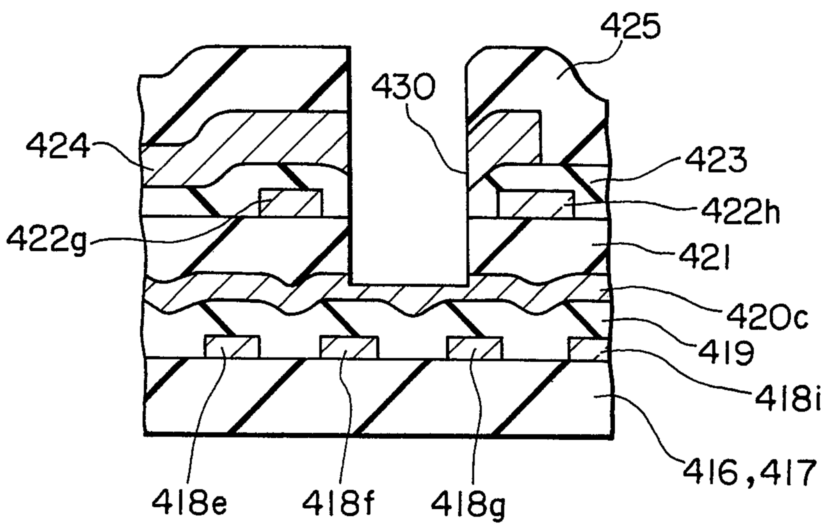


FIG. 4F

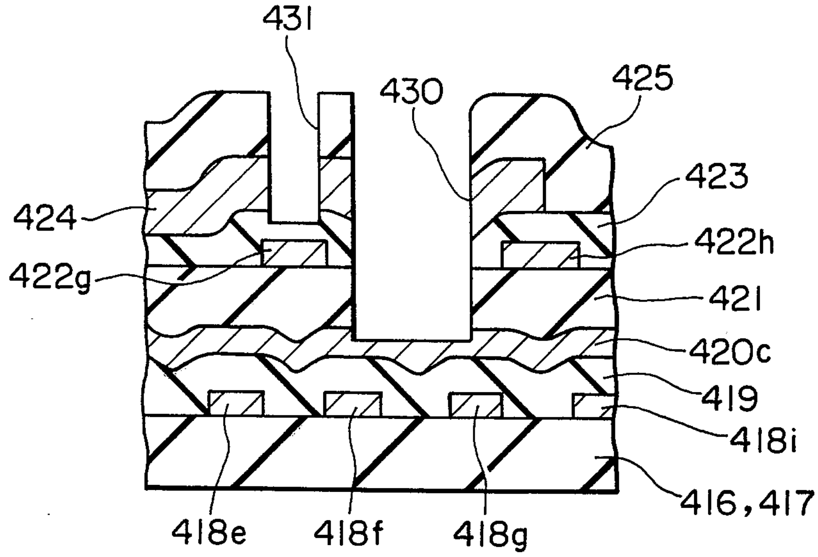

FIG. 4G

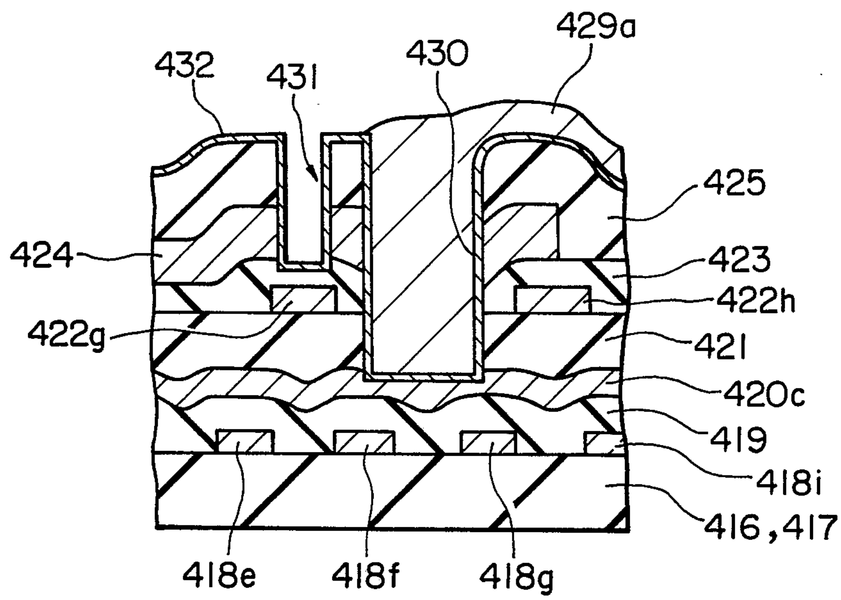
432
431
430
429a
425
424
423
422h
422g
421
420c
419
418i
416,417
418e
418f
418g

FIG. 4H

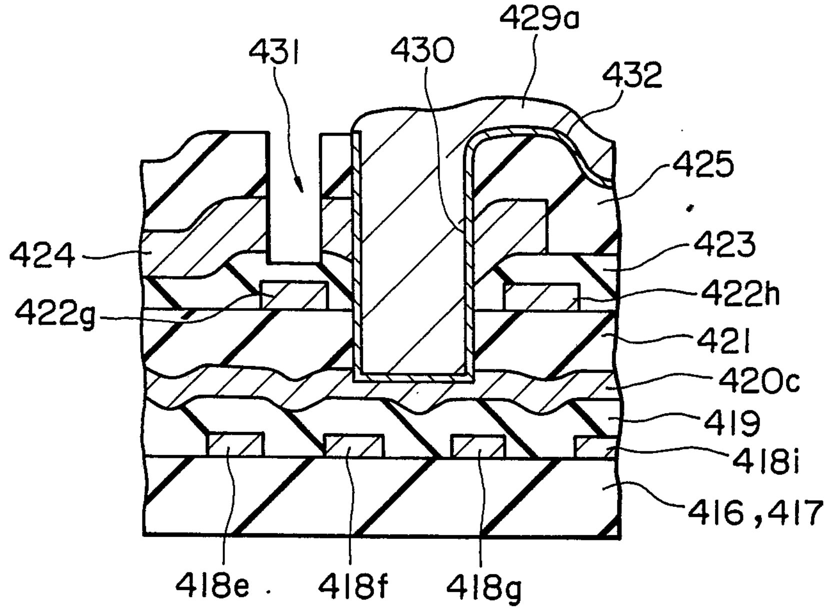
431
430
429a
432
425
424
423
422h
422g
421
420c
419
418i
416,417
418e
418f
418g

0295065

FIG. 4I

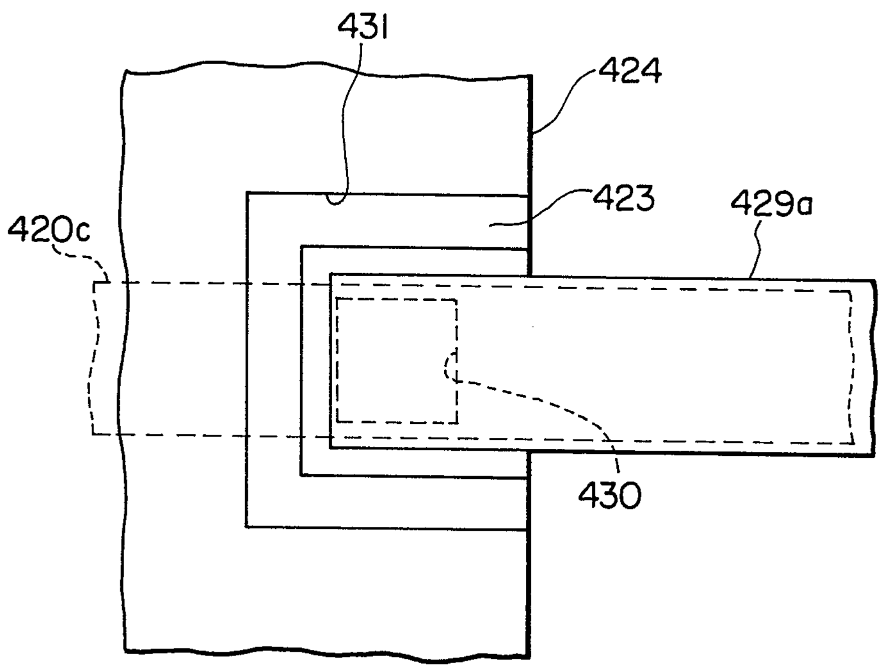


FIG. 4J

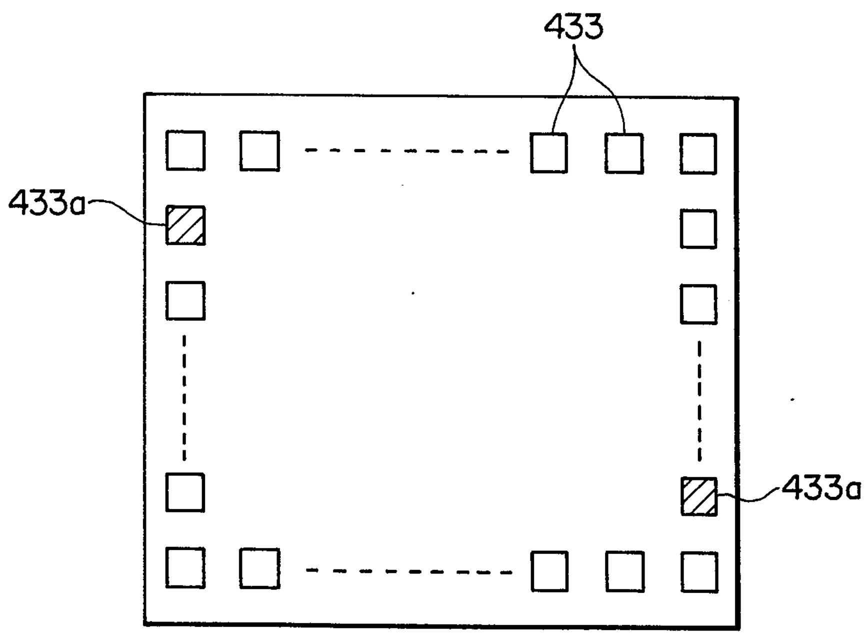

0295065

FIG. 5A

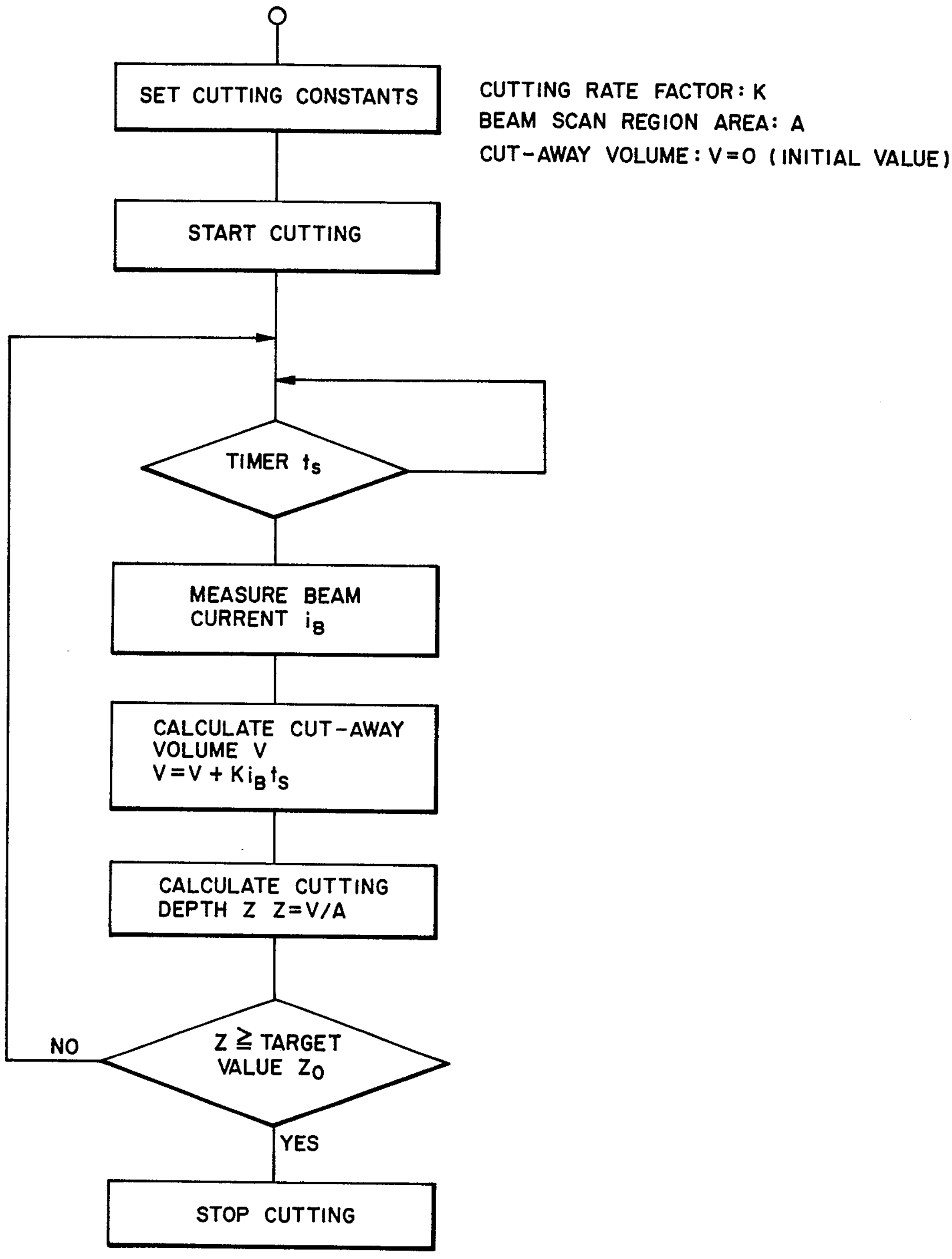

FIG. 5B

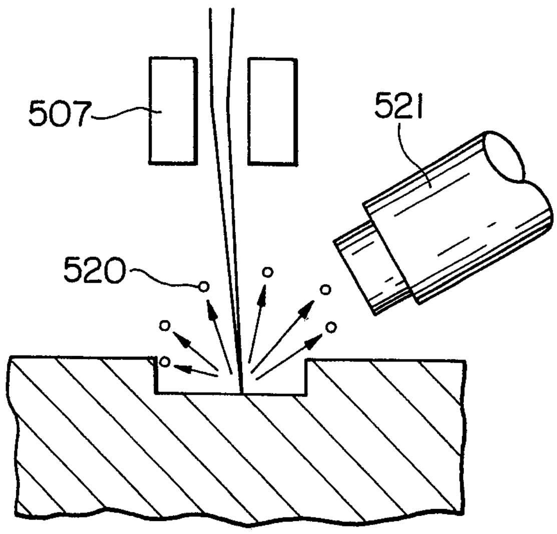


FIG. 5C

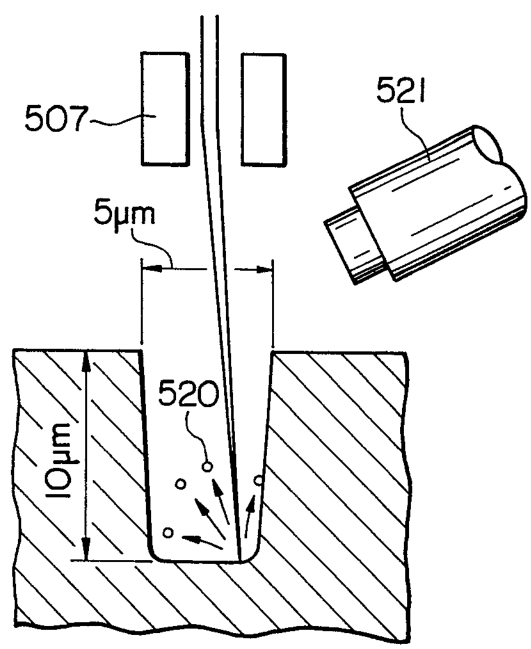


FIG. 5D

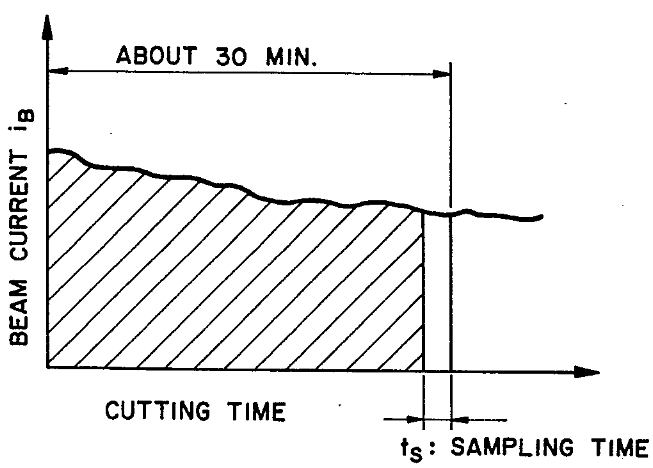

FIG. 5E

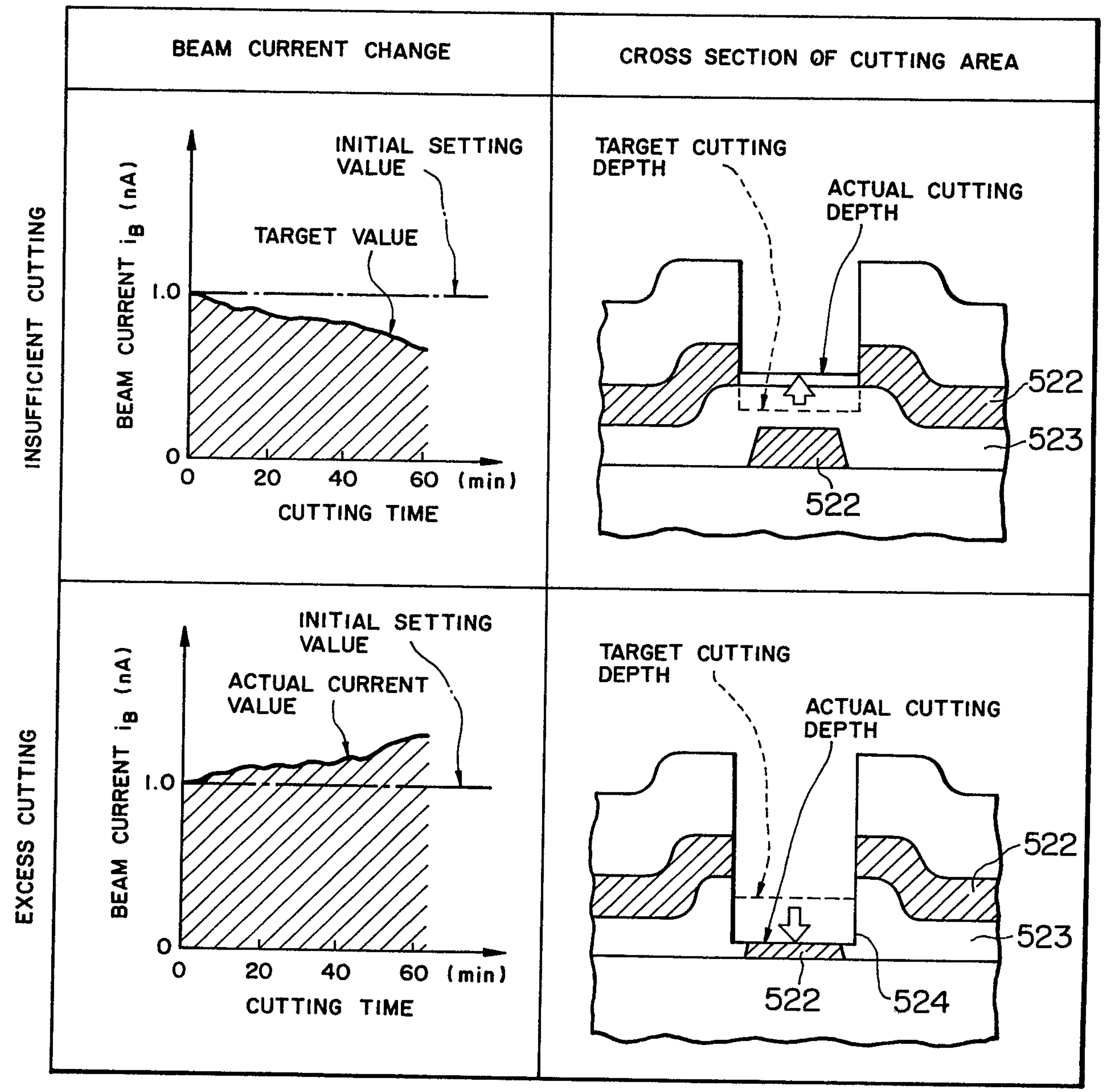

BEAM CURRENT CHANGE
CROSS SECTION OF CUTTING AREA
INSUFFICIENT CUTTING
INITIAL SETTING VALUE
TARGET VALUE
BEAM CURRENT $i_B$ (nA)
1.0
0
0 20 40 60 (min)
CUTTING TIME
TARGET CUTTING DEPTH
ACTUAL CUTTING DEPTH
522
523
522
EXCESS CUTTING
INITIAL SETTING VALUE
ACTUAL CURRENT VALUE
BEAM CURRENT $i_B$ (nA)
1.0
0
0 20 40 60 (min)
CUTTING TIME
TARGET CUTTING DEPTH
ACTUAL CUTTING DEPTH
522
523
522
524

FIG. 5G

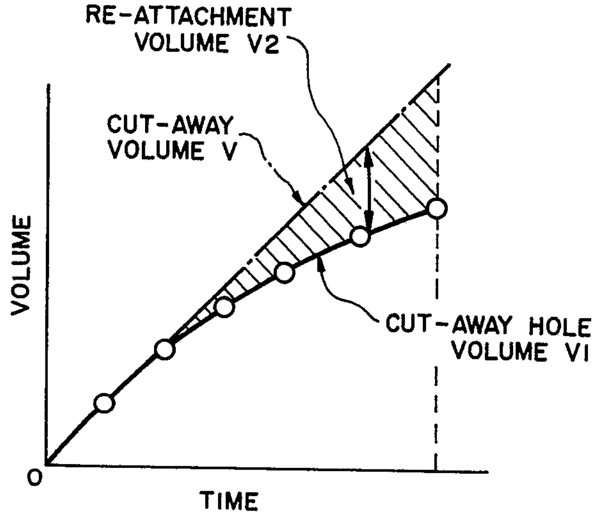


FIG. 5F

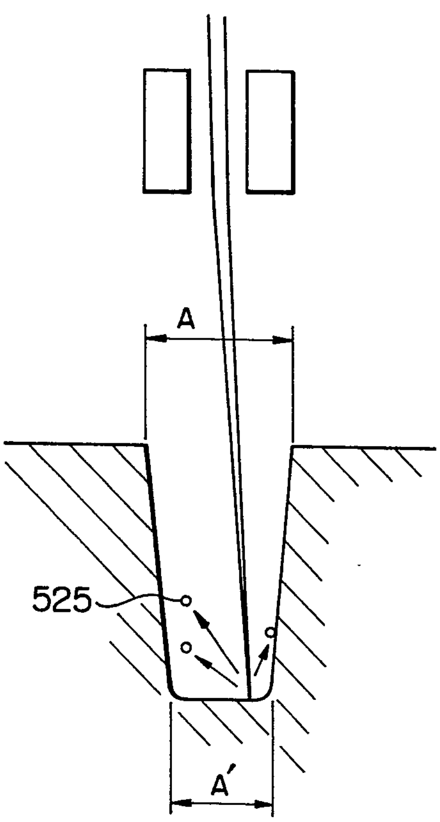


FIG. 5H

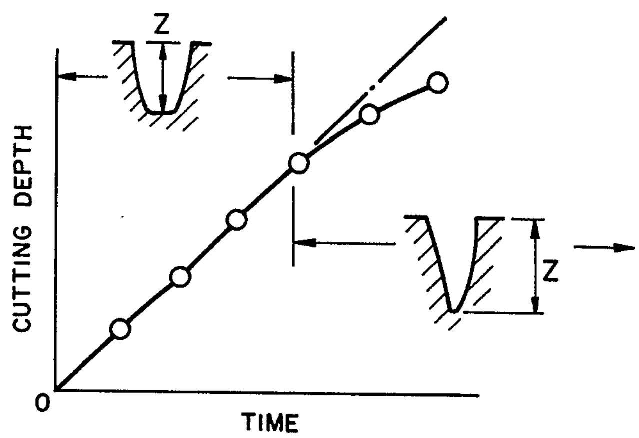

FIG. 5I

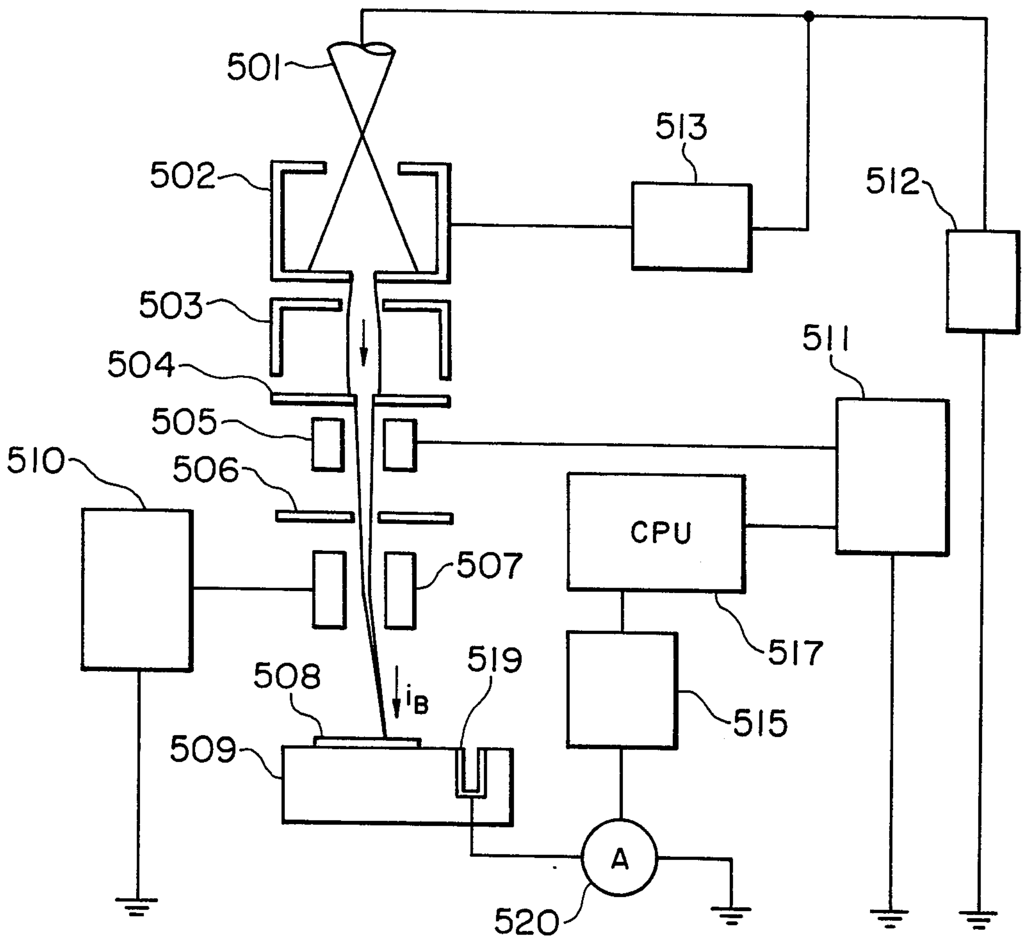
501
502
503
504
505
506
507
508
509
510
511
512
513
CPU
517
515
519
$i_B$
A
520

FIG. 5J

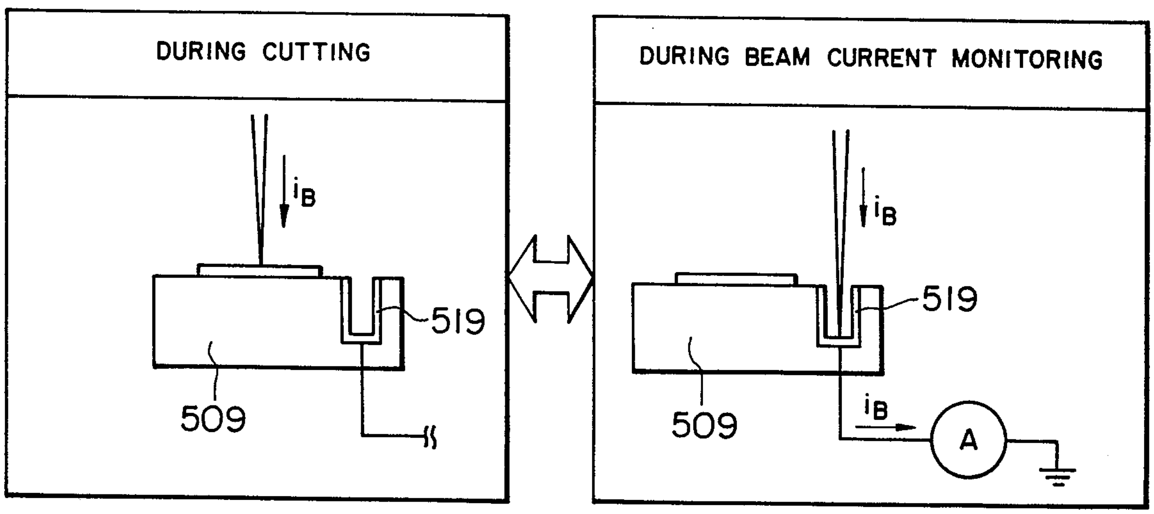
DURING CUTTING
$i_B$
519
509
DURING BEAM CURRENT MONITORING
$i_B$
519
509
$i_B$
A

FIG. 5K

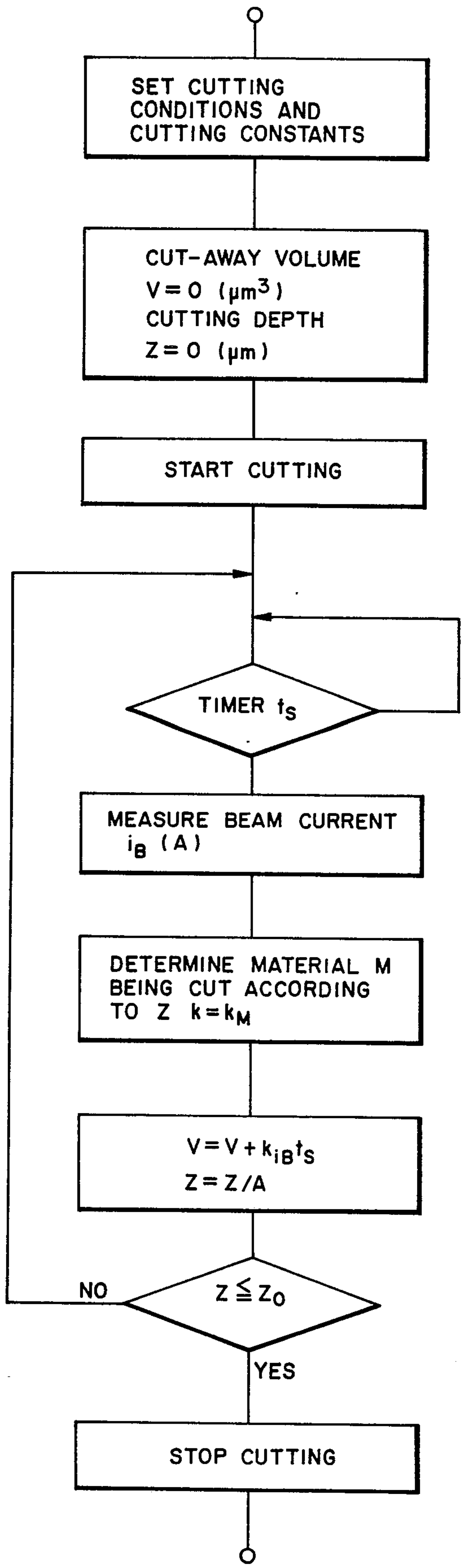


$k_M$: CUTTING RATE FACTOR OF MATERIAL M ($\mu m^3 . A^{-1} . sec^{-1}$)

A: BEAM SCAN AREA ($\mu m^2$)

$Z_0$: TARGET DEPTH ($\mu m$)

FIG. 5L

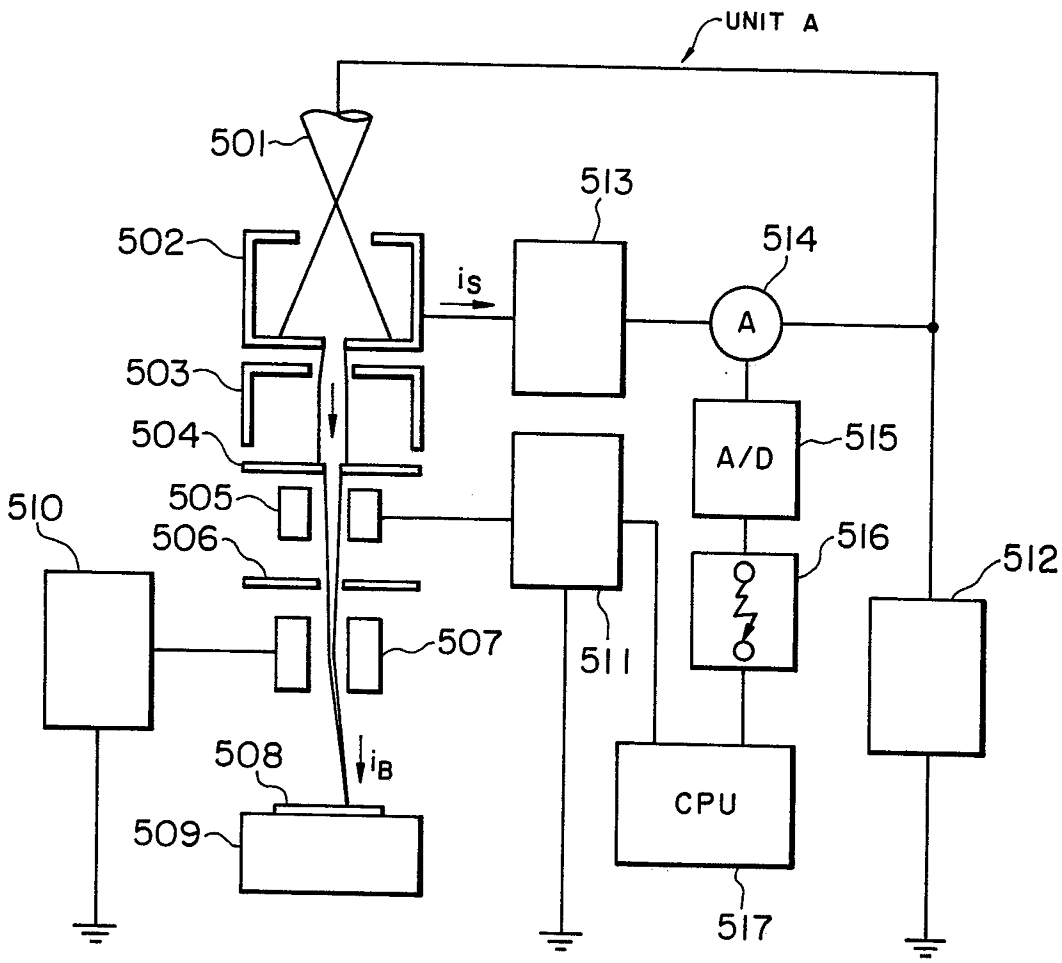


FIG. 5M

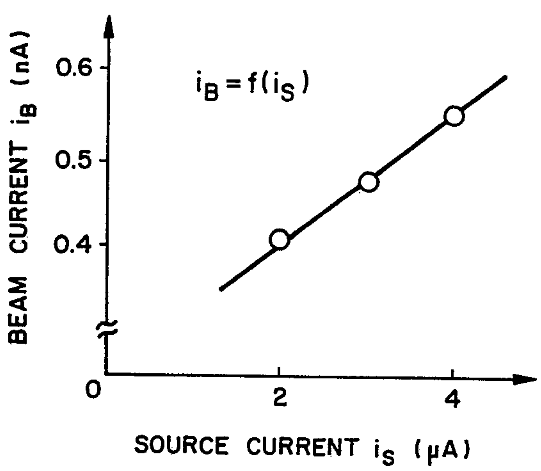


FIG. 5P

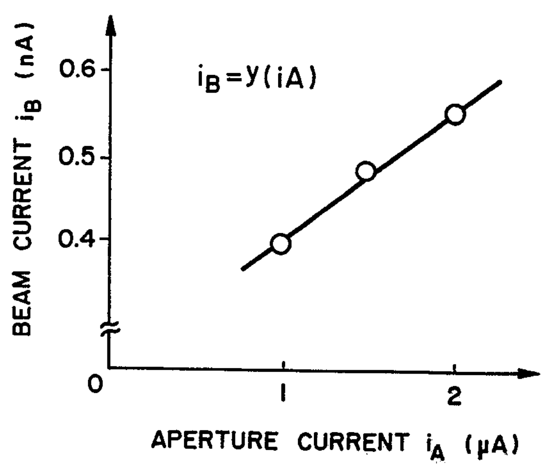

FIG. 5N

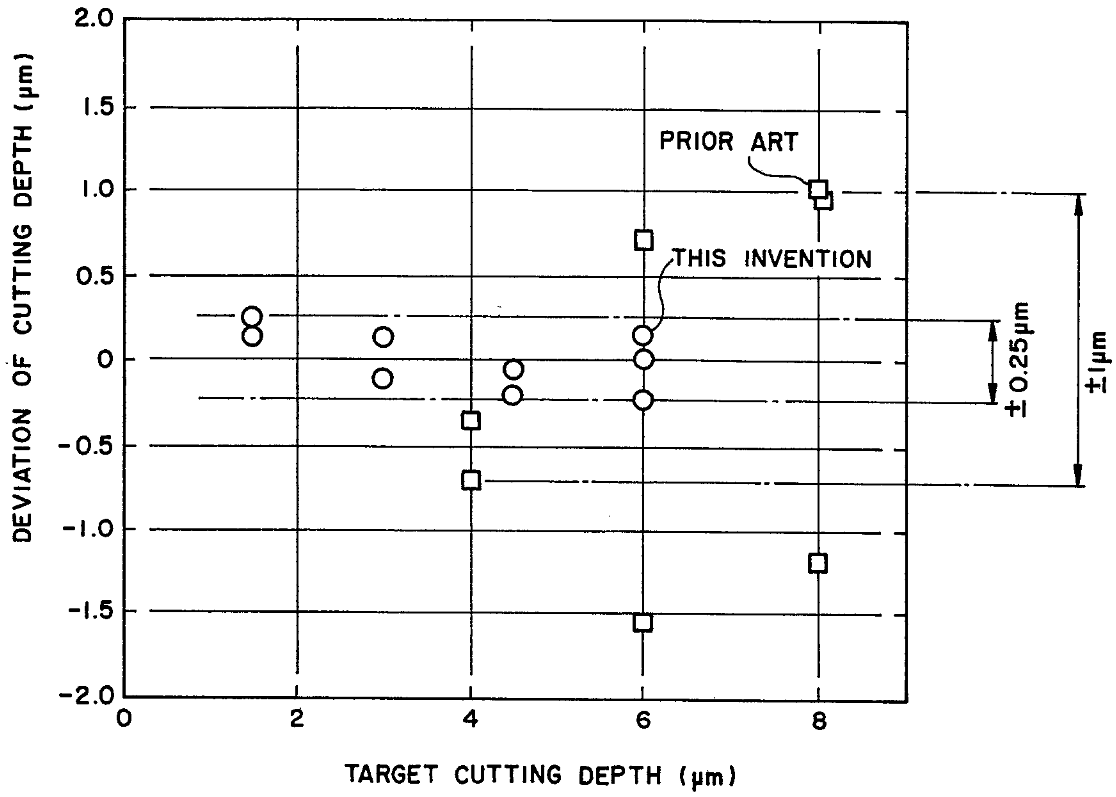
2.0
1.5
1.0
0.5
0
-0.5
-1.0
-1.5
-2.0
DEVIATION OF CUTTING DEPTH (μm)
0
2
4
6
8
TARGET CUTTING DEPTH (μm)
PRIOR ART
THIS INVENTION
± 0.25μm
±1μm

FIG. 5O

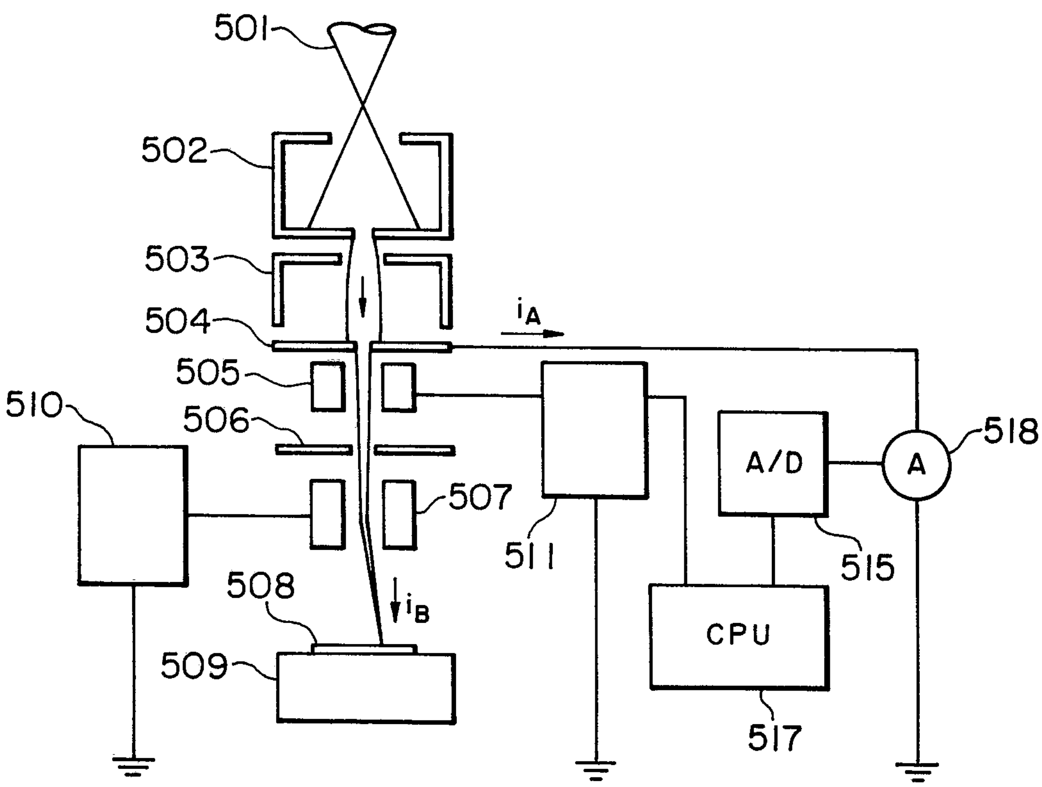
501
502
503
504
505
506
507
508
509
510
511
515
517
518
$i_A$
$i_B$
A/D
A
CPU

FIG. 5Q

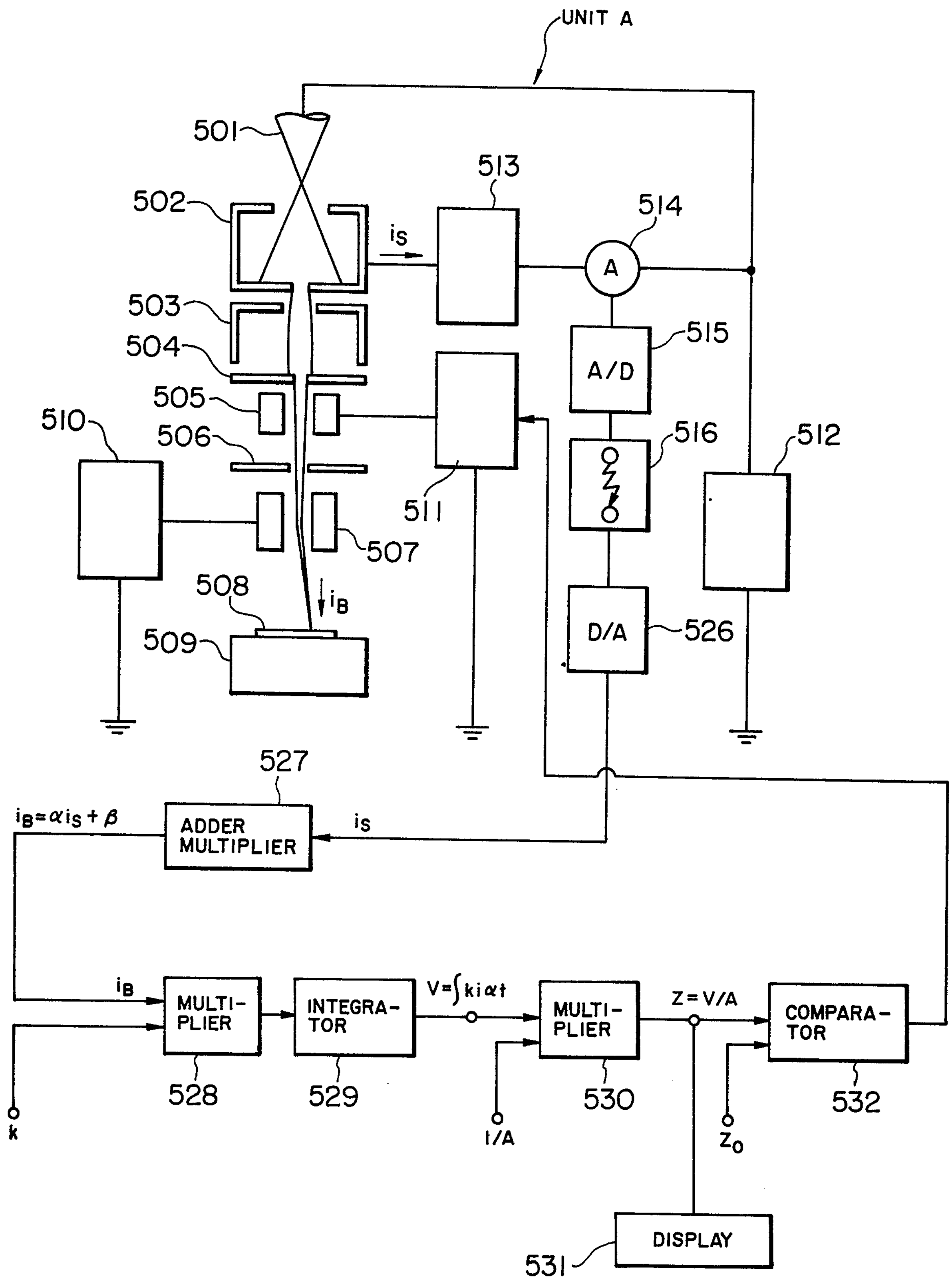
UNIT A
501
502
503
504
505
506
507
508
509
510
511
512
513
514
A
515
A/D
516
526
D/A
is
iB
527
ADDER MULTIPLIER
$i_B = \alpha i_S + \beta$
is
iB
MULTI-PLIER
528
INTEGRA-TOR
529
$V = \int k i \alpha t$
MULTI-PLIER
530
1/A
$Z = V/A$
COMPARA-TOR
532
$Z_0$
k
DISPLAY
531

FIG. 6A

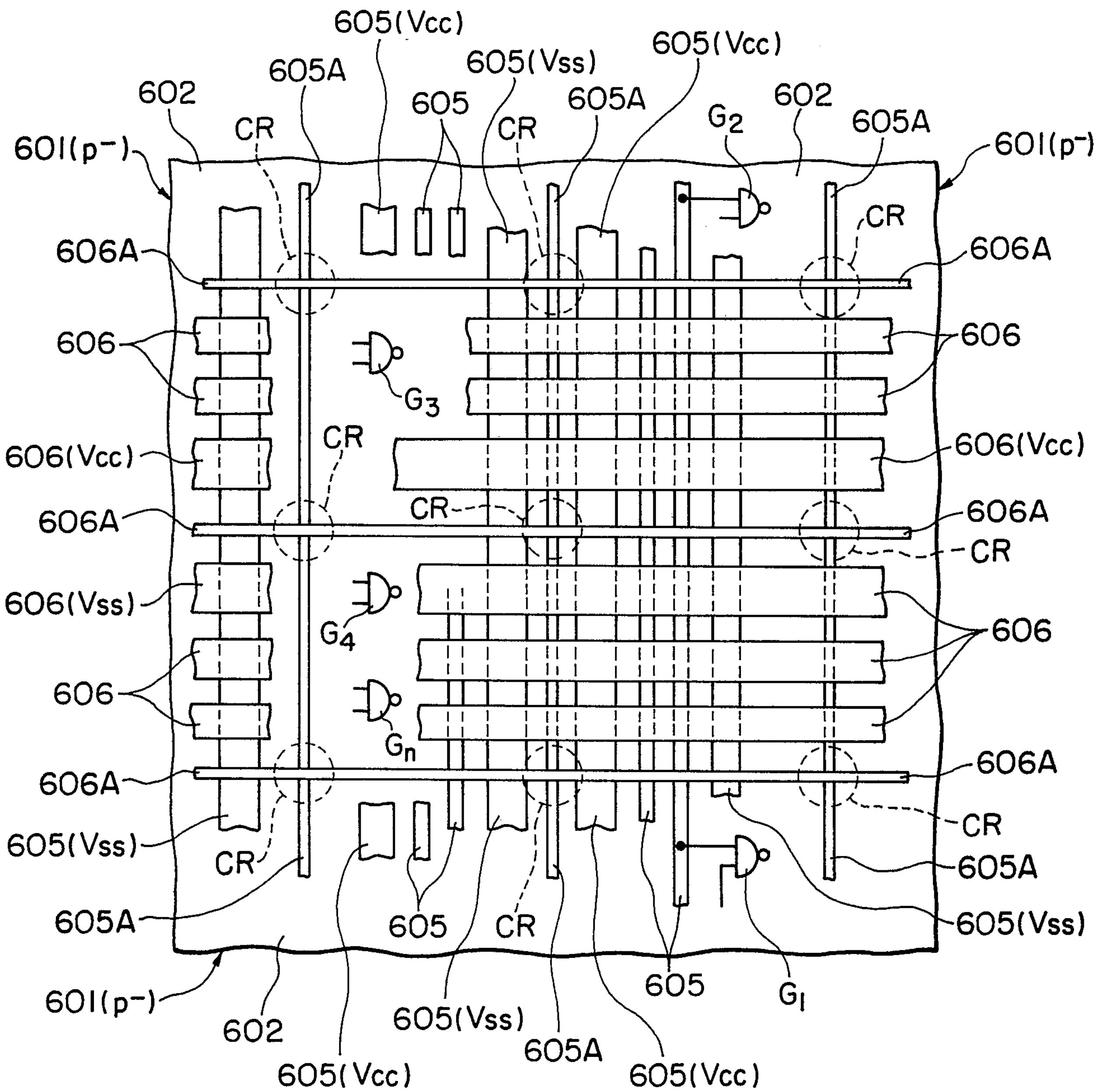
605(Vcc)
605A
605(Vss)
605(Vcc)
602
605
605A
602
CR
CR
G2
605A
601(p-)
601(p-)
CR
606A
606A
606
606
G3
CR
606(Vcc)
606(Vcc)
606A
CR
606A
CR
606(Vss)
G4
606
606
Gn
606A
606A
605(Vss)
CR
CR
605A
605A
605
CR
605(Vss)
605
G1
601(p-)
602
605(Vss)
605A
605(Vcc)
605(Vcc)

FIG. 6B

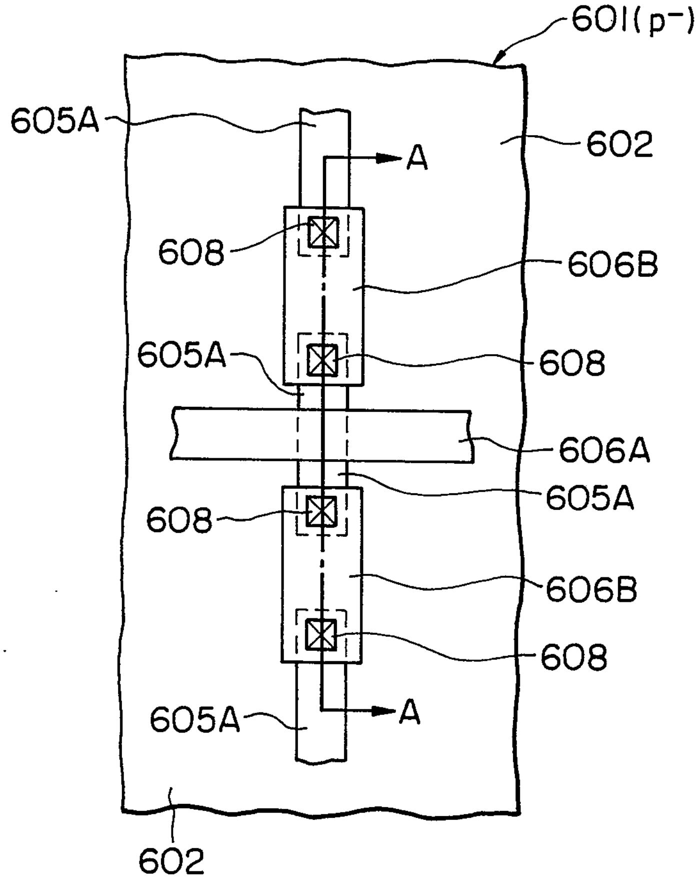
601(p⁻)
605A
A
602
608
606B
605A
608
606A
605A
608
606B
608
605A
A
602

FIG. 6C

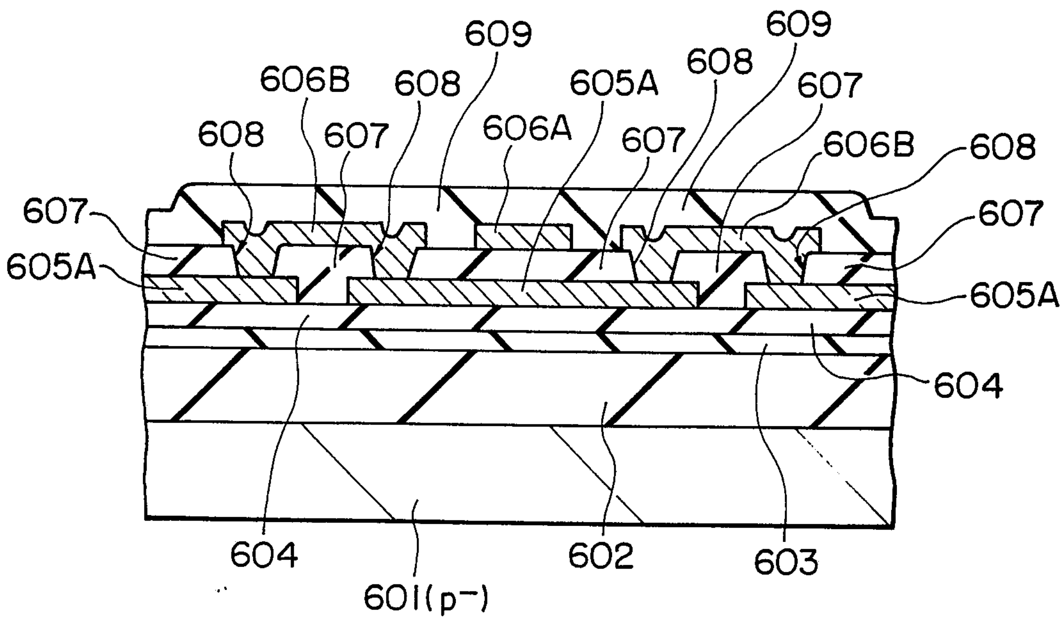
609
609
606B
608
605A
608
607
608
607
606A
607
606B
608
607
607
605A
605A
604
604
602
603
601(p⁻)

FIG. 6D

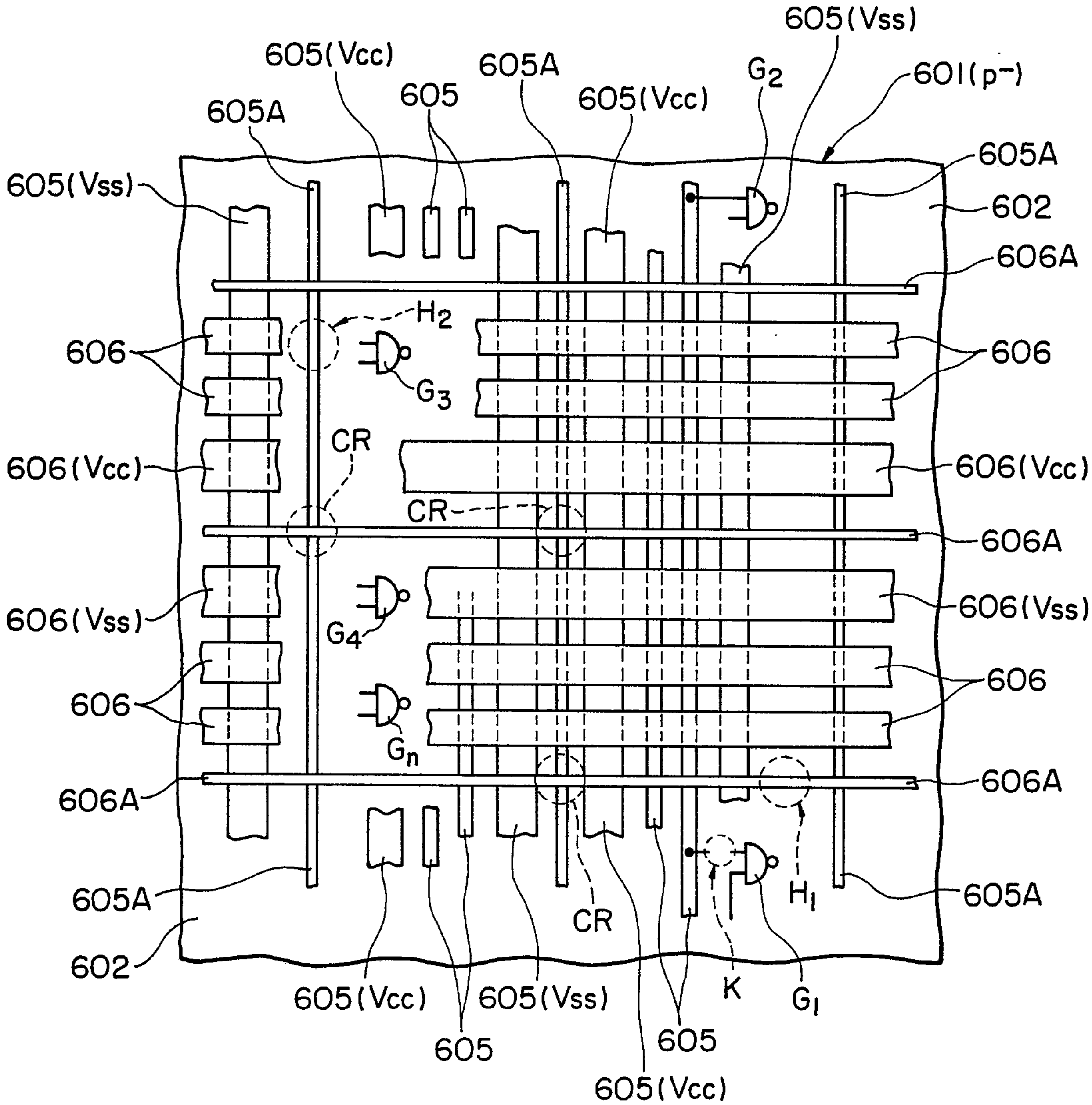

605(Vss)
605(Vcc)
605A
605
605A
605(Vcc)
G2
605(Vss)
601(p−)
605A
602
606A
606
606
H2
G3
CR
606(Vcc)
606(Vcc)
CR
606A
606(Vss)
606(Vss)
G4
606
606
Gn
606A
606A
605A
605A
CR
H1
602
K
G1
605(Vcc)
605(Vss)
605
605
605(Vcc)

FIG. 6E

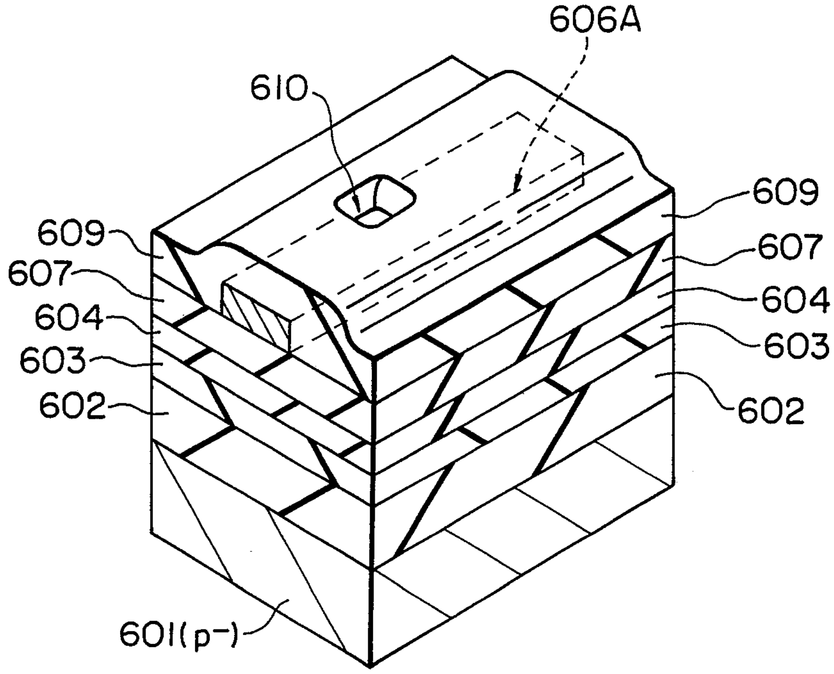
606A
610
609
607
604
603
602
609
607
604
603
602
601(p-)

FIG. 6F

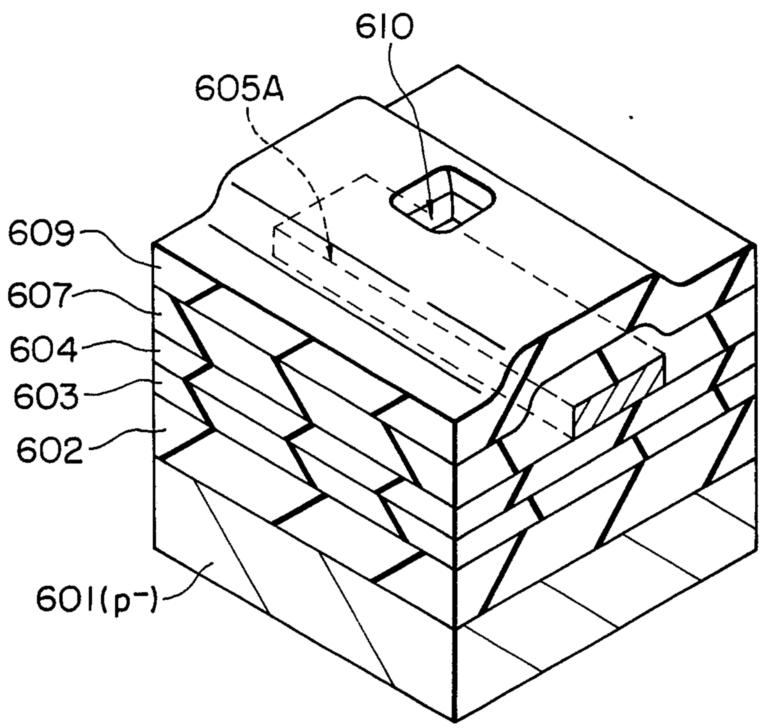
610
605A
609
607
604
603
602
601(p-)

0295065

FIG. 6G

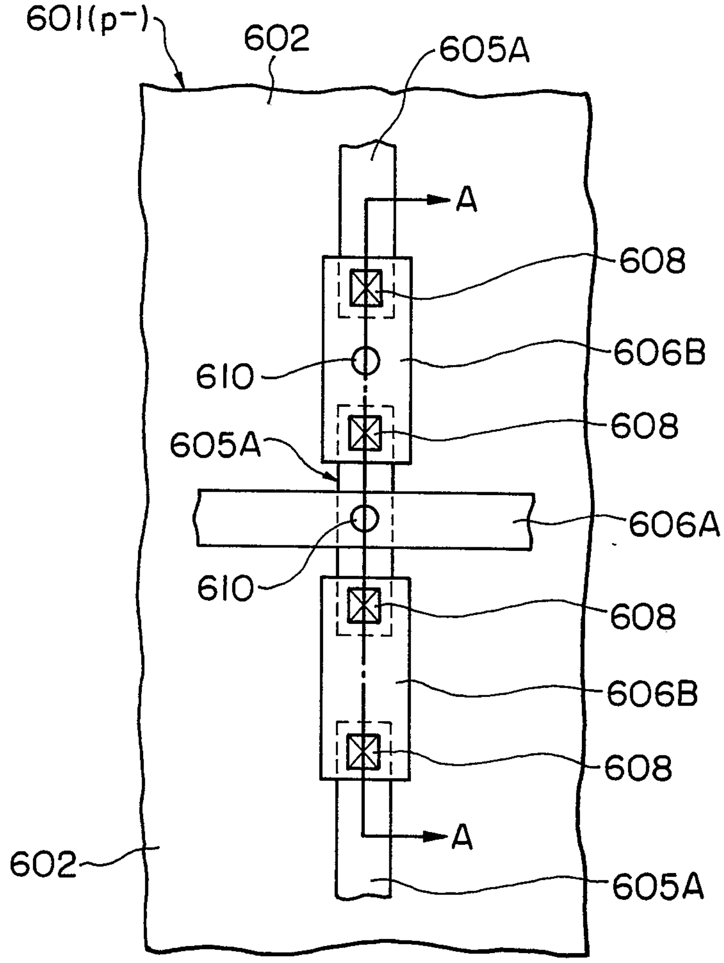


FIG. 6H

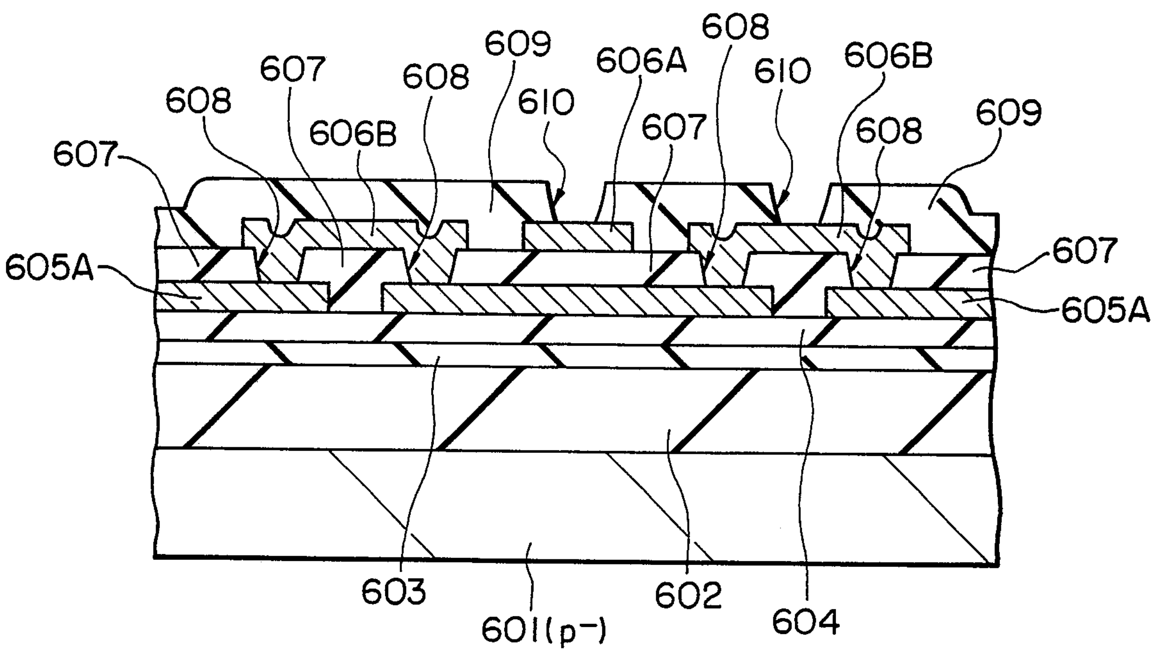

FIG. 6I

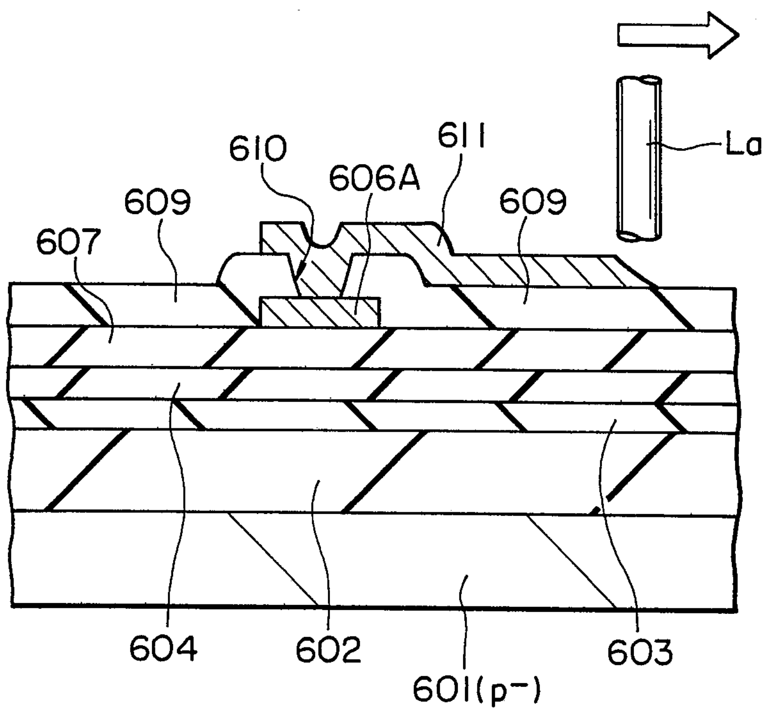
610
611
606A
609
607
609
La
604
602
603
601(p−)

FIG. 6J

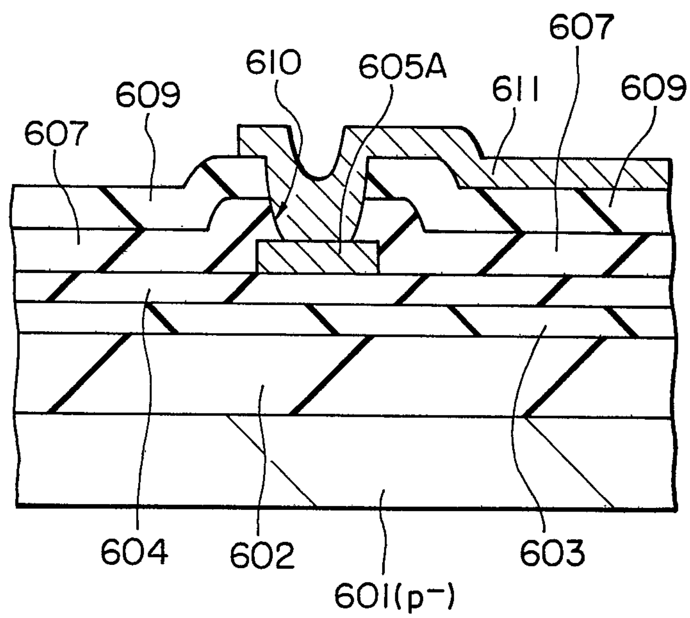
607
610
605A
611
609
609
607
604
602
603
601(p−)

FIG. 6K

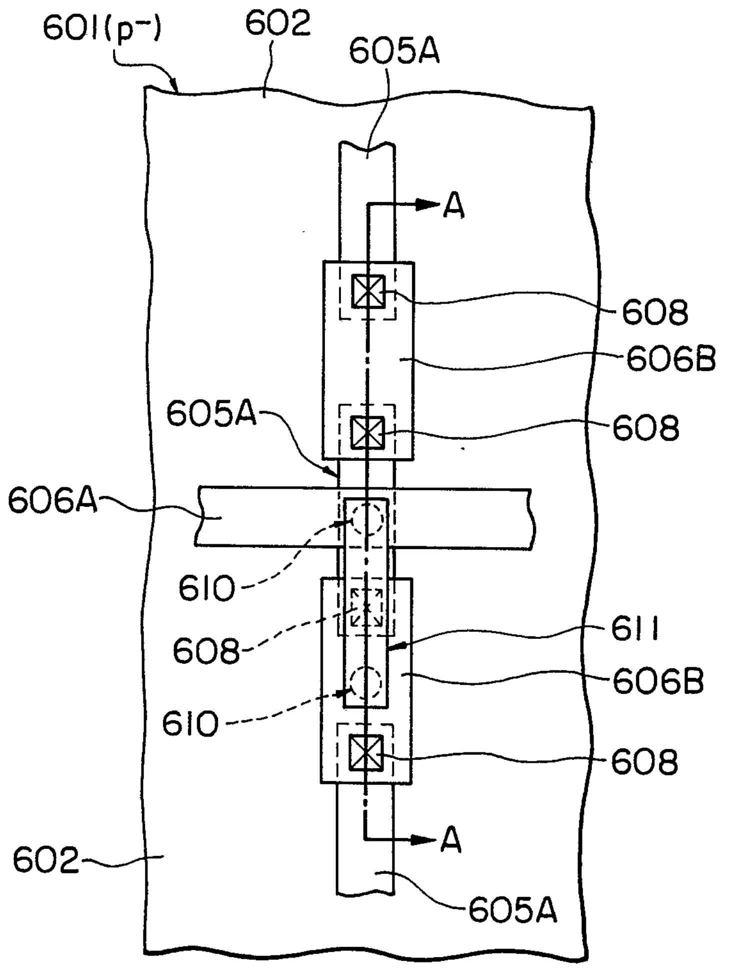
601(p-)
602
605A
A
608
606B
608
605A
606A
610
611
608
606B
610
608
A
602
605A

FIG. 6L

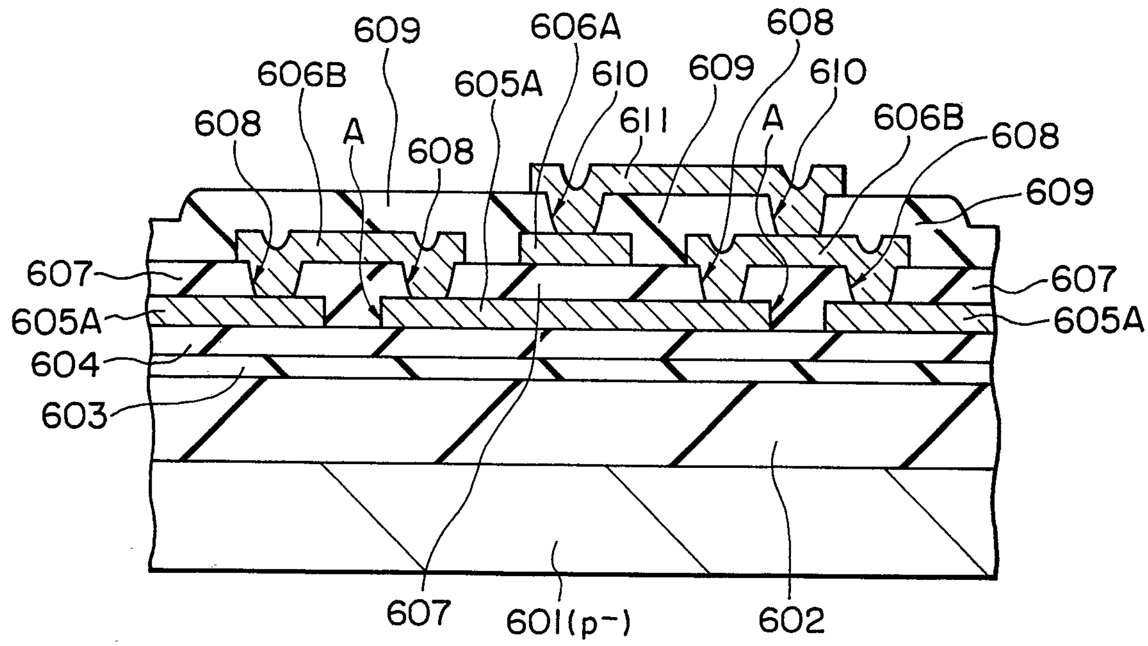
609
606A
608
606B
605A
610
609
610
608
A
611
A
606B
608
608
609
607
607
605A
605A
604
603
607
601(p-)
602

0295065

FIG. 6M

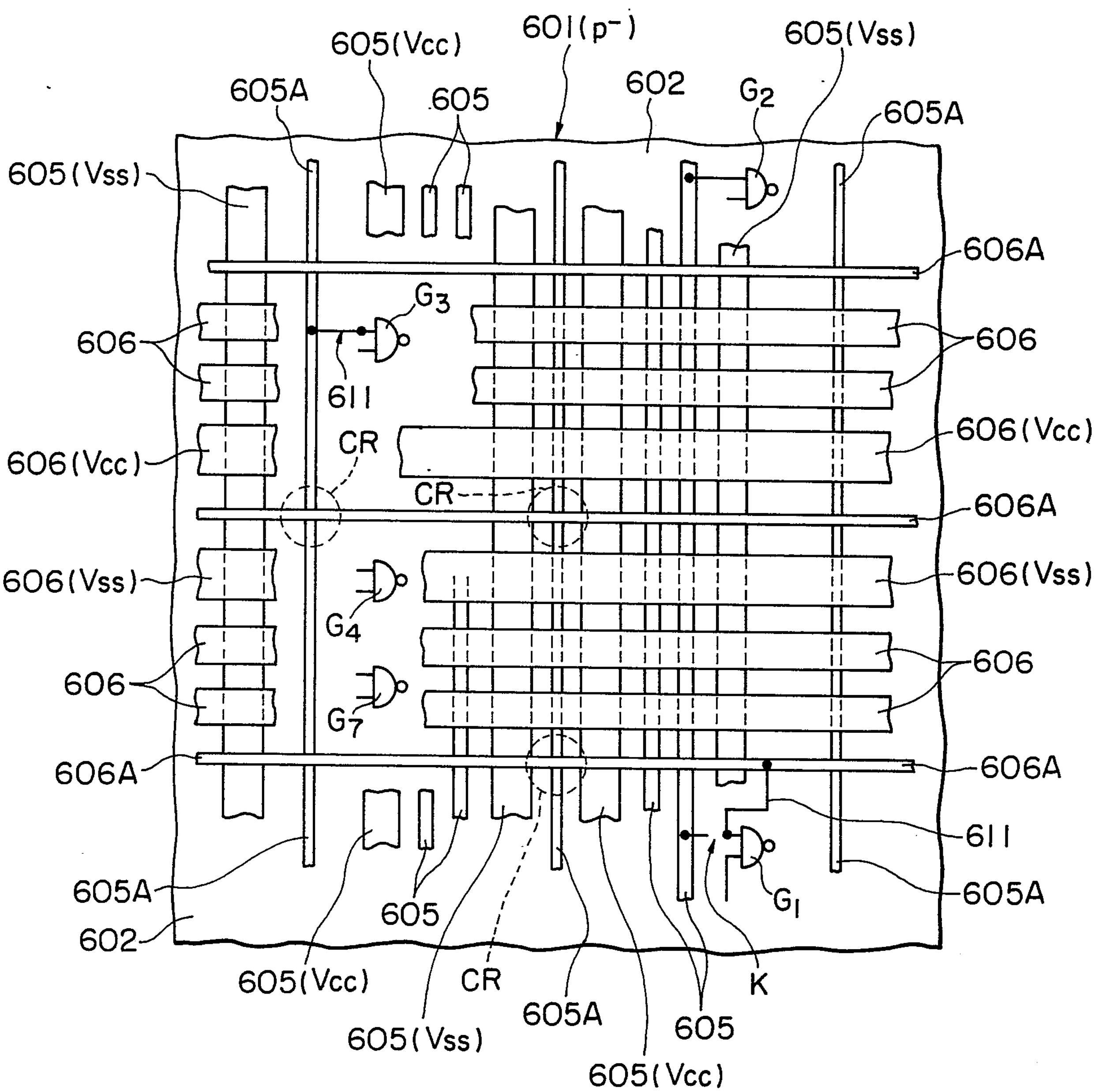

0295065

FIG. 6N

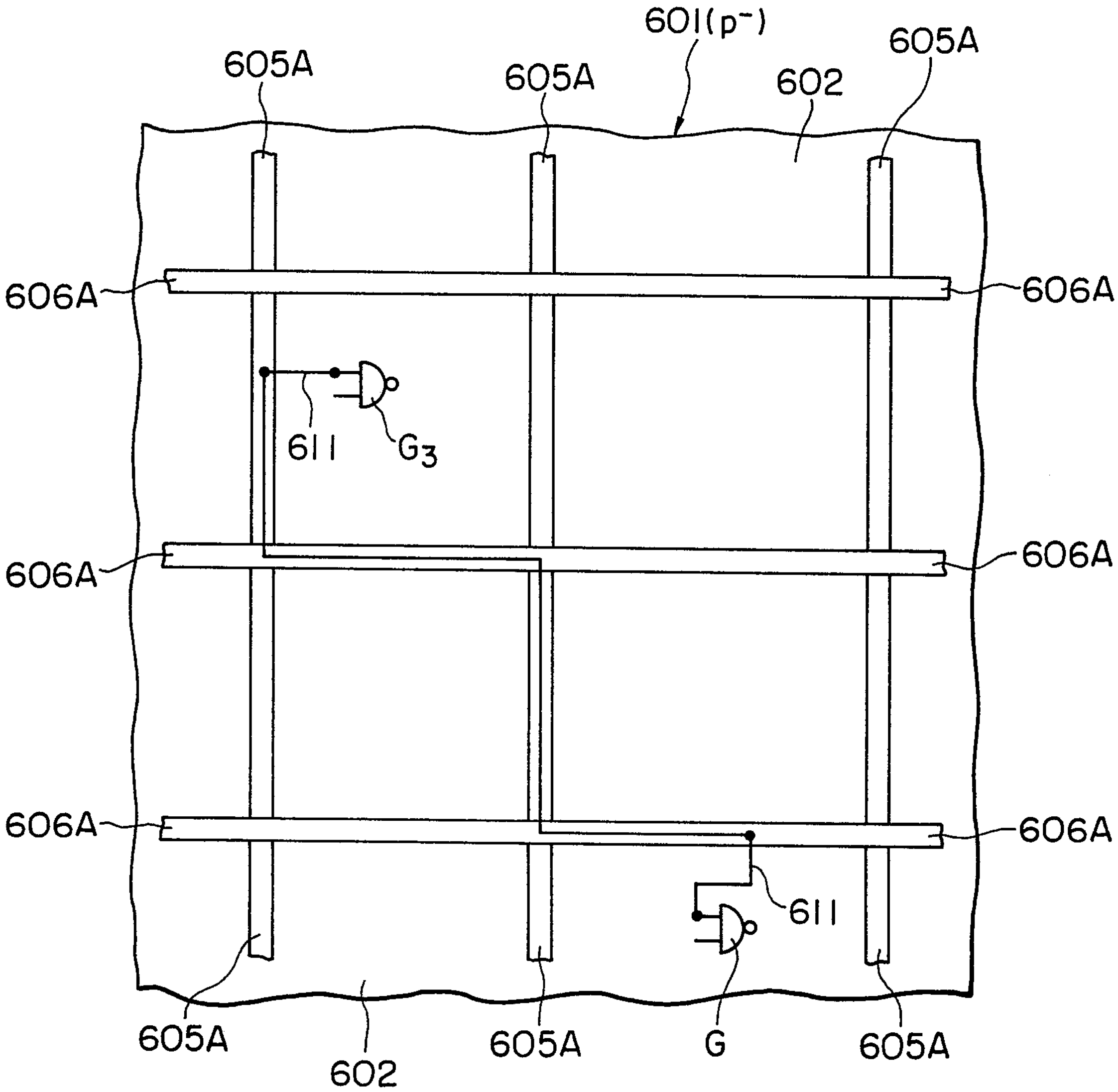

FIG. 7A

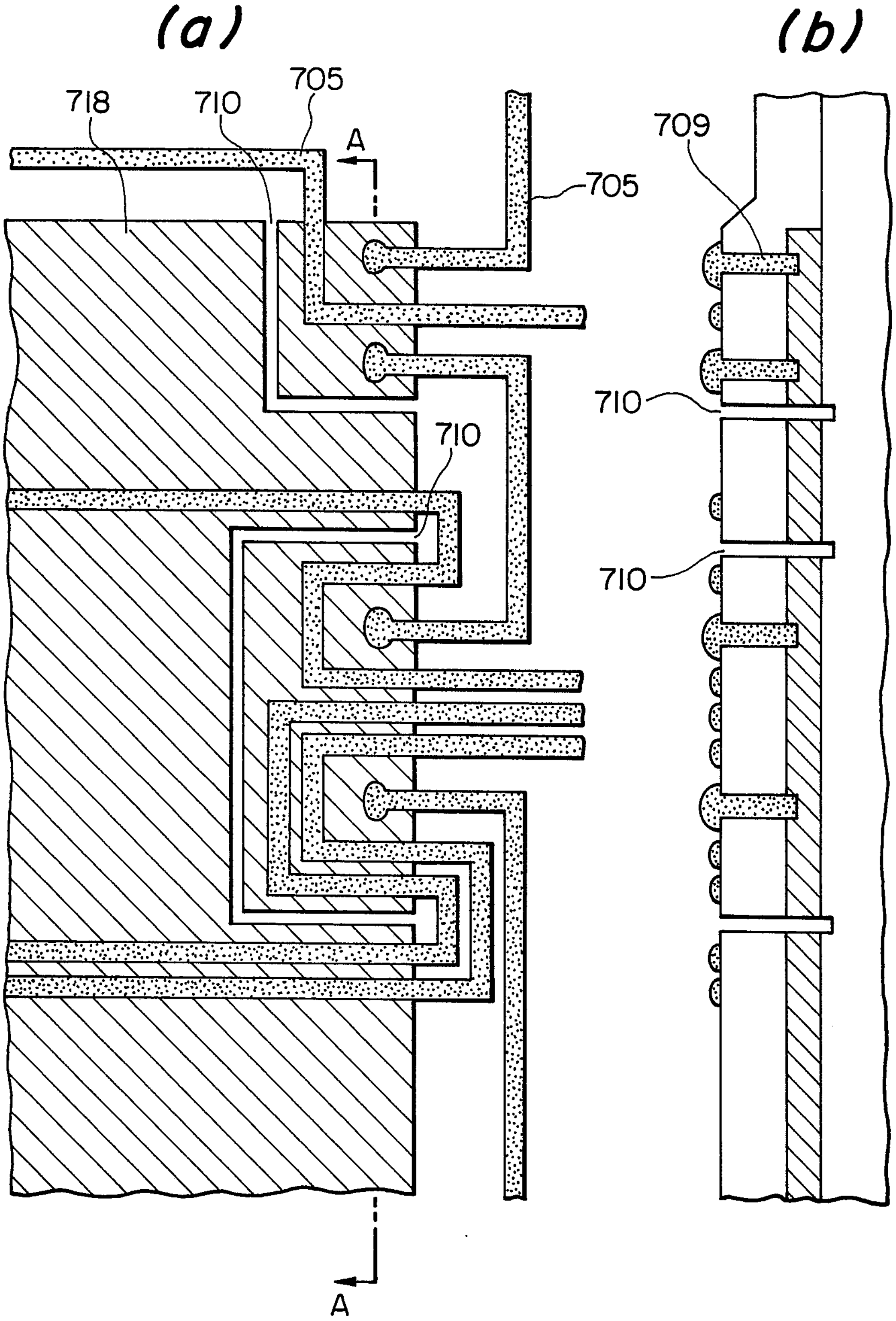

FIG. 7B

(a)

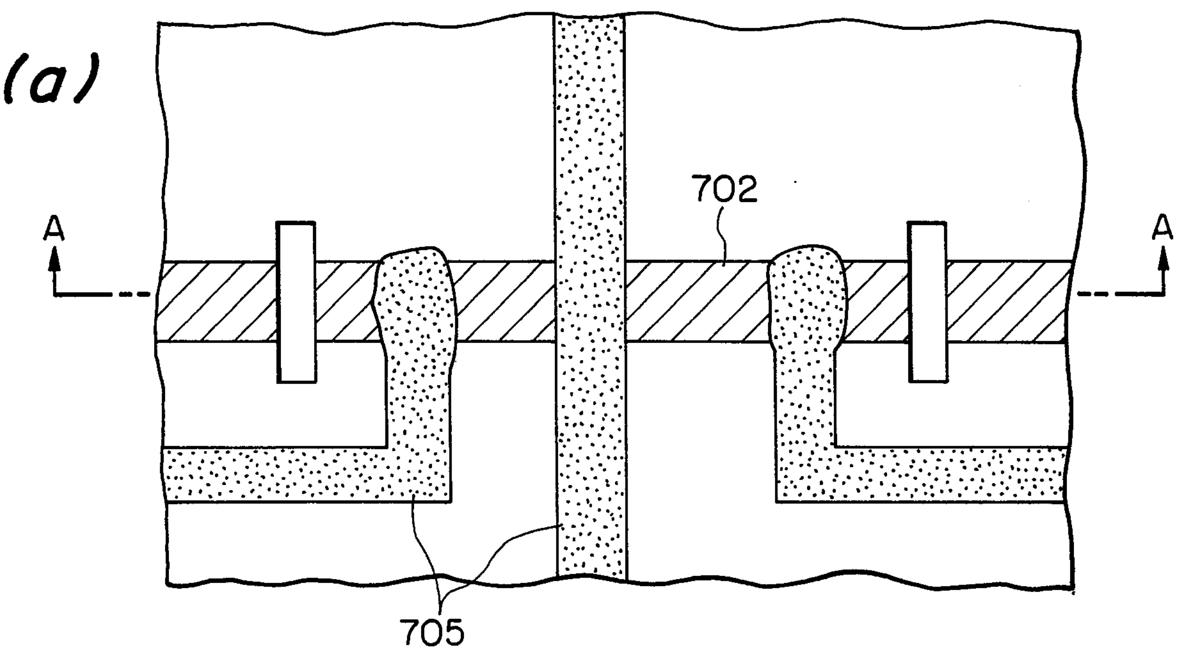


(b)

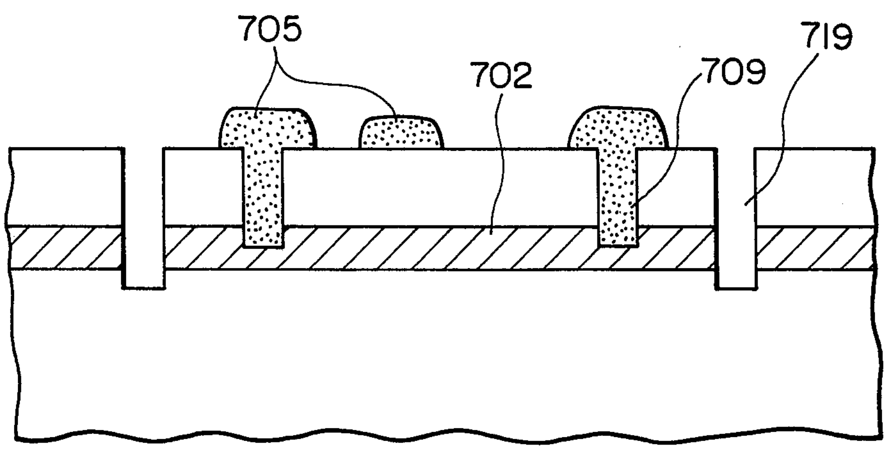

0295065

FIG. 7C

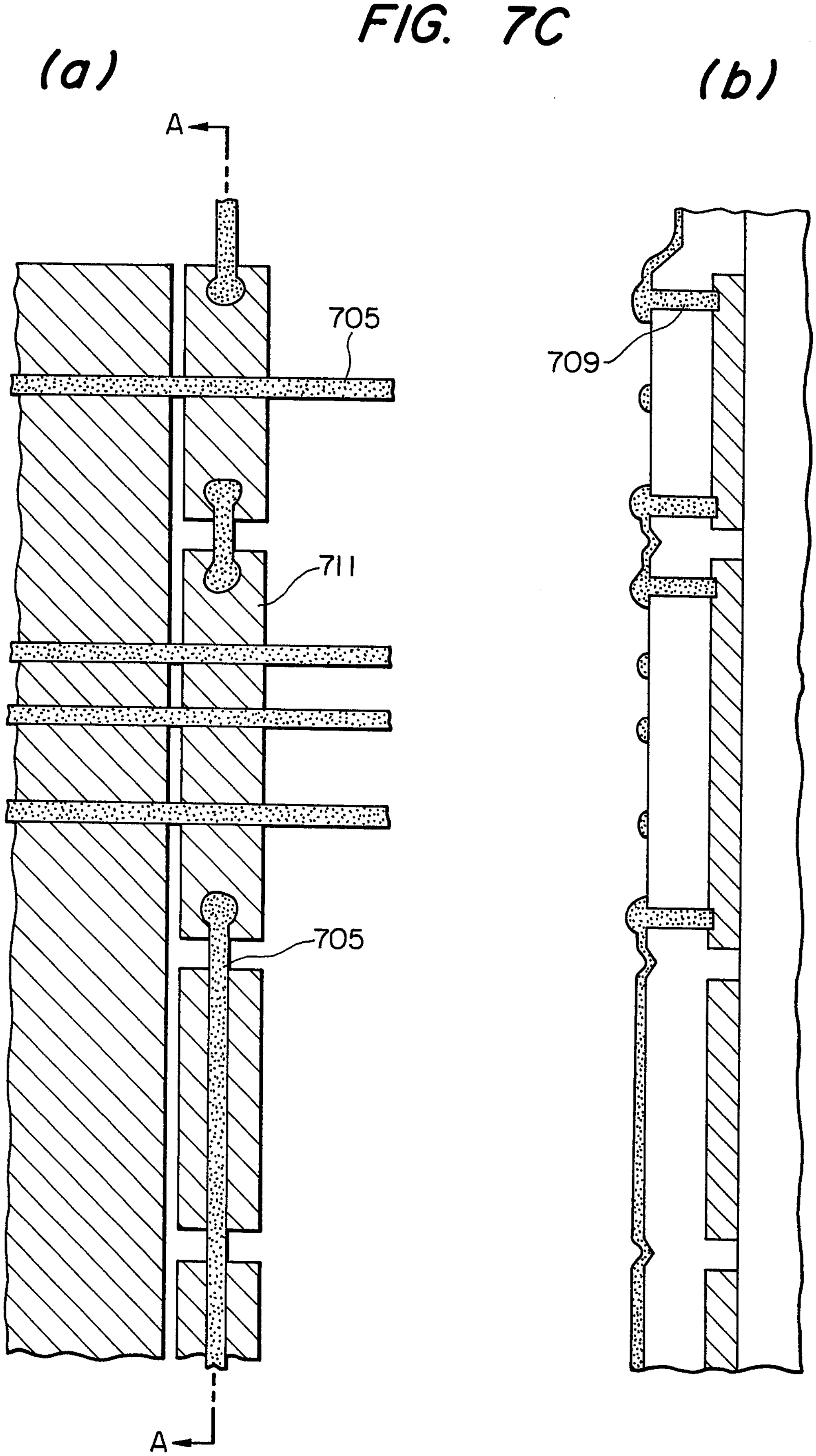

FIG. 7D

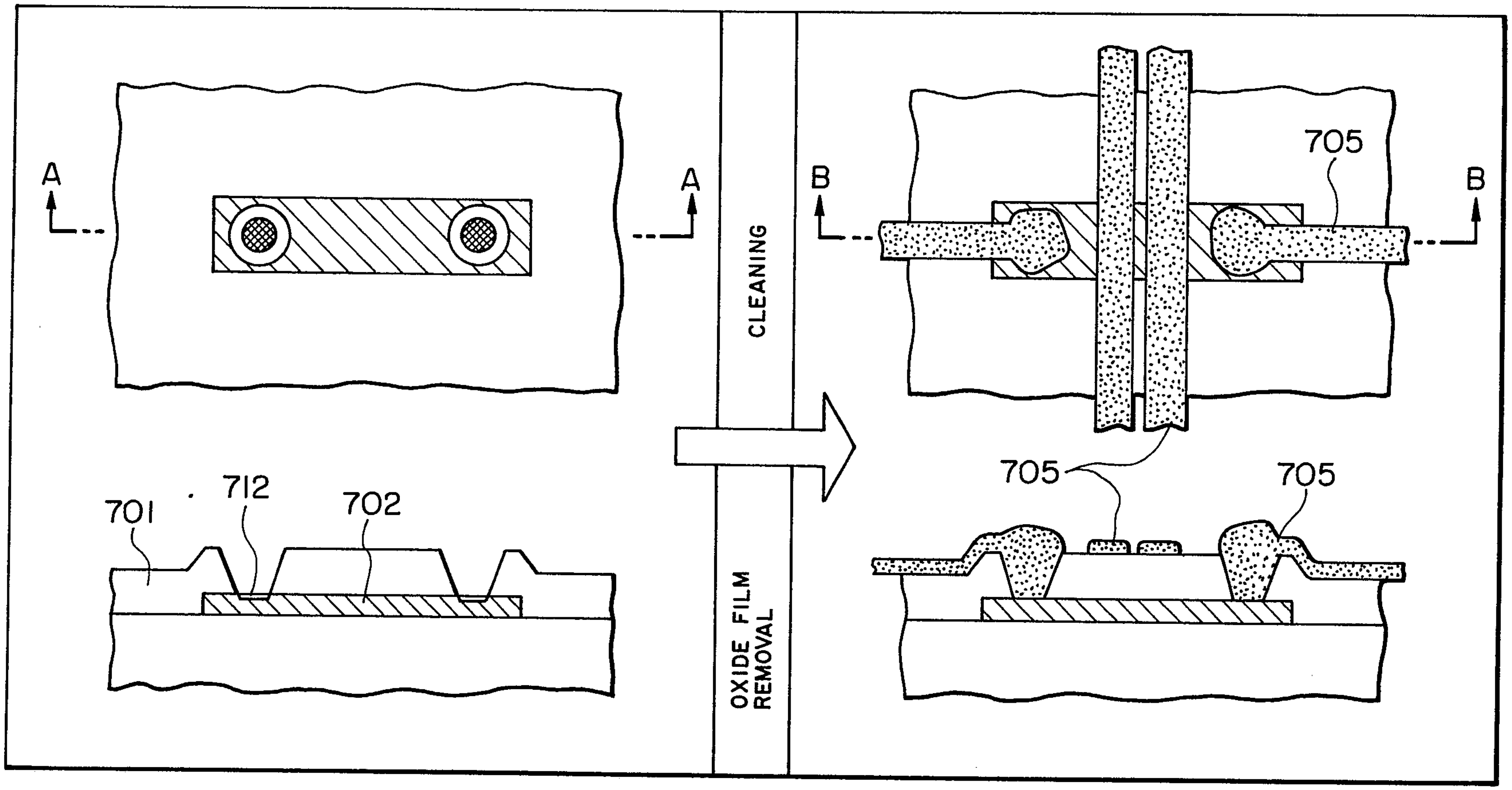


0295065

FIG. 7E

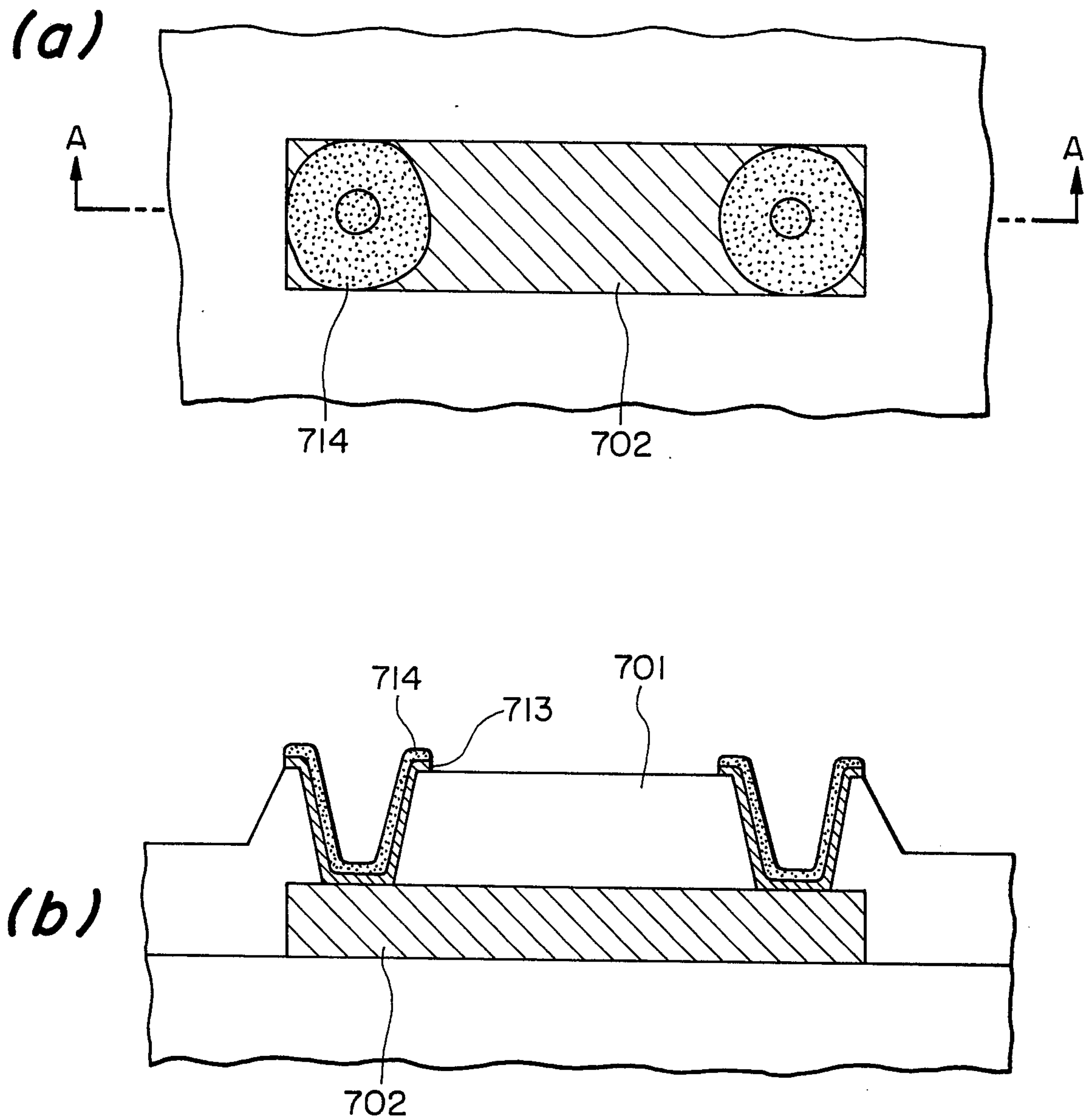

FIG. 7F

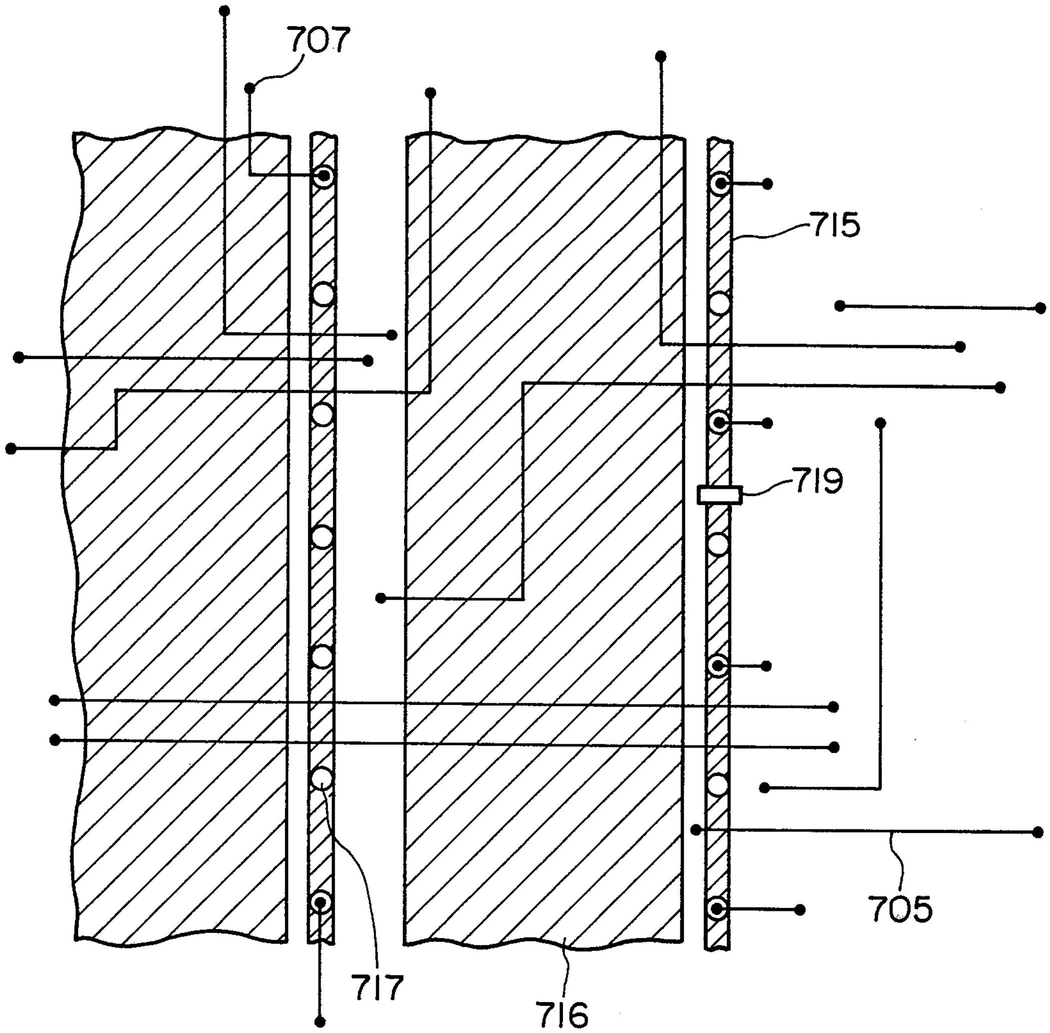

FIG. 8A

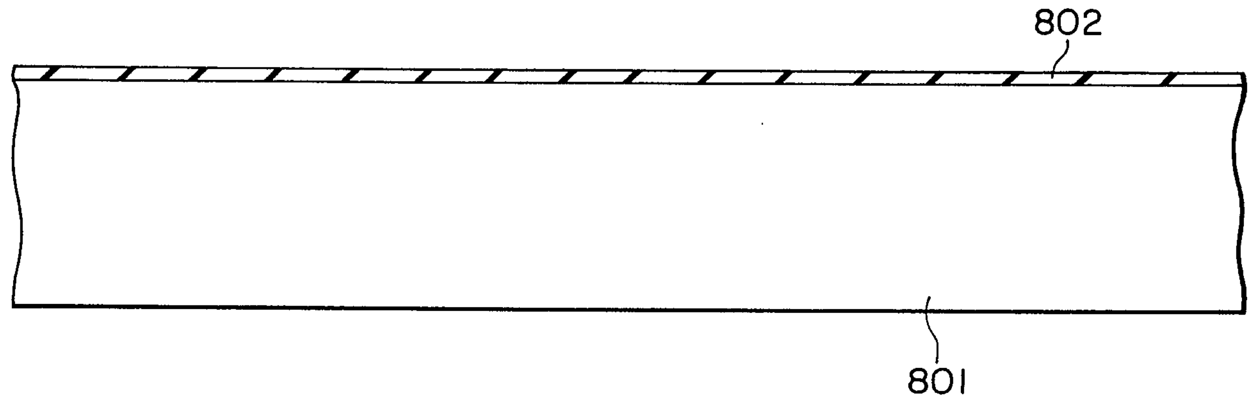


FIG. 8B

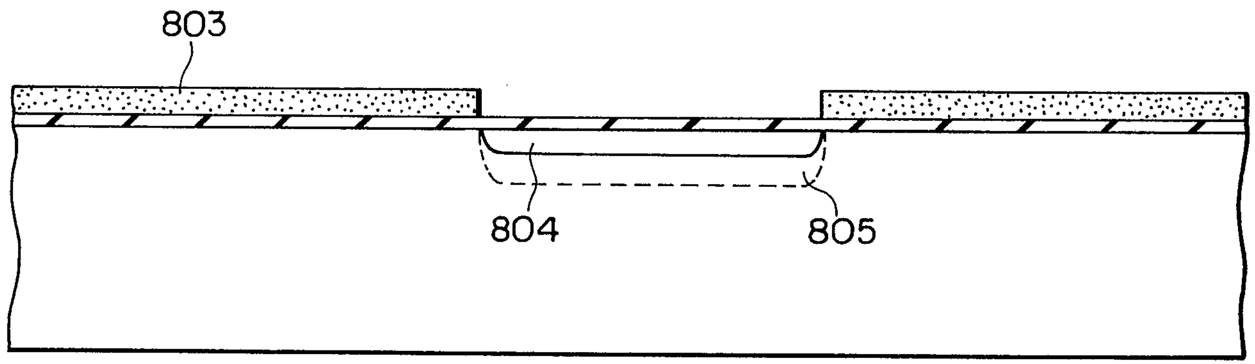


FIG. 8C

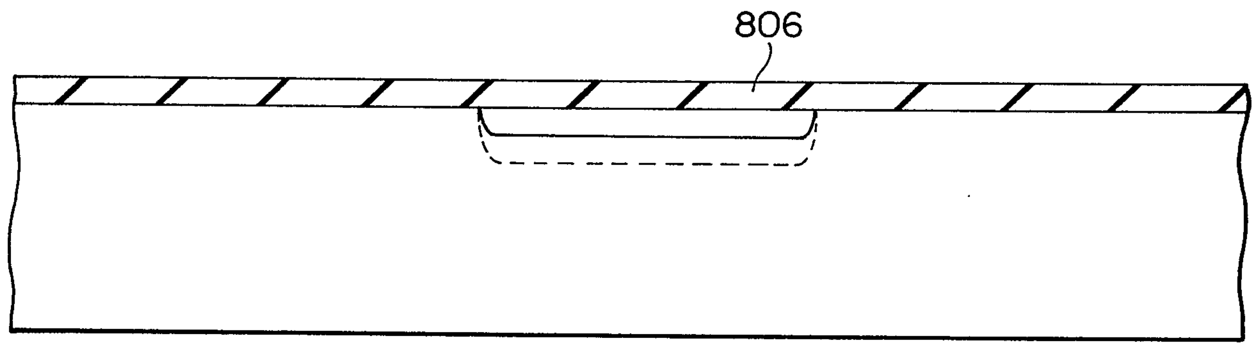

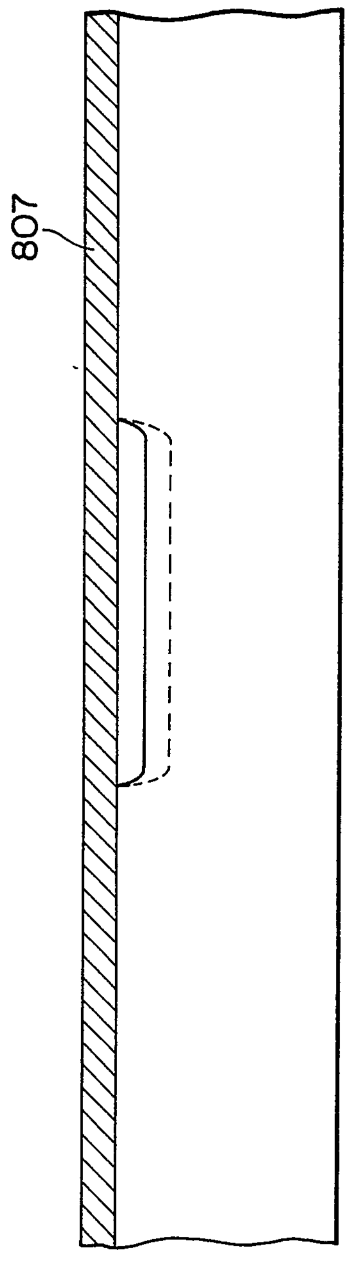


FIG. 8D

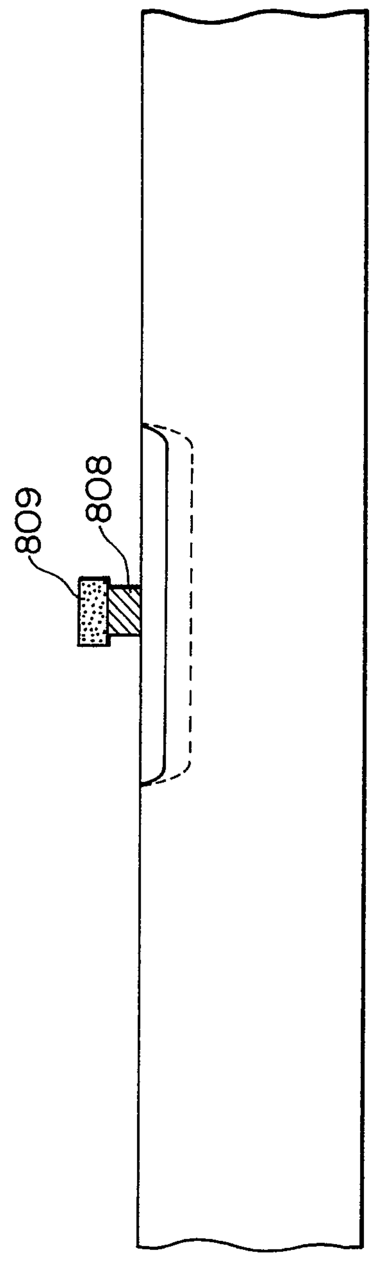


FIG. 8E

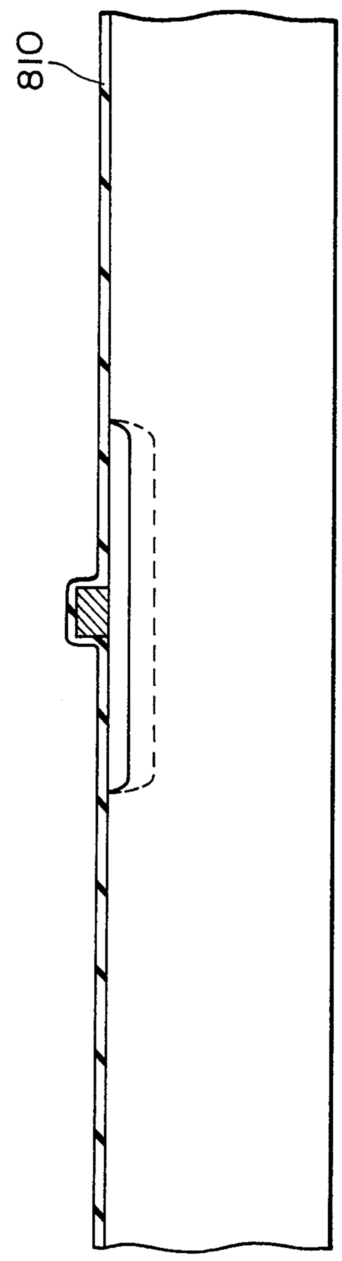


FIG. 8F

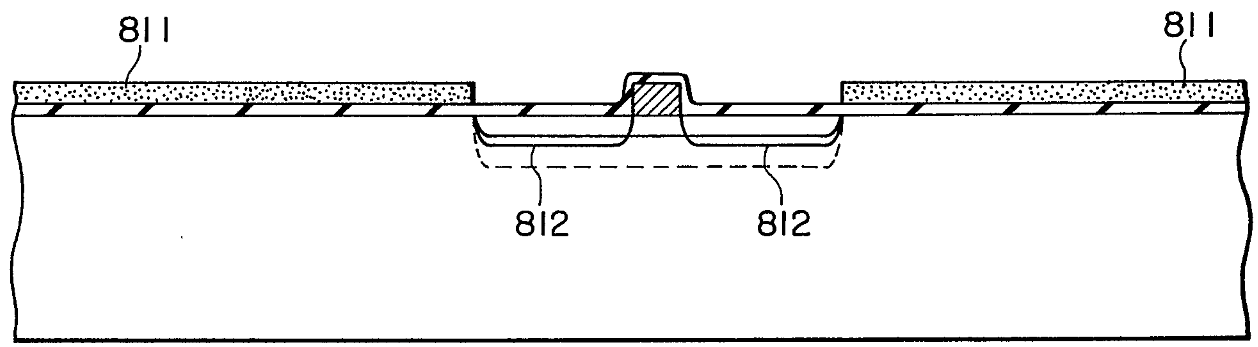


FIG. 8G

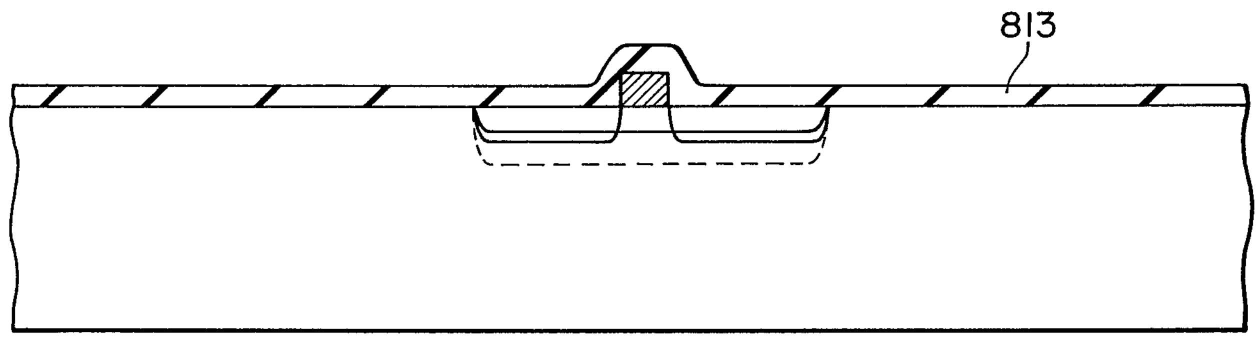


FIG. 8H

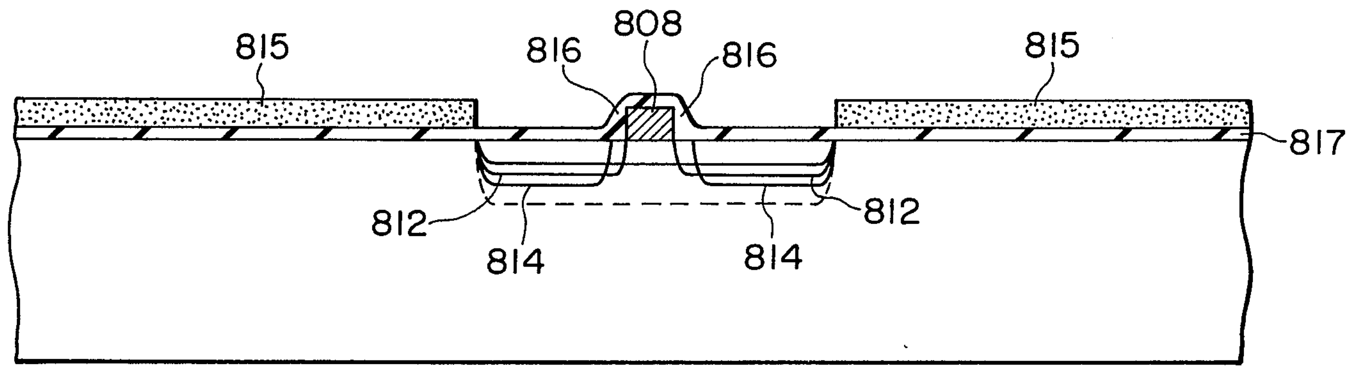


FIG. 8I

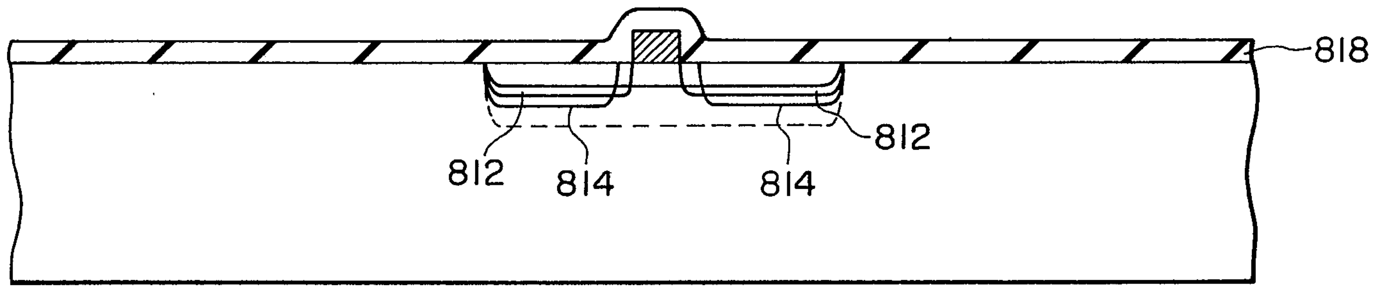


FIG. 8J

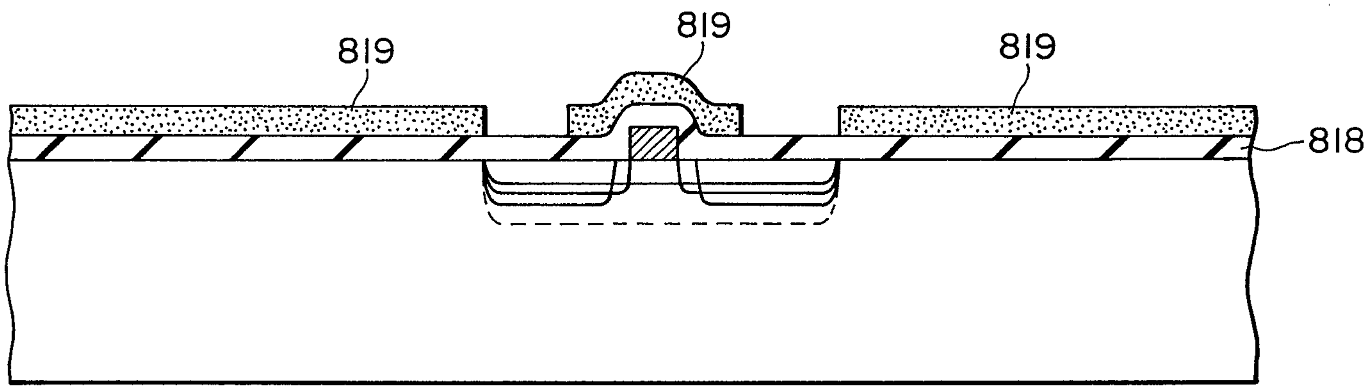


FIG. 8K

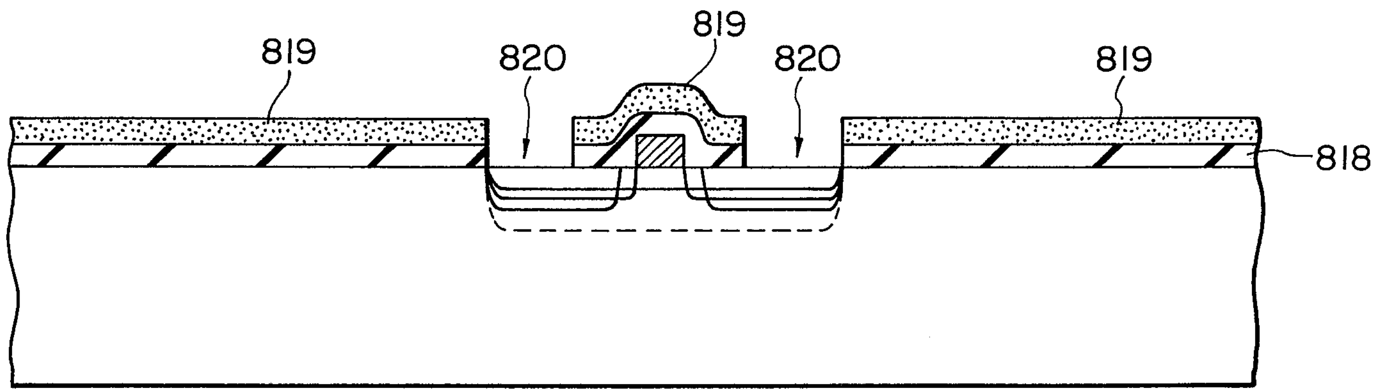


FIG. 8L

0295065

FIG. 8M

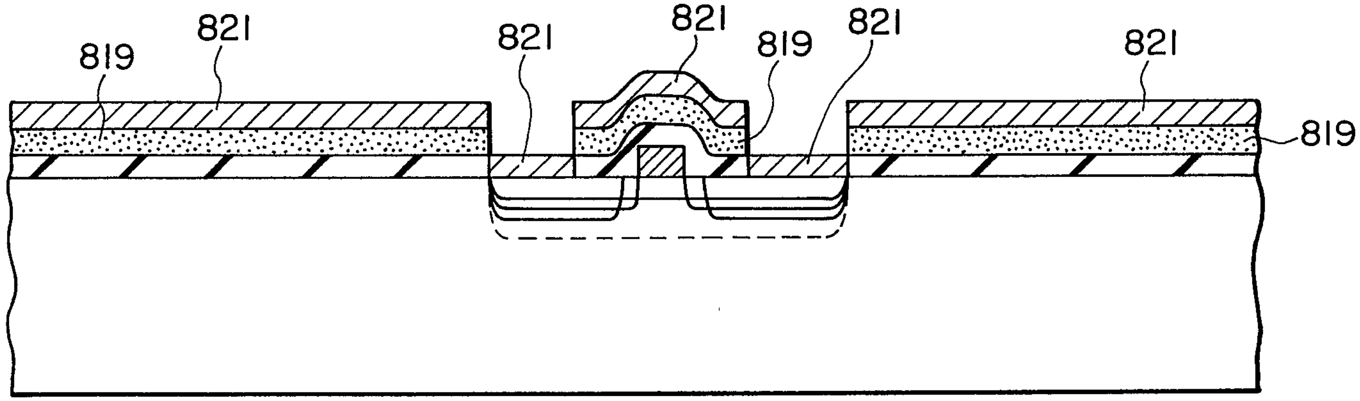


FIG. 8N

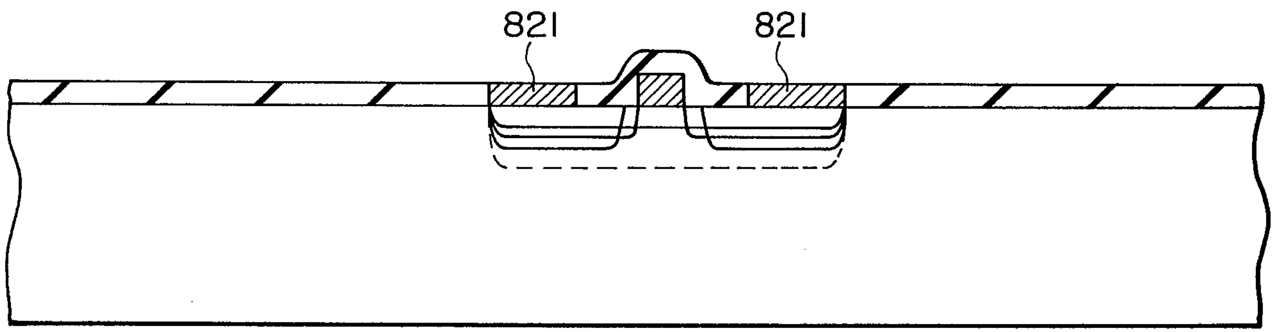


FIG. 8O

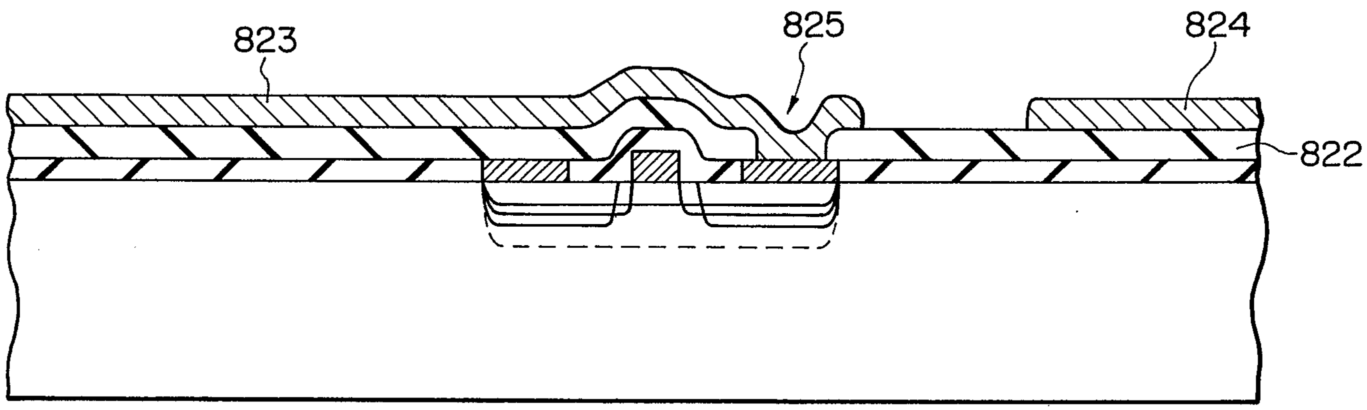

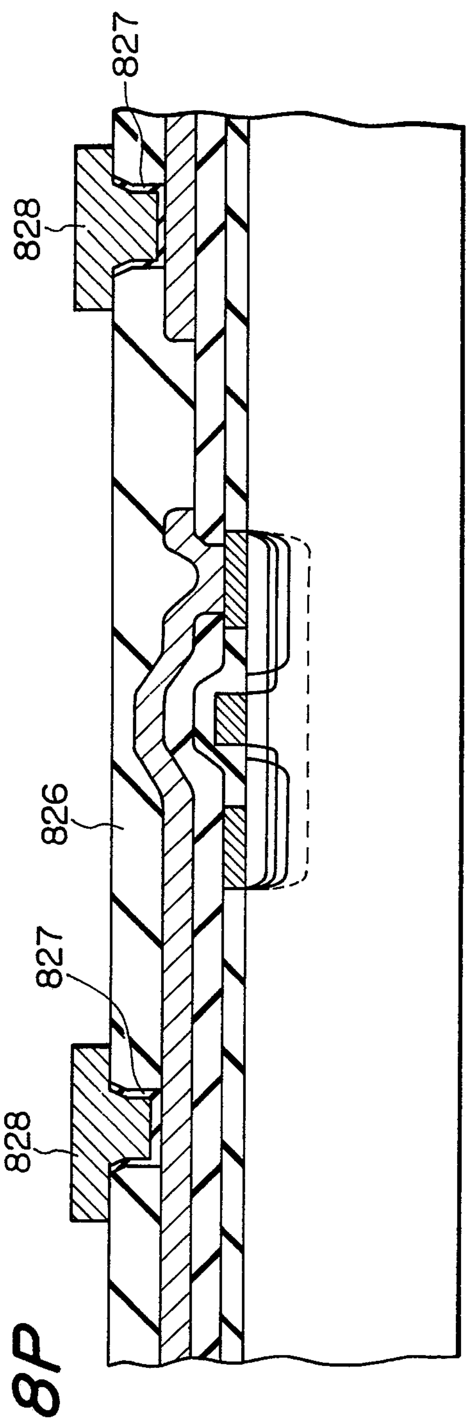
827
828
826
827
828

FIG. 8P

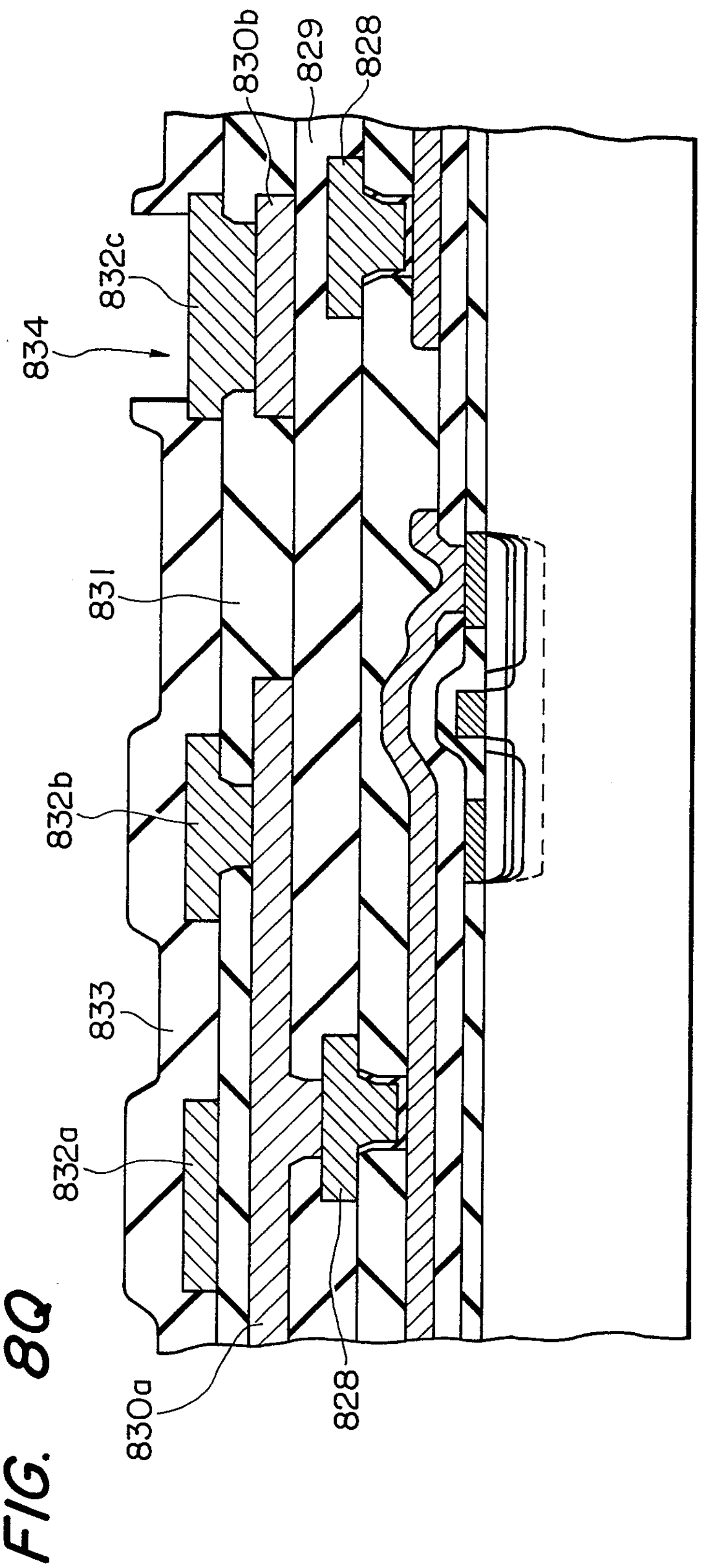
830b
829
828
832c
834
831
832b
833
832a
830a
828

FIG. 8Q

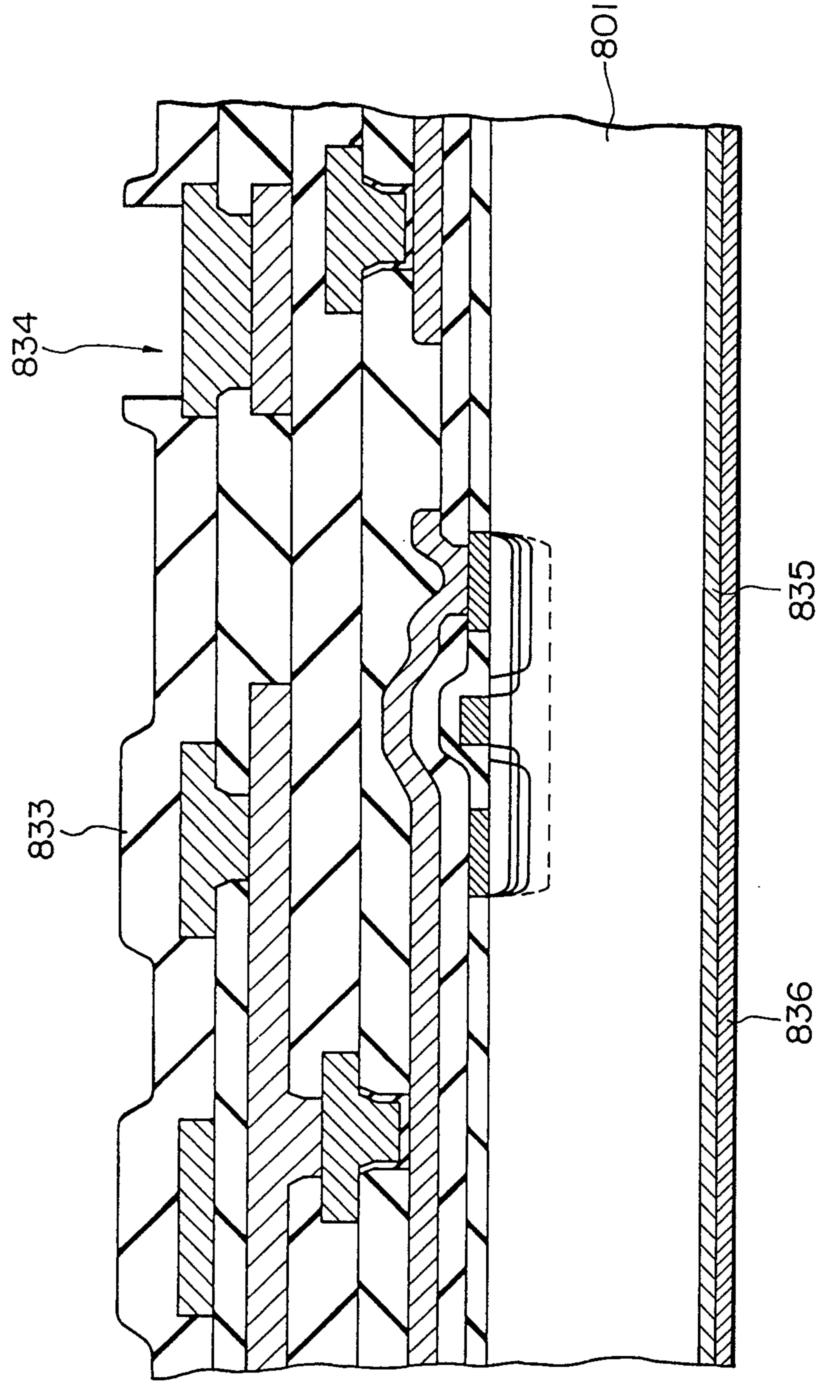


FIG. 8R

FIG. 8S

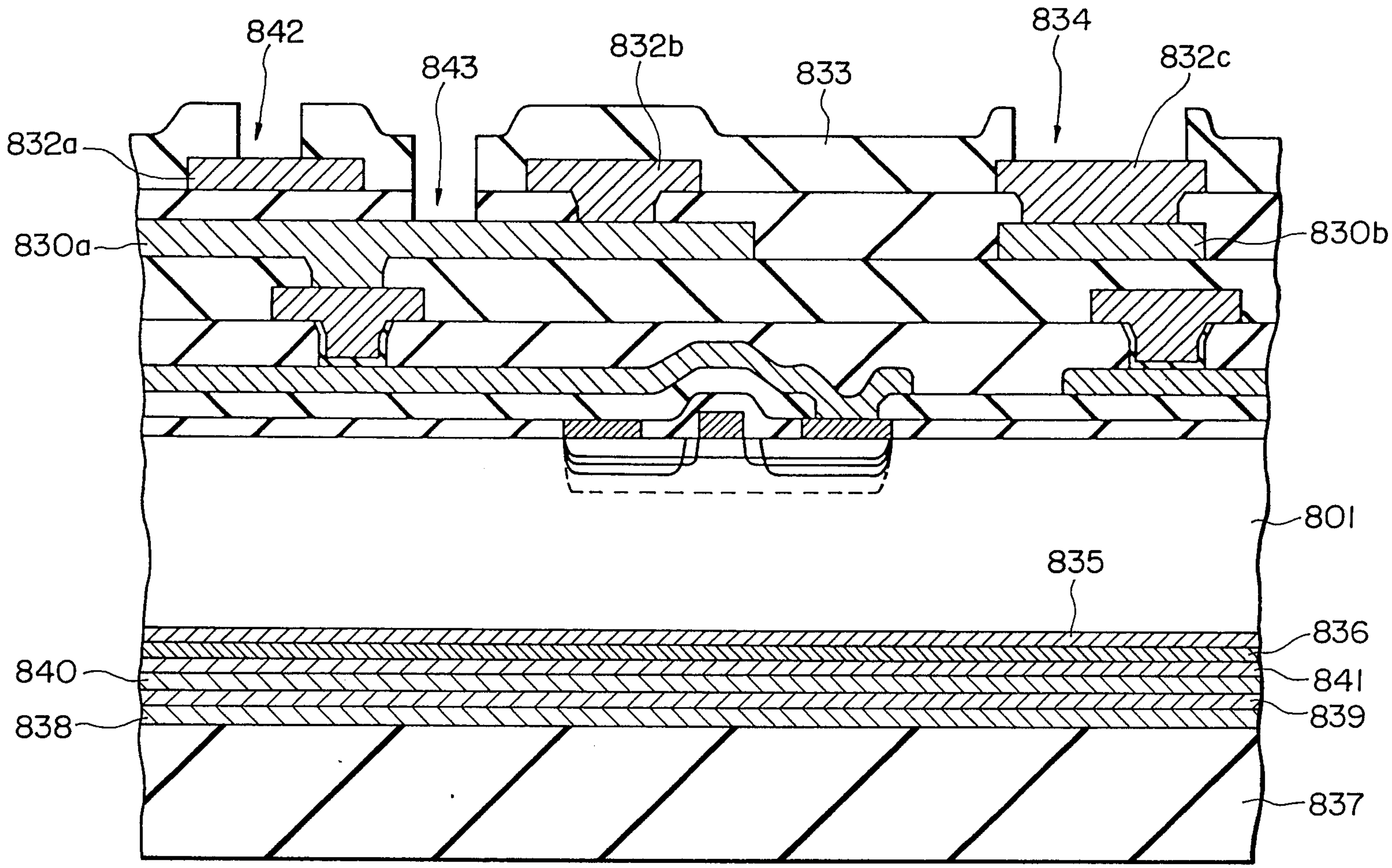
842
843
832b
833
834
832c
832a
830a
830b
801
835
836
840
841
838
839
837

FIG. 8T

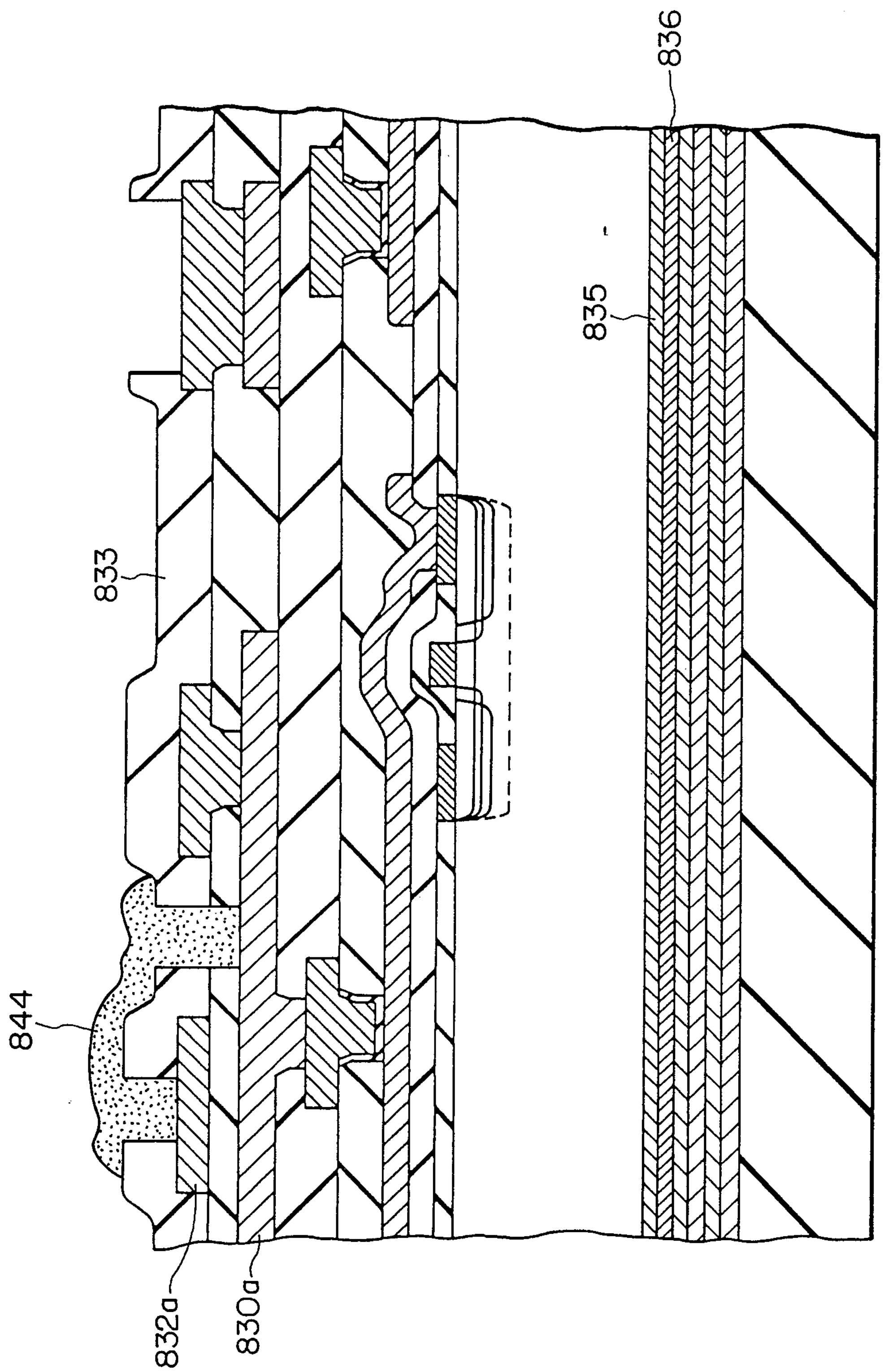

FIG. 8U

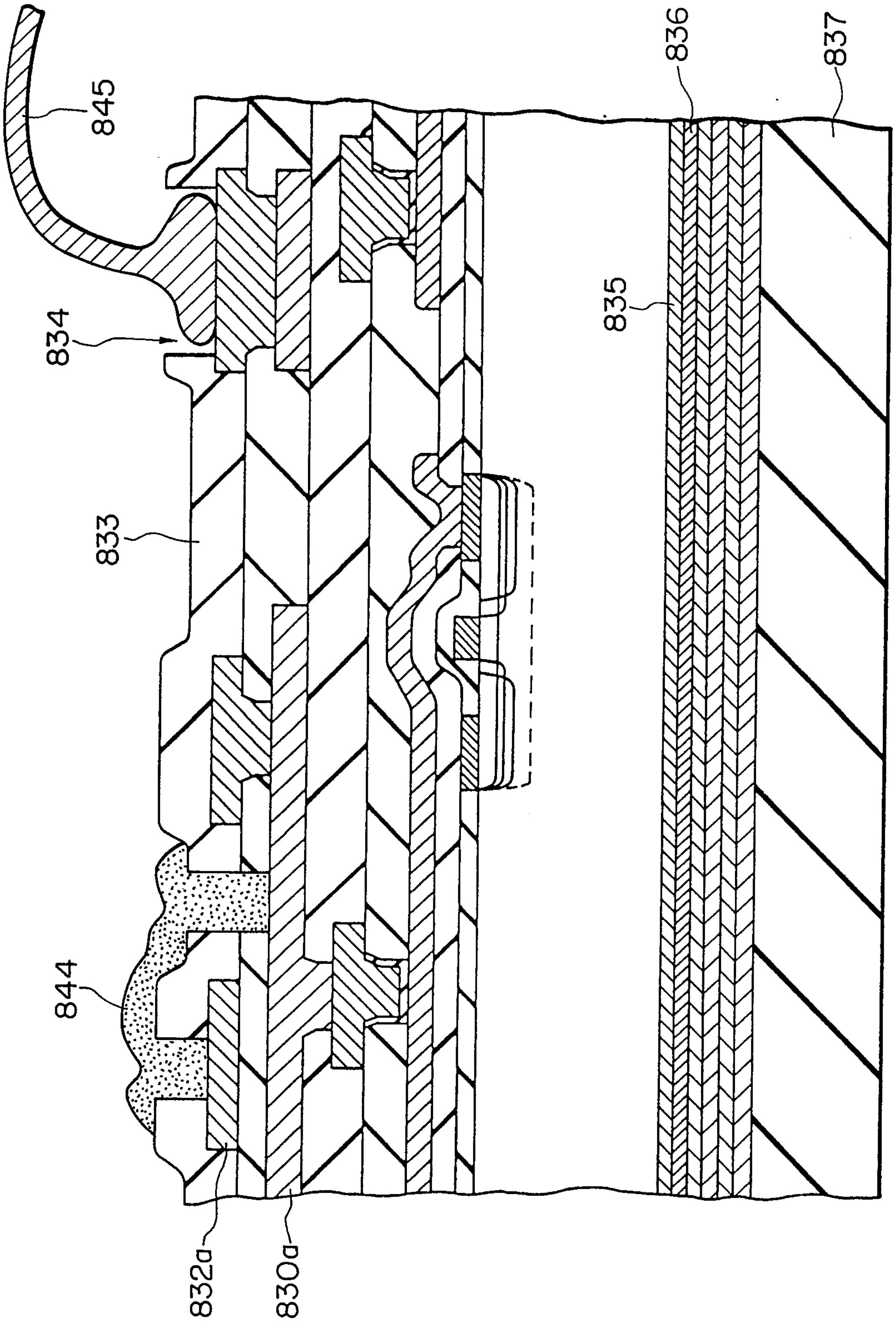

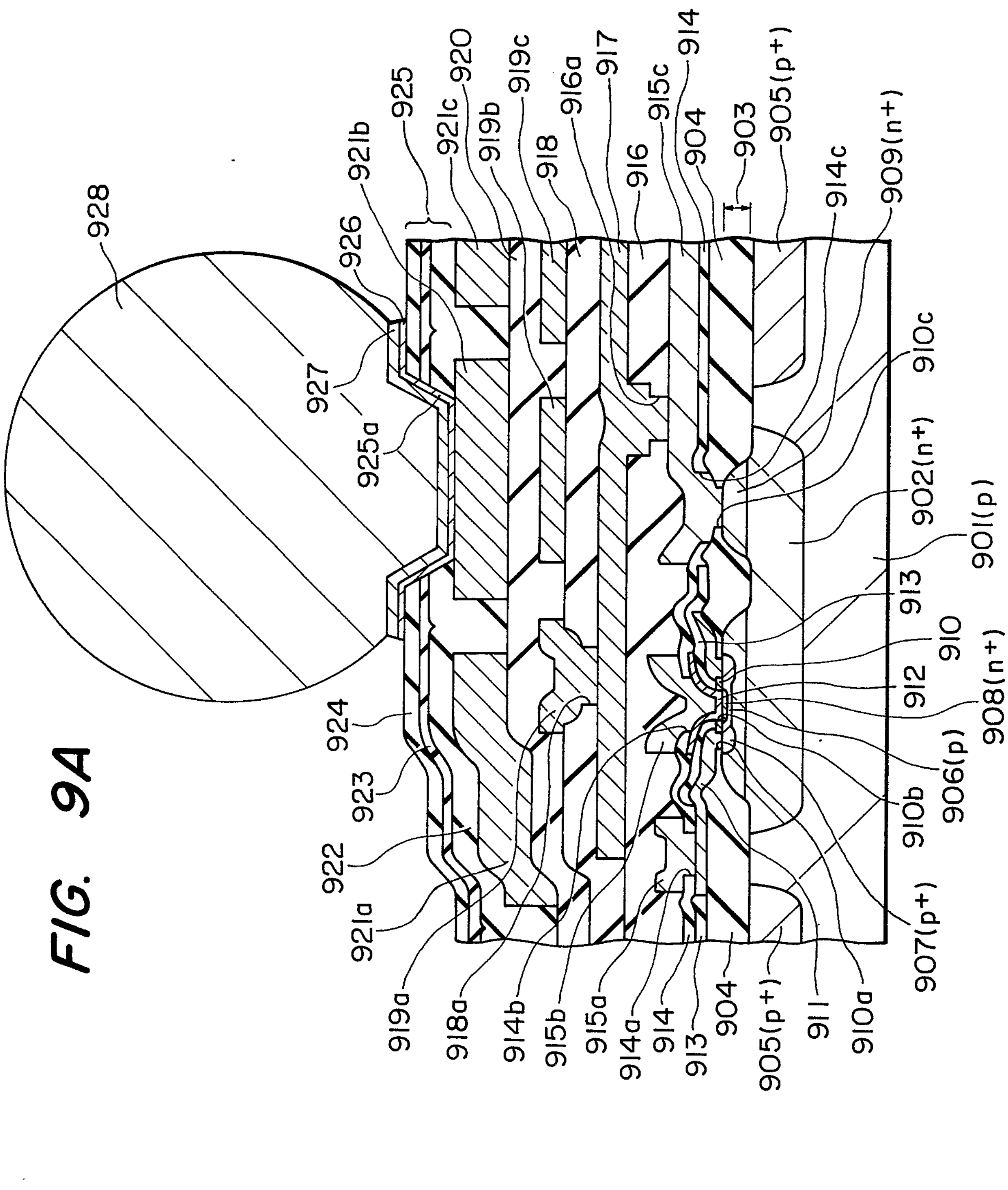

928
926
927
925a
921b
925
921c
920
919b
919c
918
916a
916
917
915c
914
904
903
905(p+)
914c
909(n+)
910c
902(n+)
901(p)
913
910
912
908(n+)
906(p)
910b
907(p+)
910a
911
905(p+)
904
913
914
914a
915a
915b
914b
918a
919a
921a
922
923
924


FIG. 9A

FIG. 9B

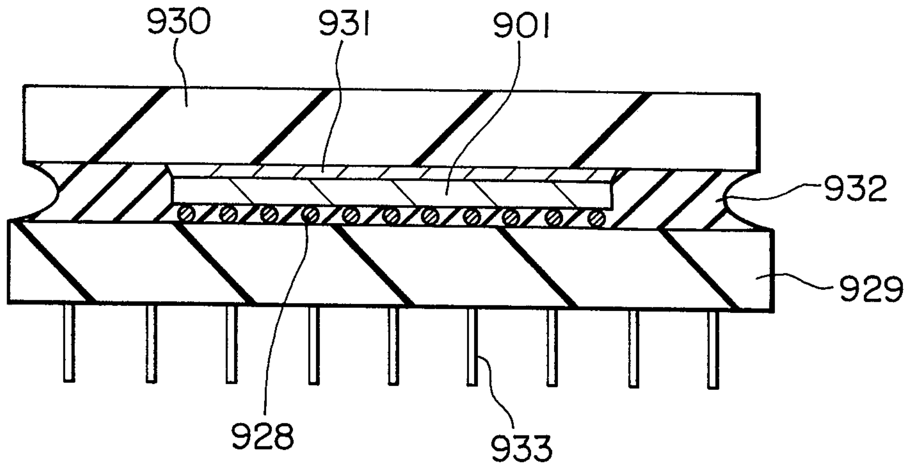


FIG. 9C

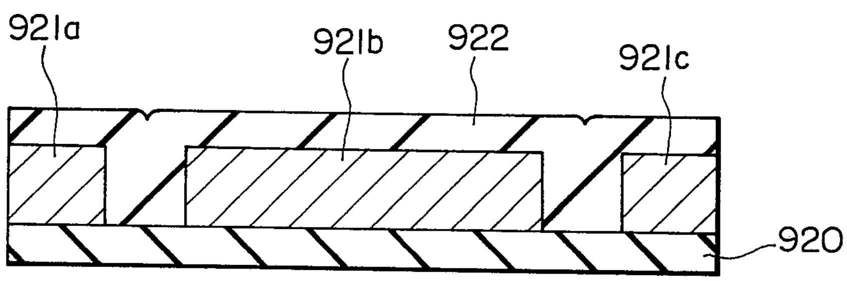


FIG. 9D

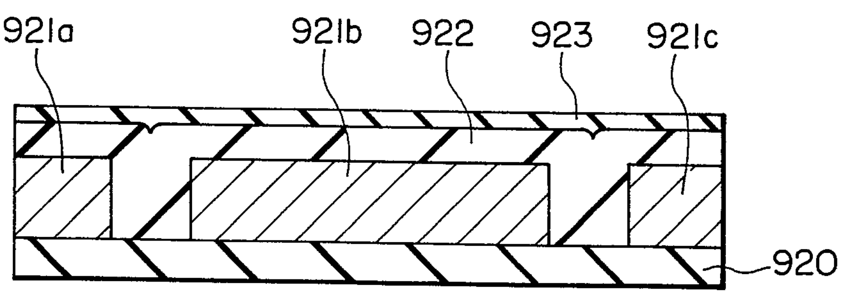

0295065

FIG. 9E

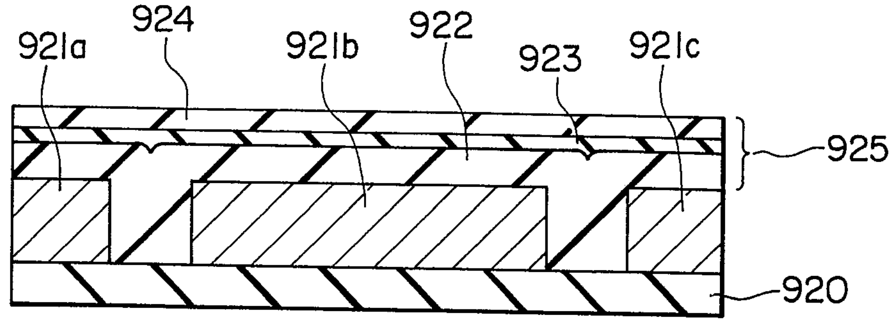


FIG. 9F

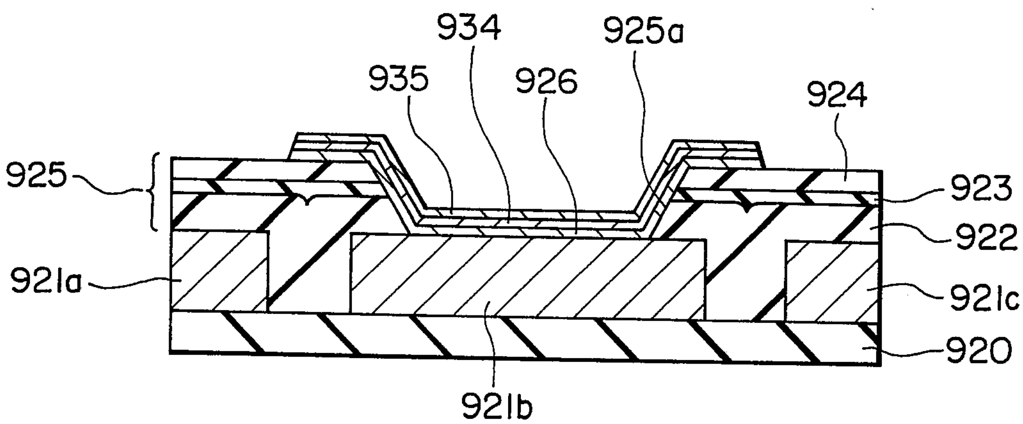


FIG. 9G

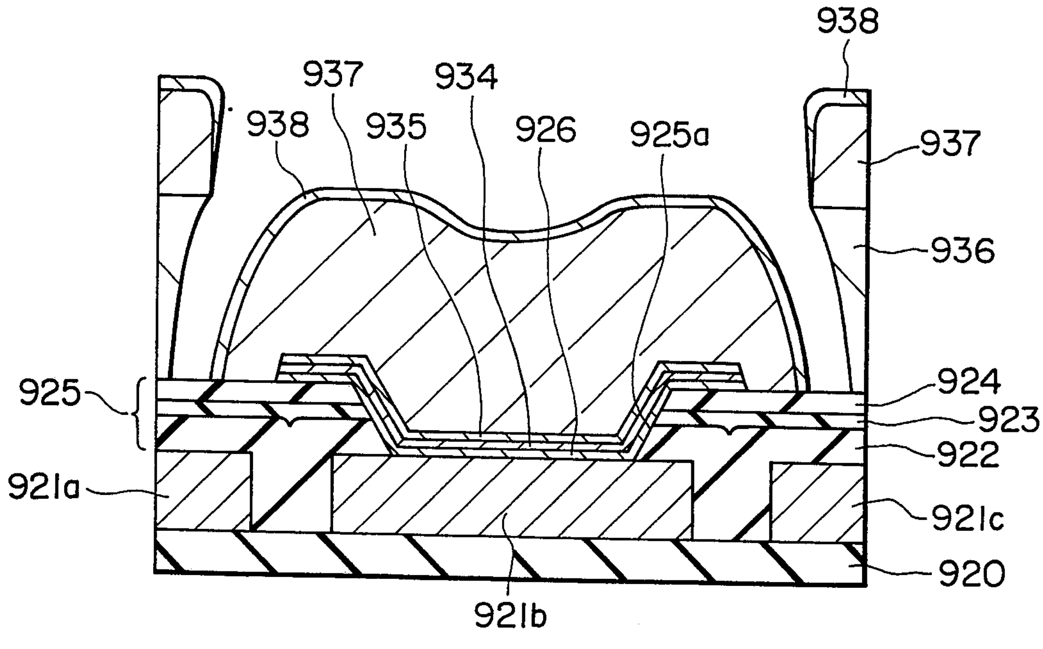

FIG. 9H

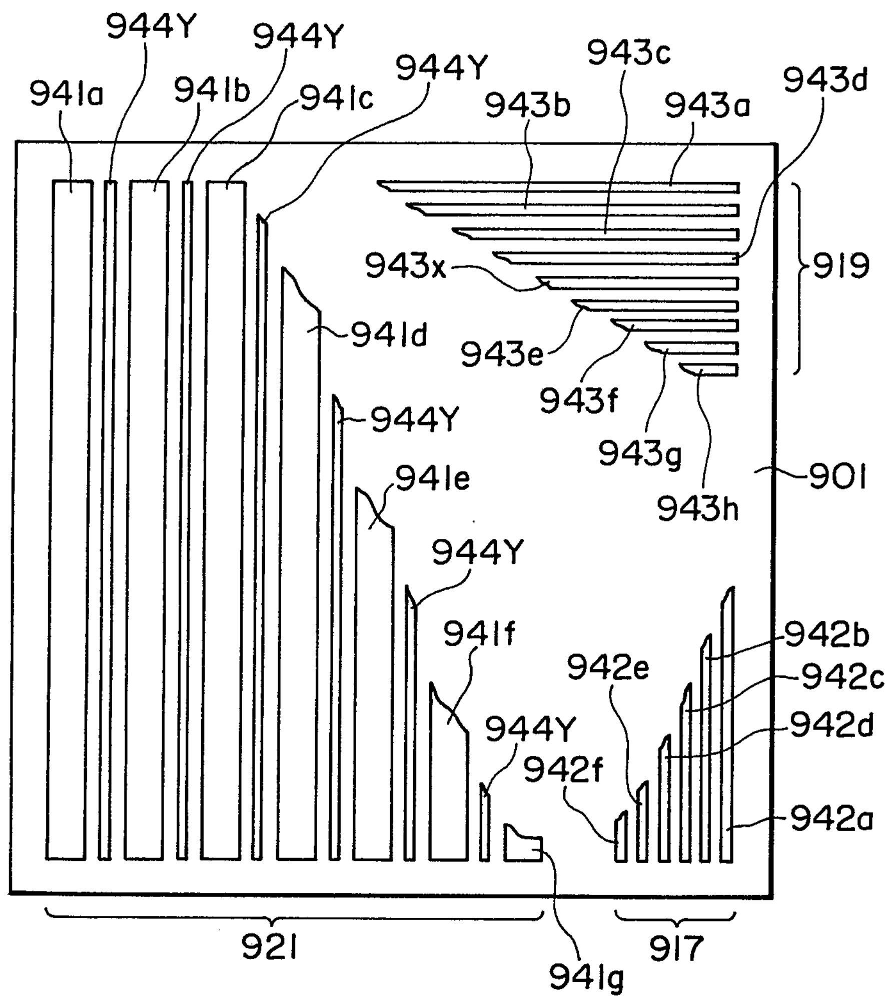
941a
944Y
941b
944Y
941c
944Y
943b
943c
943a
943d
943x
919
941d
943e
943f
944Y
943g
901
941e
943h
944Y
941f
942b
942e
942c
944Y
942d
942f
942a
921
917
941g

FIG. 9I

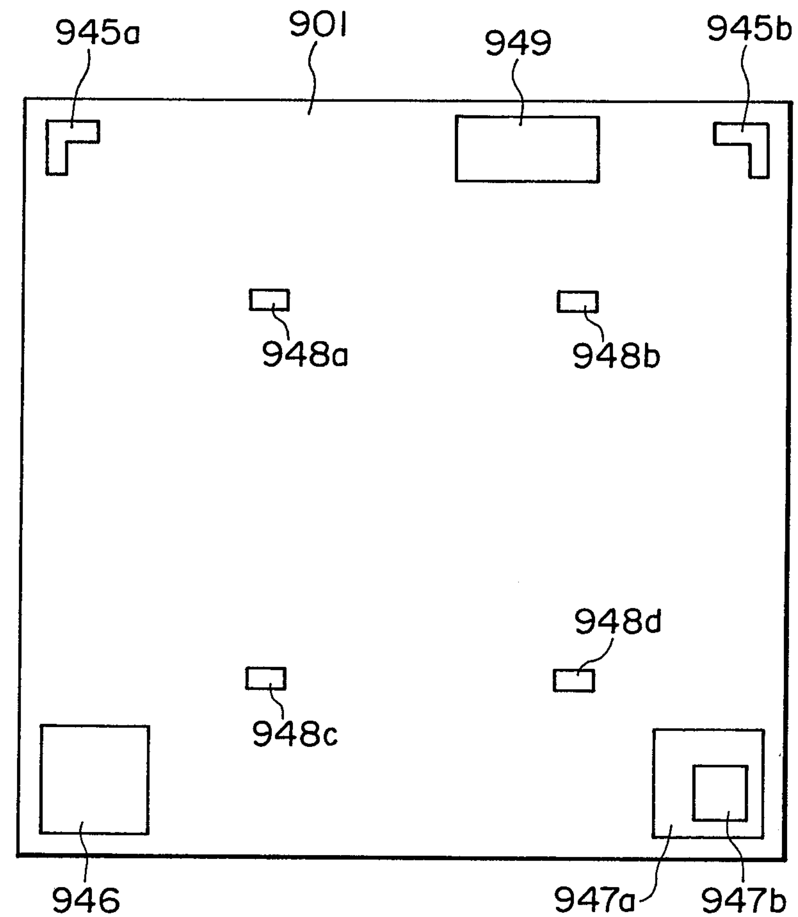
945a
901
949
945b
948a
948b
948d
948c
946
947a
947b

FIG. 9J

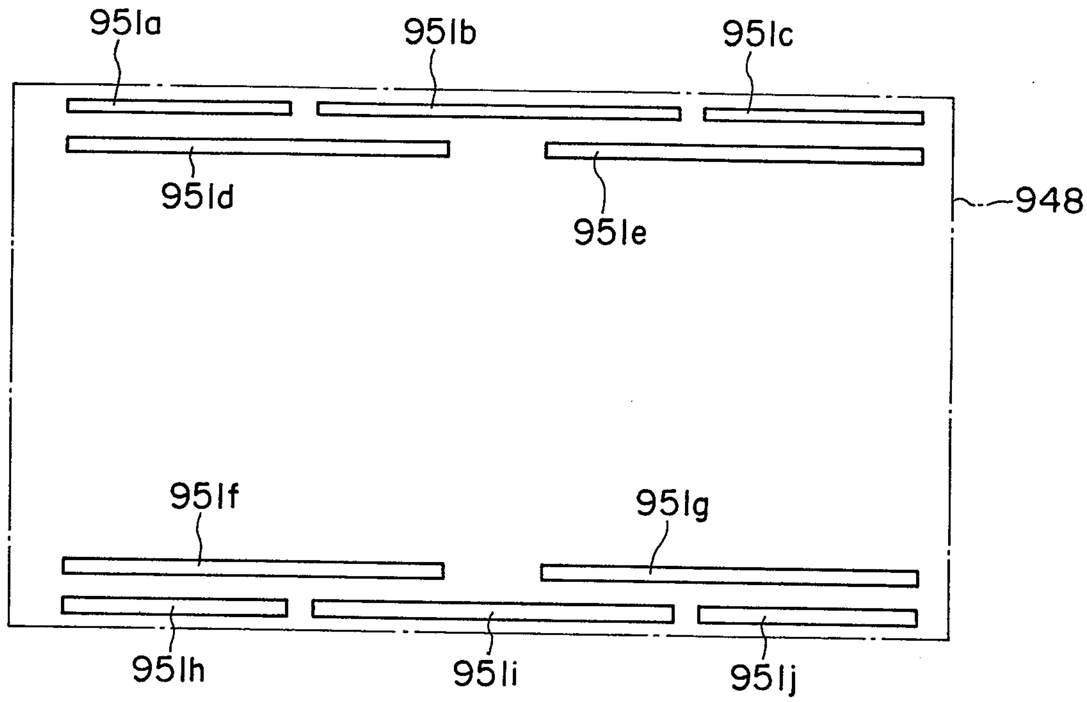


FIG. 9K

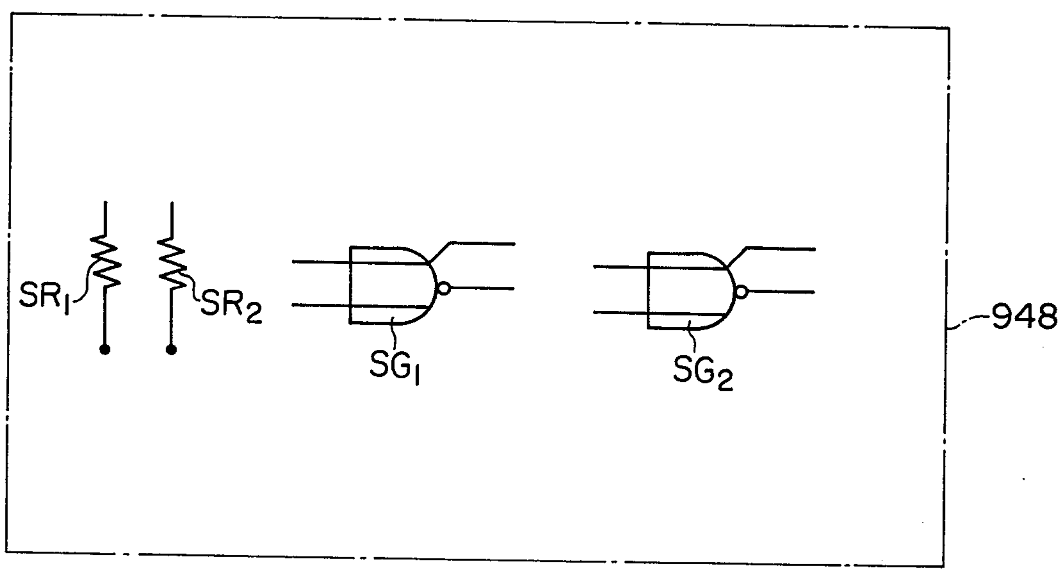


FIG. 9L

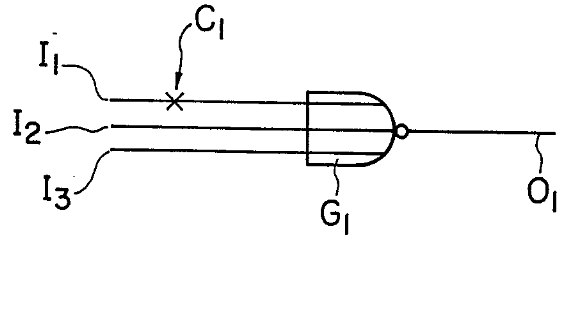

0295065

FIG. 9M

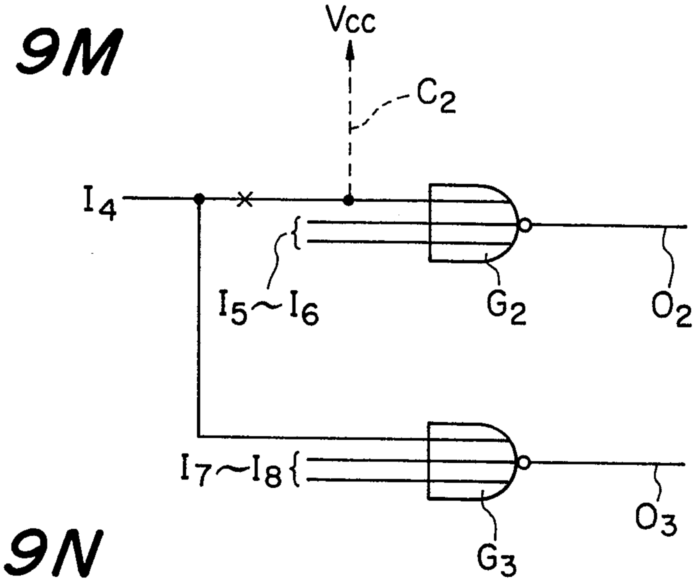


FIG. 9N

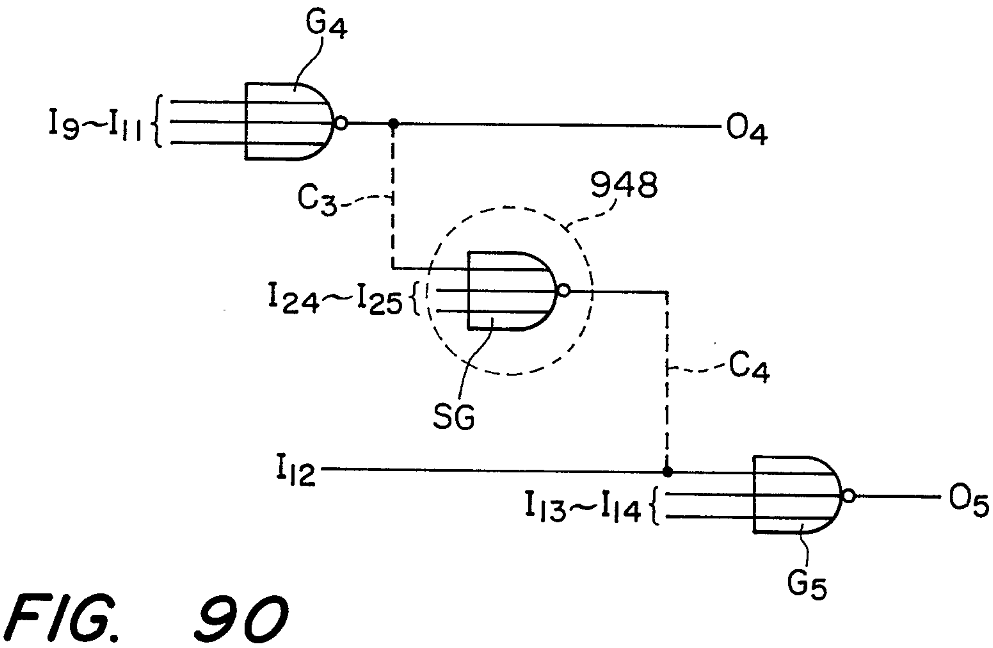


FIG. 9O

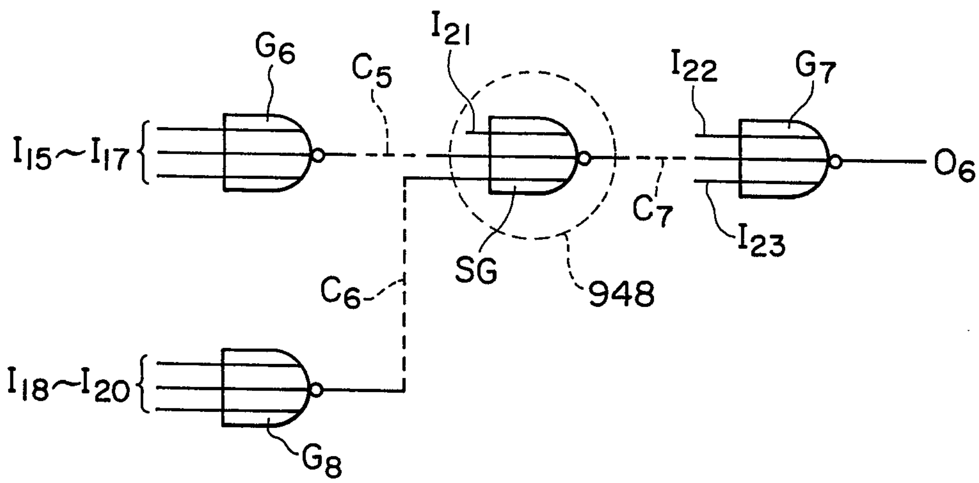

FIG. 9P

(a)

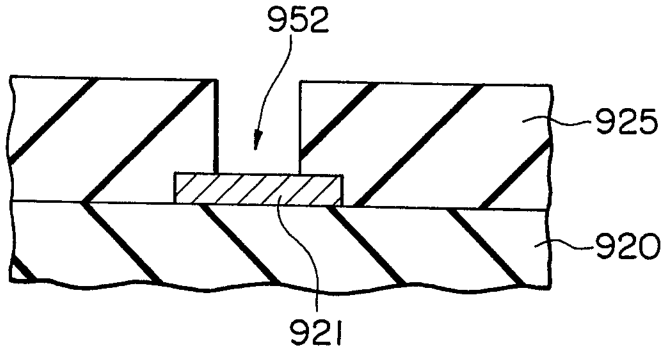


(b)

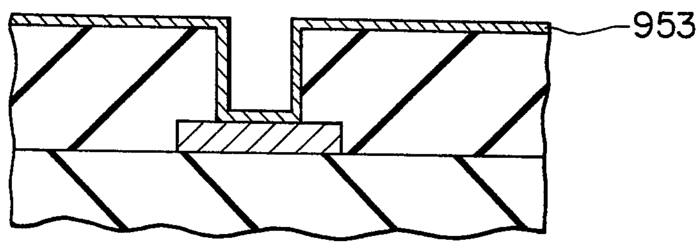


(c)

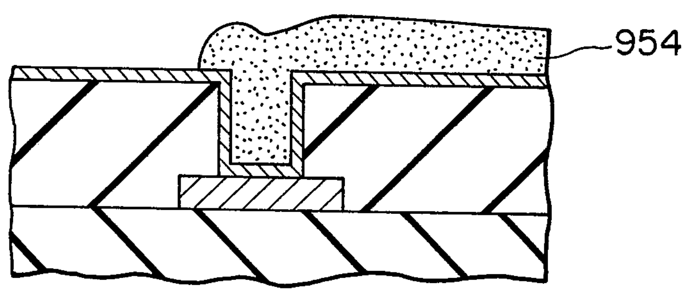


(d)

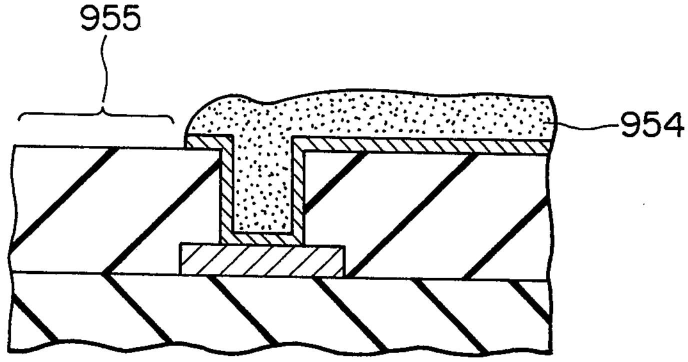

FIG. 9Q

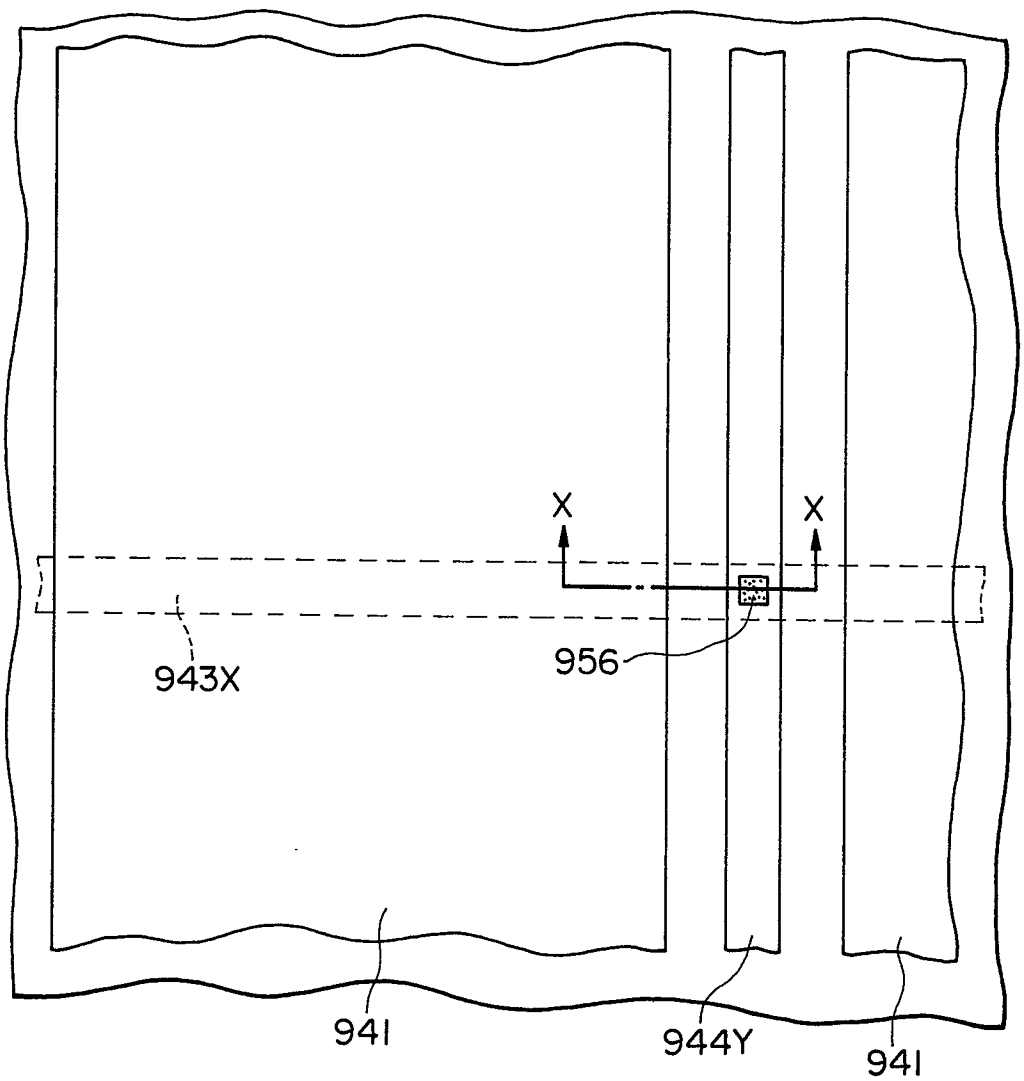


FIG. 9R

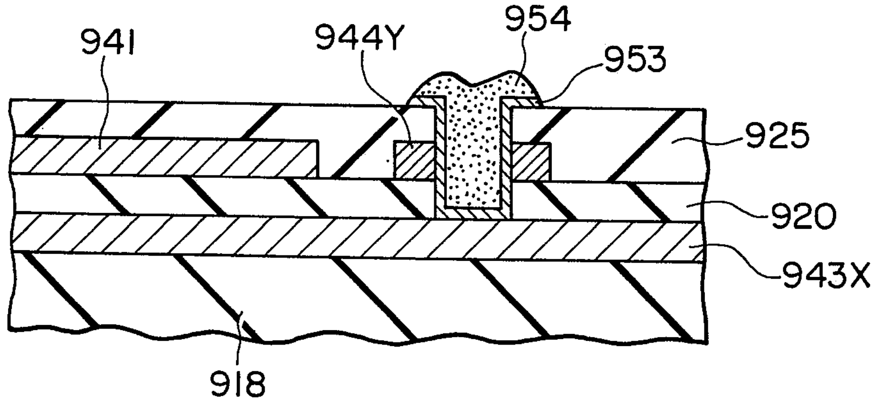

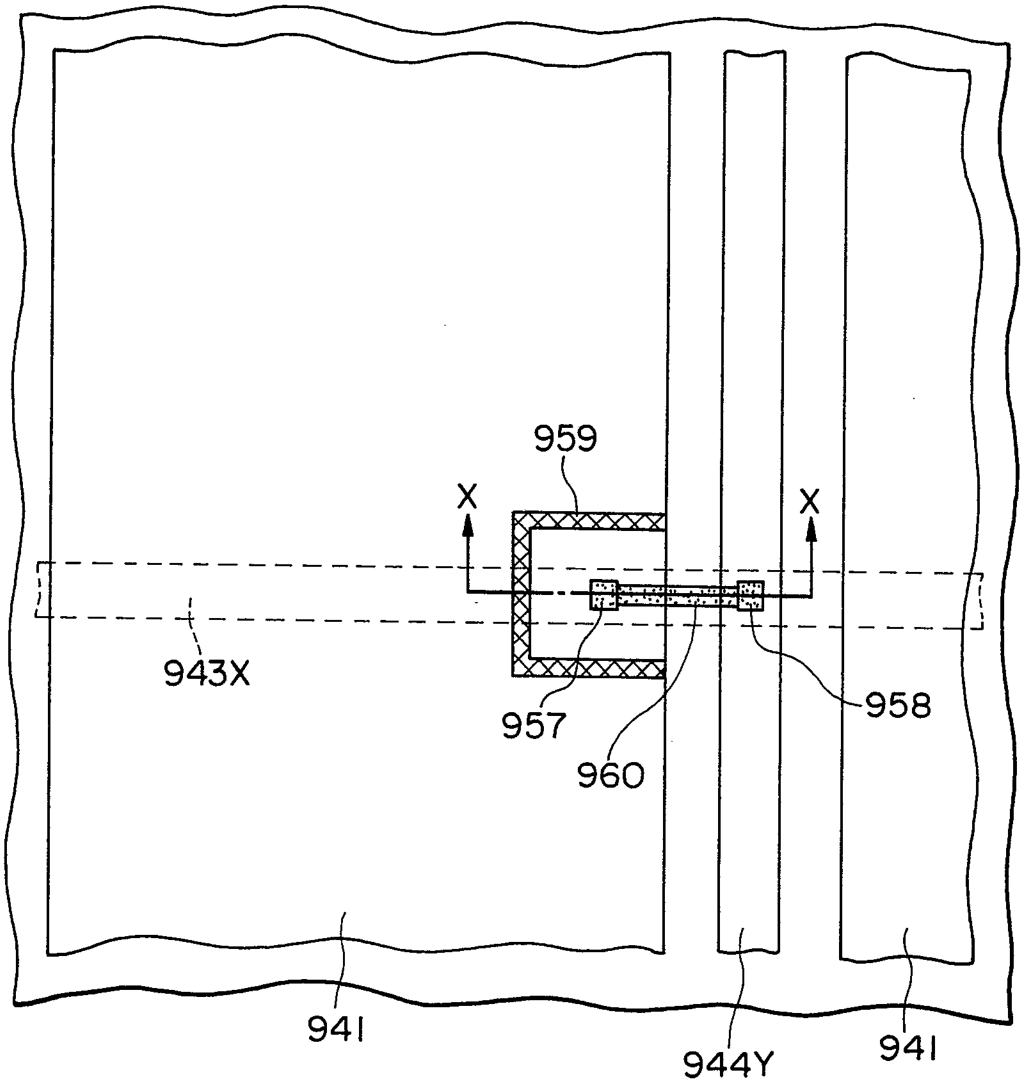
959
X
X
943X
957
960
958
941
944Y
941

FIG. 9S

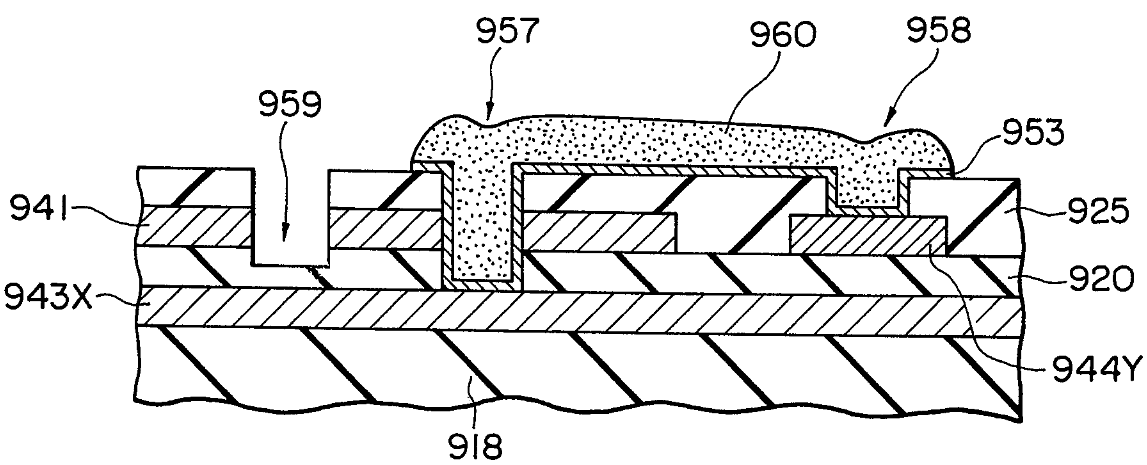
957
960
958
959
953
941
925
920
943X
944Y
918

FIG. 9T

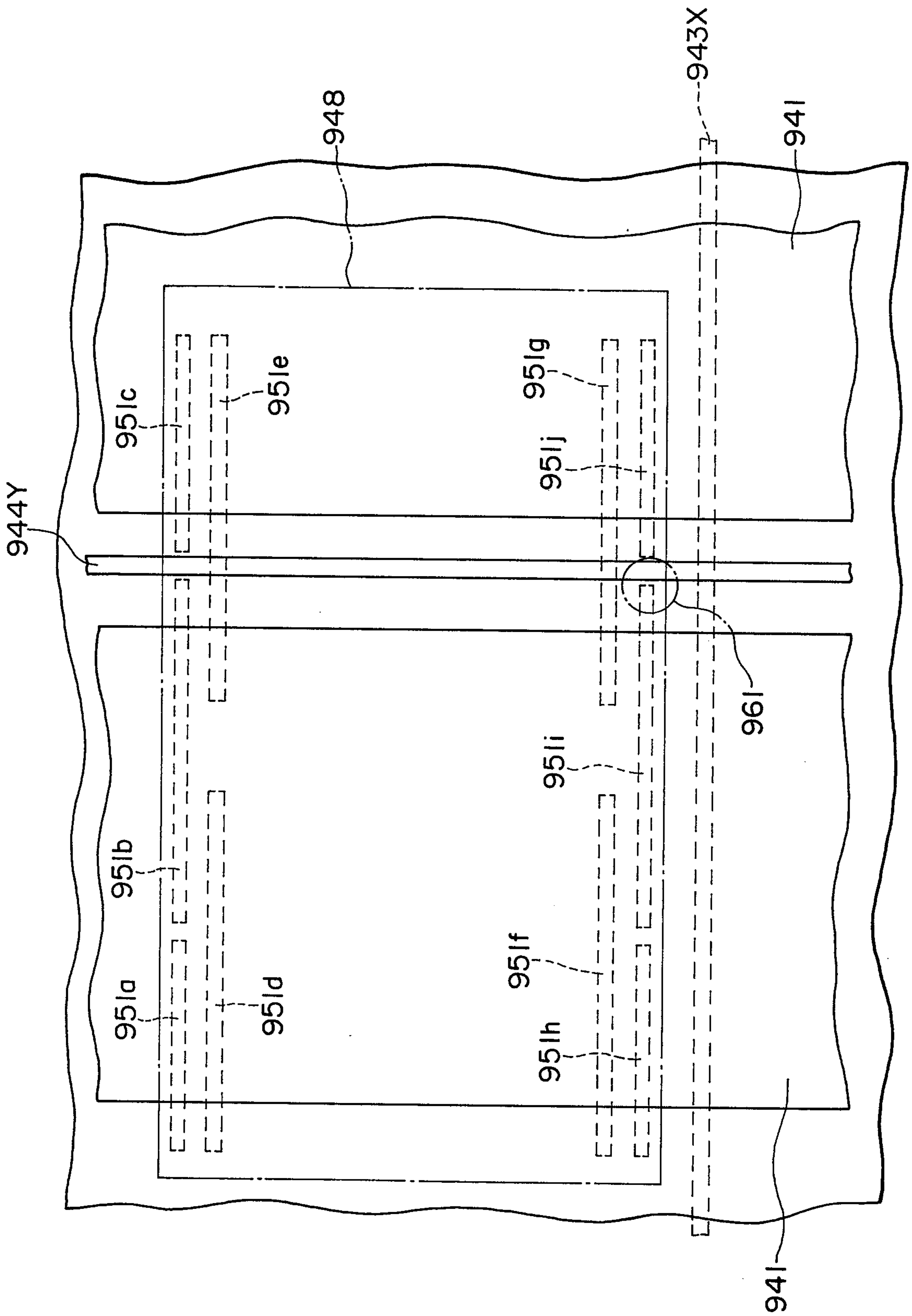
948
943X
941
951c
951e
951g
951j
944Y
961
951i
951b
951f
951a
951d
951h
941

FIG. 9U

0295065

FIG. 9V

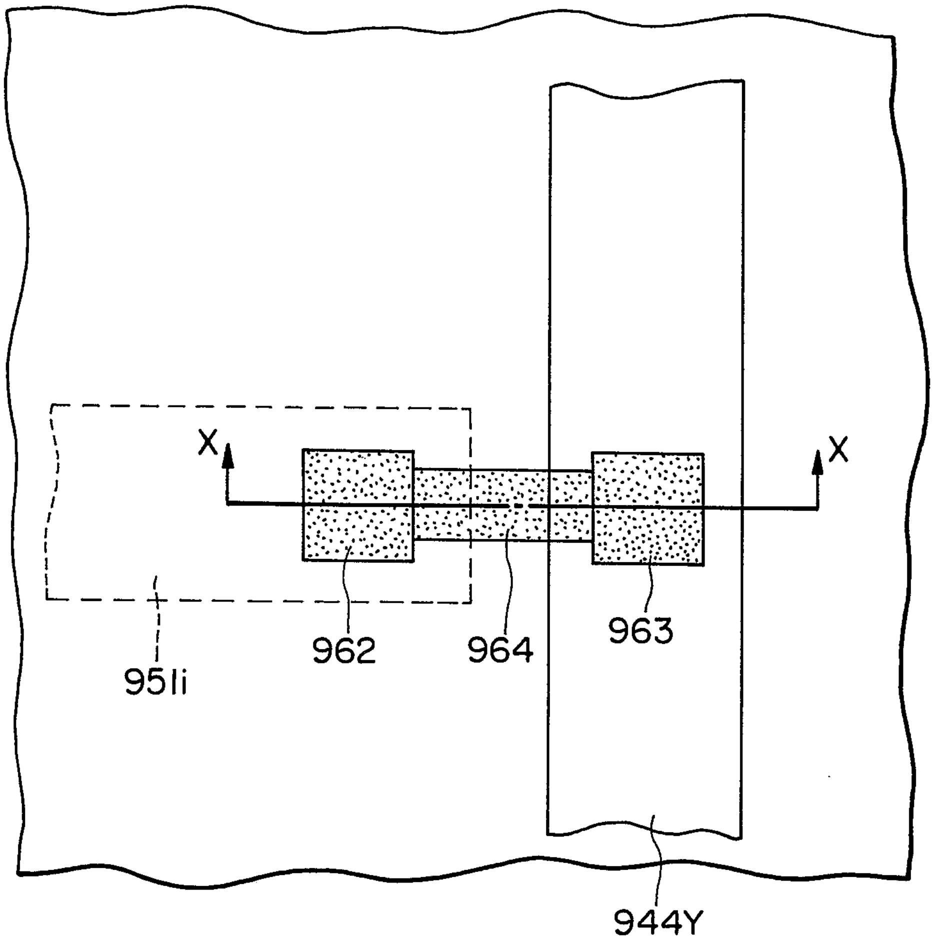


FIG. 9W